# EUROPEAN PATENT APPLICATION

(11) **EP 4 375 718 A1**
(43) Date of publication of application: **29.05.2024**
(21) Application number: 23195954.5
(22) Date of filing: 07.09.2023
(51) Int. Cl.: G02B 6/42, H05K 9/00, H01R 12/71

(54) **RECEPTACLE ASSEMBLY, CAGE, AND MOUNTING METHOD**

(30) Priority: 21.09.2022 US 202263408559 P; 22.12.2022 US 202263434706 P
(71) Applicant: Yamaichi Electronics Co., Ltd., Tokyo 144-8581 (JP)
(72) Inventor: ITO, Toshiyasu, Tokyo, 144-8581 (JP)
(74) Representative: Lippert Stachow Patentanwälte Rechtsanwälte

(57) **Abstract**

An embodiment includes: a connector 200, 300 configured to allow a module substrate 21 of a pluggable module 20 to be inserted to the connector along an insertion-extraction direction Die and configured to be electrically connected to the module substrate 21; a cage 400, 500 having a cage body 410, 510 configured to accommodate the connector 200, 300 and defines a space in which the pluggable module 20 is guided and inserted along the insertion-extraction direction Die. The connector 200, 300 and the cage body 410, 510 are mounted on a substrate 100 such that the insertion-extraction direction Die is substantially orthogonal to the front side 101 of the substrate 100, and a fixing part 416b, 516b, 416d, 516d for fixing the cage body 410, 510 to the substrate 100 is provided at a rear end edge 416, 516 of the cage body 410, 510 located on the substrate 100 side when mounted on the substrate 100.

## Description

### BACKGROUND

### 1. TECHNICAL FIELD

The present invention relates to a receptacle assembly, a cage, and a mounting method.

### 2. DESCRIPTION OF RELATED ART

Optical transceivers configured to convert an electrical signal to an optical signal and vice versa are electrically connected to an application specific integrated circuit (ASIC) mounted on a printed wiring board via a receptacle mounted on the printed wiring board.

Conventionally, receptacles are mounted on printed wiring boards such that the insertion-extraction direction of the optical transceiver is parallel to the face of the printed wiring board (for example, as in Japanese Patent No. 7082068).

In this context, when a plurality of receptacles each defining the insertion-extraction direction parallel to the face of a printed wiring board are mounted on the printed wiring board, the receptacles may be aligned in one direction (one line) or a U-shape on one or more straight lines parallel to edges of the printed wiring board, for example, as disclosed in U.S. Patent No. 11177614.

When respective receptacles defining the insertion-extraction direction parallel to the face of the printed wiring board are arranged as described above, receptacles arranged at positions closer to both ends of the printed wiring board are more distant from an integrated circuit mounted in the center region of the printed wiring board.

In such a case, if a signal is an ultrahigh-speed signal, a distance available for transmission of the signal via a pattern applied to the printed wiring board is short (for example, about 100 mm to 150 mm). As a result, the signal may be degraded and thus fail to be suitably transmitted in case where the receptacles are arranged as described above, because of a longer distance to the integrated circuit from receptacles arranged at positions closer to both ends or a corner (that is, a longer pattern length in the printed wiring board).

Further, U.S. Patent No. 11177614 described above discloses a form of connecting respective receptacles and an integrated circuit by cables instead of patterns applied to the printed wiring board. However, when cables are used for signal transmission, there is a concern about an increase in costs due to preparation of these cables and the increased number of components.

Accordingly, the present invention intends to provide a receptacle assembly, a cage, and a mounting method that can suitably transmit a signal via a pattern applied to a printed wiring board.

### BRIEF SUMMARY

To achieve the object described above, the receptacle assembly, the cage, and the mounting method of the present invention employ the following solutions.

A receptacle assembly according to the first aspect of the present invention is a receptacle assembly which is mounted on a first face of a substrate and in which at least one pluggable module is inserted along a first direction, and the receptacle assembly includes: at least one connector configured to allow a module substrate of the pluggable module to be inserted to the connector along the first direction and configured to be electrically connected to the module substrate; and at least one cage having a cage body configured to accommodate the connector and define a space in which the pluggable module is guided and inserted along the first direction, and the connector and the cage body are mounted on the substrate such that the first direction is substantially orthogonal to the first face of the substrate.

According to the receptacle assembly of the present aspect, since the connector and the cage body are mounted on the substrate such that the first direction is substantially orthogonal to the first face of the substrate, a plurality of receptacle assemblies can be arranged (mounted) on the region of the first face of the substrate corresponding to the region of the second face (the face corresponding to the backside of the first face) of a portion on which an integrated circuit is mounted. Thus, the distances of patterns from receptacle assemblies mounted on the first face to the integrated circuit mounted on the second face can be shorter than those of the conventional type. Accordingly, an ultrahigh-speed signal (for example, 200 Gbps or higher) with a short transmittable distance can be suitably transmitted via patterns applied to the substrate.

Further, a fixing part for fixing the cage body to the substrate is provided at a rear end edge of the cage body located on a substrate side when mounted on the substrate.

According to the receptacle assembly of the present aspect, since a fixing part is provided at the rear end edge of the cage body, it is possible to use the fixing part to fix the cage body indirectly or directly to the substrate.

Further, in the receptacle assembly according to the second aspect of the present invention, the fixing part is a flange expanding in a direction orthogonal to the first direction, in the first aspect.

According to the receptacle assembly of the present aspect, since the fixing part is a flange, it is possible to position the cage body based on the flange as a reference with respect to the substrate by causing the flange to come into contact with the substrate.

Further, in the receptacle assembly according to the third aspect of the present invention, a hole corresponding to a through hole formed in the substrate is formed in the flange, in the second aspect.

According to the receptacle assembly of the present aspect, since a hole corresponding to a through hole formed in the substrate is formed in the flange, it is possible to mount (fix) the cage on the substrate by using a screw inserted through the through hole of the substrate and the hole of the flange, for example.

Further, the receptacle assembly according to the fourth aspect of the present invention includes: a first plate; and a second plate, and the first plate and the second plate are fastened to each other with the flange and the substrate being interposed between the first plate and the second plate, in any one of the first aspect to the third aspect.

According to the receptacle assembly of the present aspect, the receptacle assembly includes a first plate and a second plate and the first plate and the second plate are fastened to each other with the flange and the substrate being interposed between the first plate and the second plate, and thus the cage can be firmly mounted on (fixed to) the substrate with the flange being pressed against the substrate.

Further, the receptacle assembly according to the fifth aspect of the present invention includes a first plate, and the first plate and the flange are fastened to each other with the substrate being interposed between the first plate and the flange, in any one of the first aspect to the third aspect.

According to the receptacle assembly of the present aspect, the receptacle assembly includes a first plate and the first plate and the flange are fastened to each other with the substrate being interposed between the first plate and the flange, and thus the cage can be firmly mounted on (fixed to) the substrate with the flange being pressed against the substrate.

Further, in the receptacle assembly according to the sixth aspect of the present invention, the fixing part is a pin extending in the first direction, in the first aspect.

According to the receptacle assembly of the present aspect, since the fixing part is a pin, it is possible to easily mount the cage on the substrate by using the pin.

For example, the pin is inserted in the through hole formed in the substrate, and an example of the pin is a press-fit pin or a soldering pin.

Further, in the receptacle assembly according to the seventh aspect of the present invention, the pin is inserted and secured in a through hole formed in the substrate, in the sixth aspect.

According to the receptacle assembly of the present aspect, since the pin is inserted and secured in a through hole formed in the substrate, it is possible to easily mount the cage on the substrate.

An example of the pin is a press-fit pin or a soldering pin.

Further, in the receptacle assembly according to the eighth aspect of the present invention, the at least one connector and the at least one cage body include a plurality of connectors and a plurality of cage bodies, respectively, the connectors are adjacent to each other in a width direction orthogonal to the first direction and/or a height direction orthogonal to both the first direction and the width direction, and the cage bodies are adjacent to each other in the width direction and/or the height direction and connected to each other, and the receptacle assembly includes a connecting panel configured to connect the plurality of cage bodies in the height direction, in any one of the first aspect to the seventh aspect.

According to the receptacle assembly of the present aspect, there are a plurality of connectors and a plurality of cage bodies, the connectors are adjacent to each other in the width direction and/or the height direction, and the cage bodies are adjacent to each other in the width direction and/or the height direction and connected to each other, and thus a plurality of pluggable modules can be connected to the substrate.

Further, since the receptacle assembly includes a connecting panel, the cage bodies can be rigidly connected to each other by the connecting panel. Thus, connected bodies of a plurality of cages can be rigidly integrated. Accordingly, for example, even when the openings of the front panel in which respective cage bodies are inserted are combined into one piece in terms of a good machining property, respective cage bodies are not unstable inside the openings.

Further, in the receptacle assembly according to the ninth aspect of the present invention, in the first aspect, the at least one connector and the at least one cage body include a plurality of connectors and a plurality of cage bodies, respectively, the connectors are adjacent to each other in a width direction orthogonal to the first direction and/or a height direction orthogonal to both the first direction and the width direction, and the cage bodies are adjacent to each other in the width direction and/or the height direction and connected to each other. The plurality of cage bodies adjacent to each other in the width direction have a rectangular cylindrical outer cage and at least one partition plate, the outer cage defining a space accommodating a plurality of pluggable modules, and the partition plate partitioning the space of the outer cage in the width direction, and/or the plurality of cage bodies adjacent to each other in the height direction have a rectangular cylindrical outer cage and at least one partition plate, the outer cage defining a space accommodating the plurality of pluggable modules, and the partition plate partitioning the space of the outer cage in the height direction. The outer cage is formed by bending a plate material having a latch claw and a notch into a rectangular cylindrical shape and then fitting the latch claw into the notch, the latch claw being formed at one edge, and the notch being formed in another edge opposed to the one edge and having a shape adapted to a shape of the latch claw, and a space defined by the outer cage and the partition plate functions as the cage body.

According to the receptacle assembly of the present aspect, the plurality of cage bodies adjacent to each other in the width direction have a rectangular cylindrical outer cage and at least one partition plate, and the partition plate partitioning the space inside the outer cage in the width direction, and/or the plurality of cage bodies adjacent to each other in the height direction have a rectangular cylindrical outer cage and at least one partition plate, and the partition plate partitioning the space inside the outer cage in the height direction, and the space defined by the outer cage and the partition plate function as the cage body. Thus, a plurality of cage bodies having a common outer wall can be collectively formed. Further, a plurality of pluggable modules can be connected to the substrate.

Further, the outer cage is formed by bending a plate material having a latch claw, which is formed at one edge, and a notch, which is formed in the other edge opposed to the one side and has a shape adapted to a shape of the latch claw, into a rectangular cylindrical shape and then fitting the latch claw into the notch. Thus, a rectangular cylindrical outer cage can be produced from one plate material. Further, edges (sides) of the plate material can be connected to each other by the latch claw and the notch.

Further, in the receptacle assembly according to the tenth aspect of the present invention, protrusions are formed at respective edges of the partition plate, the edges being opposed to each other in the height direction, engagement holes are formed in respective walls of the outer cage, the walls facing each other in the height direction, and the partition plate is fixed to the outer cage when the protrusions of the partition plate are inserted in the engagement holes of the outer cage, in the ninth aspect.

According to the receptacle assembly of the present aspect, protrusions are formed at respective edges of the partition plate, the edges being opposed to each other in the height direction, engagement holes are formed in respective walls of the outer cage, the walls facing each other in the height direction, and the partition plate is fixed to the outer cage when the protrusions of the partition plate are inserted in the engagement holes of the outer cage. Thus, the partitioning plate can be rigidly fixed to the outer cage.

Further, in the receptacle assembly according to the eleventh aspect of the present invention, a plurality of partition plates partitioning, in the width direction, the space defined by the outer cage are arranged at substantially the same positions while being close to each other in the width direction, and/or a plurality of partition plates partitioning, in the height direction, the space defined by the outer cage are arranged at substantially the same positions while being close to each other in the height direction, in the ninth aspect or the tenth aspect.

According to the receptacle assembly of the present aspect, plurality of partition plates partitioning, in the width direction, the space defined by the outer cage are arranged at substantially the same positions while being close to each other in the width direction, and/or a plurality of partition plates partitioning, in the height direction, the space defined by the outer cage are arranged at substantially the same positions while being close to each other in the height direction, in the ninth aspect or the tenth aspect.

Further, in the receptacle assembly according to the twelfth aspect of the present invention, the cage body is configured such that the pluggable module with a heat sink is inserted in the cage body, and at least one vent hole is formed in walls of the cage body, the walls facing in a height direction orthogonal to the first direction, in any one of the first aspect to the eleventh aspect.

According to the receptacle assembly of the present aspect, the cage body is configured such that the pluggable module with a heat sink is inserted in the cage body, and at least one vent hole is formed in walls of the cage body that face in the height direction orthogonal to the first direction. Thus, for example, when the pluggable module with a heat sink is inserted in the cage, air flowing along the heat sink is allowed to flow to outside of the cage via the vent hole.

Further, in the receptacle assembly according to the thirteenth aspect of the present invention, an undercut part recessed so as to be spaced apart from the substrate is provided in the rear end edge in walls of the cage body, the walls facing each other in a height direction orthogonal to the first direction, in any one of the first aspect to the twelfth aspect.

According to the receptacle assembly of the present aspect, since an undercut part recessed so as to be spaced apart from the substrate is provided, the rear end edge of the metal cage body is spaced apart from the mount part of the contact pin mounted on the substrate. This can reduce crosstalk occurring between the cage body and the mount part of the contact pin. Further, wirings can be protected.

Further, in the receptacle assembly according to the fourteenth aspect of the present invention, the connector includes a contact pin group in which a plurality of contact pins are aligned and a housing holding the contact pin group, the contact pin group at least has signal pins used for signal transmission and ground pins used for reference potential connection, the contact pin group has a predetermined portion in which two adjacent signal pins are arranged between two ground pins, and in the predetermined portion, a pitch between one of the ground pins and one of the adjacent signal pins is larger than a pitch between the adjacent signal pins, in any one of the first aspect to the thirteenth aspect.

According to the receptacle assembly of the present aspect, the connector includes a contact pin group in which a plurality of contact pins are aligned and a housing that holds the contact pin group, the contact pin group at least has signal pins used for signal transmission and ground pins used for reference potential connection, the contact pin group has a predetermined portion in which two adjacent signal pins (a differential pair) are arranged between two ground pins, and in the predetermined portion, a pitch between one of the ground pins and one of the adjacent signal pins is larger than a pitch between the adjacent signal pins. Thus, crosstalk occurring between a first differential pair and a second differential pair that are adjacent to each other interposing the common ground pin can be reduced.

Further, in the receptacle assembly according to the fifteenth aspect of the present invention, the connector includes a contact pin group in which a plurality of contact pins are aligned, a housing holding the contact pin group, and a shell covering the housing, a fixing tab for fixing the shell to the substrate is provided at an end edge of the shell located on the substrate side, and a width dimension of the fixing tab is a larger than a width dimension of each of the contact pin of the contact pin group, in any one of the first aspect to the fourteenth aspect.

According to the receptacle assembly of the present aspect, the connector includes a shell covering the housing, a fixing tab is provided at an end edge of the shell, and the width dimension of the fixing tab is a larger than the width dimension of the contact pin of the contact pin group. Thus, it is possible to more firmly mount the connector on the substrate by using the fixing tab to solder the shell accommodating the housing to the substrate. This can reduce a likelihood of damage being caused in a mount portion of the connector when the pluggable module is inserted or extracted.

Further, in the receptacle assembly according to the sixteenth aspect of the present invention, the connector includes a contact pin group in which a plurality of contact pins are aligned, a housing holding the contact pin group, and a fixing tab protruding from a face of the housing facing the substrate, and a width dimension of the fixing tab is larger than a width dimension of each of the contact pin of the contact pin group, in any one of the first aspect to the fourteenth aspect.

According to the receptacle assembly of the present aspect, the connector includes a fixing tab protruding from a face of the housing facing the substrate, and the width dimension of the fixing tab is larger than the width dimension of the contact pin of the contact pin group. Thus, it is possible to more firmly mount the connector on the substrate by using the fixing tab to solder the connector to the substrate. This can reduce a likelihood of damage being caused in a mount portion of the connector when the pluggable module is inserted or extracted.

Further, a cage according to the seventeenth aspect of the present invention is a cage mounted on a first face of a substrate and having a cage body defining a space in which at least one pluggable module is guided and inserted along a first direction, and the cage body is mounted on the substrate such that the first direction is substantially orthogonal to a face of the substrate. Hereby, the cage body may be mounted on a first face of the substrate. In general, when the cage is mounted to a substrate or to a surface of a substrate, the cage body may be mounted to the substrate or to the surface of a substrate.

Further, a fixing part for fixing the cage body to the substrate is provided at a rear end edge of the cage body located on the substrate side when mounted on the substrate.

Further, in the cage according to the eighteenth aspect of the present invention, the fixing part is a flange expanding in a direction orthogonal to the first direction, in the seventeenth aspect.

Further, in the cage according to the nineteenth aspect of the present invention, a hole corresponding to a through hole formed in the substrate is formed in the flange, in the eighteenth aspect.

Further, in the cage according to the twentieth aspect of the present invention, the fixing part is a press-fit pin extending in the first direction, in the seventeenth aspect.

Further, the cage according to the twenty-first aspect of the present invention includes: an outer cage defining a space configured to accommodate a plurality of pluggable modules; and at least one partition plate partitioning a space inside the outer cage, and a space defined by the outer cage and the partition plate functions as the cage body, in any one of the seventeenth aspect to the twentieth aspect.

Further, in the cage according to the twenty-second aspect of the present invention, the outer cage and the partition plate have a fixing claw configured to latch the pluggable module, in the twenty-first aspect.

Further, a mounting method according to the twenty-third aspect of the present invention is a mounting method of mounting the receptacle assembly according to the eighth aspect on the substrate, and the mounting method includes: collectively mounting, on the substrate, the plurality of cage bodies integrated by the connecting panel.

Further, a receptacle assembly according to the twenty-fourth aspect of the present invention is a receptacle assembly which is mounted on a first face of a substrate and in which at least one pluggable module is inserted along the first direction, the receptacle assembly includes: a connector configured to allow a module substrate of the pluggable module to be inserted to the connector along the first direction and configured to be electrically connected to the module substrate; a cage having a cage body configured to accommodate the connector and define a space in which the pluggable module is guided and inserted along the first direction; and a fixing member fixed to the cage body, and the connector and the cage body are mounted on the substrate by the fixing member such that the first direction is substantially orthogonal to the first face of the substrate. The receptacle assembly may be a receptacle assembly according to the present invention, in general, and/or the cage may be a cage according to the present invention, in general.

In general, any disclosure of a receptacle assembly according to the present invention comprising a receptacle assembly and a cage discloses the features of the receptacle assembly and of the cage independent from one another with respect to the receptacle assembly and with respect to the cage.

In general, with respect to the combination of a receptacle assembly and a cage, the receptacle assembly may be a receptacle assembly according to the present invention and/or the cage may be a cage according to the present invention.

### BRIEF DESCRIPTION OF THE SEVERAL VIEWS OF THE DRAWINGS

Fig. 1 is a front perspective view of a communication system.
Fig. 2 is a back perspective view of the communication system.
Fig. 3 is a top perspective view of a pluggable module with a heat sink (OSFP-XD).
Fig. 4 is a bottom perspective view of the pluggable module with a heat sink (OSFP-XD).
Fig. 5 is a perspective view of a connector.
Fig. 6 is a perspective view of a contact group of the connector.
Fig. 7 is a side view of the connector.
Fig. 8 is a perspective view of a connector having a shell.
Fig. 9 is a sectional view taken along a cut line IX-IX illustrated in Fig. 8.
Fig. 10 is a top perspective view according to another example of a connector.
Fig. 11 is a bottom perspective view according to another example of the connector.
Fig. 12 is a transverse sectional view of the connector in which the pluggable module with a heat sink (OSFP-XD) is inserted and which is mounted on a substrate.
Fig. 13 is an enlarged view near a mount part of a connector pin.
Fig. 14 is a top perspective view of a cage.
Fig. 15 is a bottom perspective view of the cage.
Fig. 16 is a partial transverse sectional view of a receptacle assembly (according to a first embodiment).
Fig. 17 is a top perspective view of the cage with a separate plate made transparent.
Fig. 18 is a top perspective view of a double outer cage.
Fig. 19 is a top perspective view of the separate plate.
Fig. 20 is a developed view of the double outer cage.
Fig. 21 is a top perspective view of the cage.
Fig. 22 is a partial enlarged view of a part A illustrated in Fig. 21.
Fig. 23 is a side view of the separate plate.
Fig. 24 is a top perspective view of the cage with the separate plate made transparent.
Fig. 25 is a developed view of the double outer cage.
Fig. 26 is a top perspective view of the cage.
Fig. 27 is a partial enlarged view of a part C illustrated in Fig. 26.
Fig. 28 is a partial enlarged view of a part B illustrated in Fig. 24.
Fig. 29 is a perspective view of the receptacle assembly (according to the first embodiment) mounted on the substrate.
Fig. 30 is a front view of the substrate.
Fig. 31 is a bottom perspective view of a pluggable module with a heat sink (OSFP-XD) according to a modified example.
Fig. 32 is a bottom perspective view of a cage according to a modified example.
Fig. 33 is a partial transverse sectional view of the receptacle assembly (according to the first embodiment).
Fig. 34 is an exploded perspective view illustrating a fixing method for a cage according to Example 1.
Fig. 35 is a perspective view of a base plate.
Fig. 36 is a front perspective view of the cage and the base plate.
Fig. 37 is a back perspective view of the cage and the base plate.
Fig. 38 is a partial enlarged view of Fig. 37.
Fig. 39 is a front view of a back plate.
Fig. 40 is a front view of a substrate.
Fig. 41 is a perspective view illustrating a fixing method for the cage according to Example 1.
Fig. 42 is a perspective view of the base plate according to Modified example 1 to Example 1.
Fig. 43 is a perspective view illustrating a fixing method for the cage when the base plate according to Modified example 1 to Example 1 is used.
Fig. 44 is a perspective view of a base plate according to Modified example 2 to Example 1.
Fig. 45 is a perspective view illustrating a fixing method for the cage when the base plate according to Modified example 2 to Example 1 is used.
Fig. 46 is a perspective view illustrating a fixing method for a cage according to Example 2.
Fig. 47 is a front view of a back plate.
Fig. 48 is a front view of a substrate.
Fig. 49 is partial enlarged view of a part D illustrated in Fig. 48.
Fig. 50 is a sectional view taken along a cut line IX-IX illustrated in Fig. 49.
Fig. 51 is a sectional view according to a comparative example to Fig. 50.
Fig. 52 is a perspective view of a cage used in a fixing method for a cage according to Example 3.
Fig. 53 is a front view of a substrate used in the fixing method for the cage according to Example 3.
Fig. 54 is a partial enlarged view of a part G illustrated in Fig. 53.
Fig. 55 is a partial transverse sectional view of a receptacle assembly (according to the first embodiment) employing the fixing method for the cage according to Example 3.
Fig. 56 is a top perspective view of a pluggable module (OSFP-XD).
Fig. 57 is a bottom perspective view of the pluggable module (OSFP-XD).
Fig. 58 is a top perspective view of cages with heat sinks.
Fig. 59 is a bottom perspective view of the cages with heat sinks.
Fig. 60 is an exploded perspective view of the cages with heat sinks.
Fig. 61 is a partial transverse sectional view of a receptacle assembly (according to a second embodiment).
Fig. 62 is a top perspective view of the cages with a separate plate made transparent.
Fig. 63 is a top perspective view of a double outer cage.
Fig. 64 is a top perspective view of the separate plate.
Fig. 65 is a top perspective view of the cage with the separate plate made transparent.
Fig. 66 is a perspective view of a receptacle assembly (according to the second embodiment) mounted on a substrate.
Fig. 67 is a perspective view illustrating a fixing method for a cage corresponding to Example 1.
Fig. 68 is a perspective view illustrating a fixing method for the cage corresponding to Modified example 1 to Example 1.
Fig. 69 is a perspective view illustrating a fixing method for the cage corresponding to Modified example 2 to Example 1.
Fig. 70 is a perspective view illustrating a fixing method for the cage corresponding to Example 2.
Fig. 71 is a perspective view of the cage used in a fixing method for the cage corresponding to Example 3.
Fig. 72 is a front view of a substrate.
Fig. 73 is a back perspective view of the receptacle assembly (according to the second embodiment) when mounted on a substrate.
Fig. 74 is a partial enlarged view of Fig. 73.
Fig. 75 is a bottom perspective view of a cage according to a modified example.
Fig. 76 is a partial transverse sectional view of the receptacle assembly (according to the second embodiment) employing the fixing method for the cage corresponding to Example 3.
Fig. 77 is a bottom perspective view when the cage according to the modified example is mounted (fixed) on a substrate on which a connector is mounted.
Fig. 78 is a top perspective view of a pluggable module with a heat sink (OSFP).
Fig. 79 is a bottom perspective view of the pluggable module with a heat sink (OSFP).
Fig. 80 is a perspective view of a connector.
Fig. 81 is a perspective view of a contact group of the connector.
Fig. 82 is a side view of the connector.
Fig. 83 is a bottom perspective view of the connector.
Fig. 84 is a transverse sectional view of the connector in which the pluggable module with a heat sink (OSFP) is inserted and which is mounted on a substrate.
Fig. 85 is a partial transverse sectional view of a receptacle assembly (according to a third embodiment).
Fig. 86 is a front view of a substrate.
Fig. 87 is a partial enlarged view of a part I illustrated in Fig. 86.
Fig. 88 is a side view of the receptacle assembly (according to the third embodiment) mounted on the substrate.
Fig. 89 is a front view of a front panel.
Fig. 90 is a front view of the front panel according to a comparative example to Fig. 88.
Fig. 91 is a perspective view of a quadruple outer cage according to Modified example 3.
Fig. 92 is a perspective view of a cage with the quadruple outer cage according to Modified example 3.
Fig. 93 is a perspective view of a cage with an octuple outer cage according to Modified example 3.
Fig. 94 is a perspective view when a cage with the octuple outer cage (of a flange-integrated type) according to Modified example 3 is fixed to a substrate.
Fig. 95 is a perspective view when a cage with the octuple outer cage (of a flange-separate type) according to Modified example 3 is fixed to a substrate.
Fig. 96 is a perspective view when a cage with the octuple outer cage according to Modified example 3 is fixed to a substrate (using a base plate).
Fig. 97 is a bottom perspective view of a cage according to Modified example 4.
Fig. 98 is a top perspective view of the cage according to Modified example 4.
Fig. 99 is a partial enlarged view of a part J illustrated in Fig. 97.
Fig. 100 is a perspective view when the cage according to Modified example 4 is mounted on a substrate.
Fig. 101 is a perspective view of a plurality of double outer cages integrated by connecting panels according to a fourth embodiment.
Fig. 102 is an exploded perspective view of Fig. 101.
Fig. 103 is a partial enlarged view of Fig. 102.
Fig. 104 is a perspective view of a plurality of double outer cages to which a flange member is connected according to a fifth embodiment.
Fig. 105 is an exploded perspective view of Fig. 104.
Fig. 106 is a partial enlarged view of Fig. 105.
Fig. 107 is a top perspective view of a cage according to a sixth embodiment.
Fig. 108 is a bottom perspective view of the cage according to the sixth embodiment.
Fig. 109 is a top perspective view of a main outer cage.
Fig. 110 is a top perspective view of a bottom face outer cage.
Fig. 111 is a partial enlarged view of Fig. 107.
Fig. 112 is a perspective view of a plurality of double outer cages stacked in the height direction.
Fig. 113 is a partial enlarged view of Fig. 112.
Fig. 114 is a perspective view of a plurality of double outer cages integrated by connecting panels.
Fig. 115 is a perspective view of a connecting panel.
Fig. 116 is a perspective view of a plurality of double outer cages integrated by another type of connecting panels.
Fig. 117 is a perspective view of another type of a connecting panel.
Fig. 118 is a perspective view when sub-assemblies and a side wall are separated from each other according to a seventh embodiment.
Fig. 119 is a perspective view of a sub-assembly.
Fig. 120 is an exploded perspective view of the sub-assembly.
Fig. 121 is an exploded perspective view of the side wall.
Fig. 122 is a front perspective view of a plurality of cages of a double configuration stacked in the height direction.
Fig. 123 is a back perspective view of the plurality of cages of the double configuration stacked in the height direction.

### DETAILED DESCRIPTION

A receptacle assembly and a cage according to the present invention will be described below with reference to the drawings.

### [Overview]

A receptacle assembly 30 is a device forming a communication system 10 and is used for electrically connecting pluggable modules 20 such as an optical transceiver to an integrated circuit 13 such as an application specific integrated circuit (ASIC).

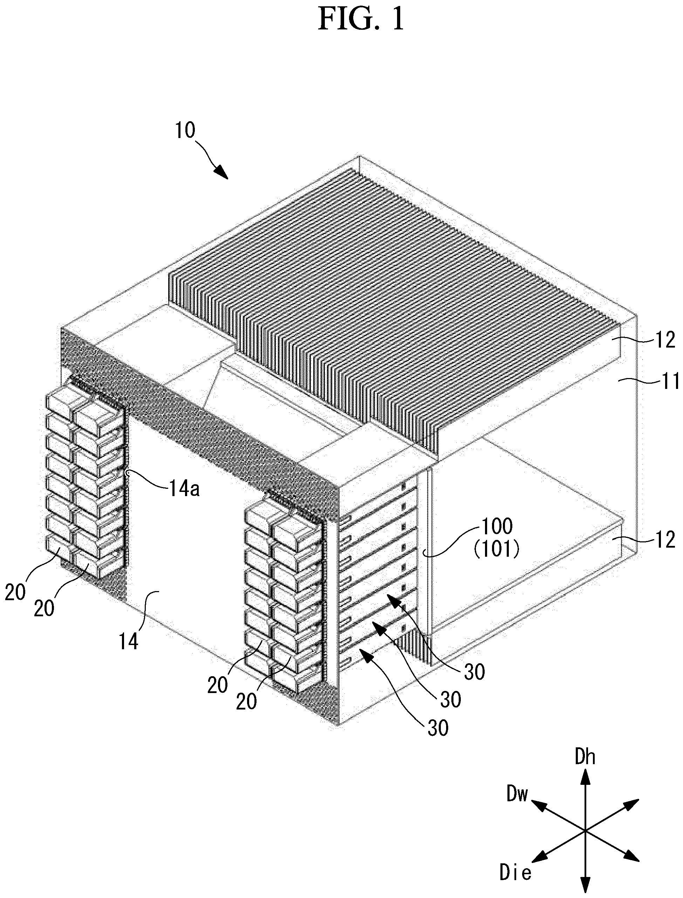

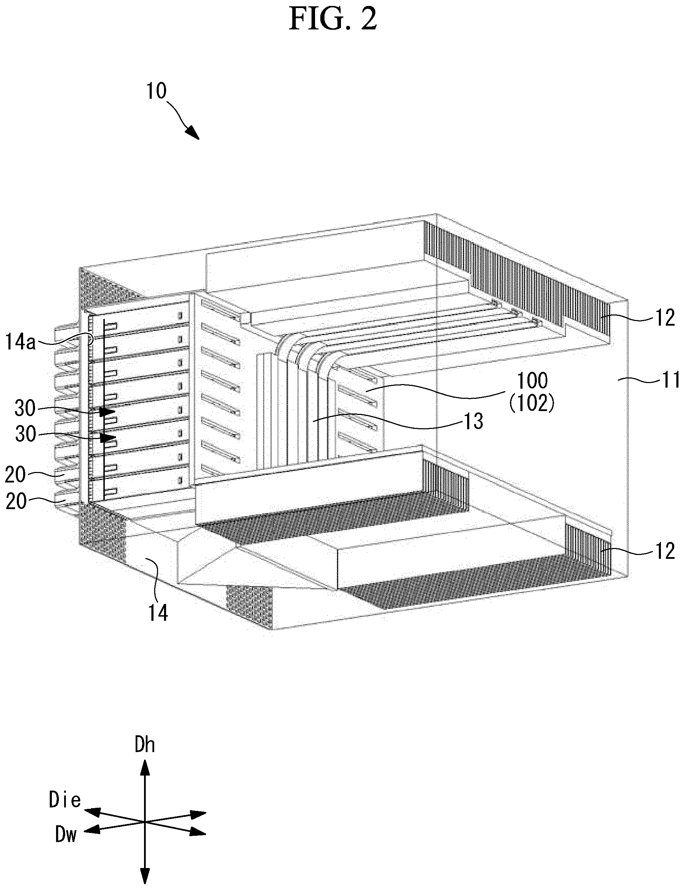

As illustrated in Fig. 1 and Fig. 2, the communication system 10 has a box-shaped casing 11, a printed wiring board (hereafter, simply referred to as a "substrate 100") erected perpendicularly inside the casing 11 and having a front side 101 (a first face) and a back side 102 (a second face) serving as mount faces, a cooling part 12 provided on the upper face of an integrated circuit or on the top face and/or the bottom face inside the casing 11 (for example, a heat sink, a heat pipe, or the like), the integrated circuit 13 mounted in the center region of the back side 102 of the substrate 100, a plurality of receptacle assemblies 30 mounted on the front side 101 of the substrate 100, and a front panel 14 provided on the front face of the casing 11 and defining panel openings 14a through which the plurality of receptacle assemblies 30 are inserted.

Some devices (not illustrated) such as a power supply device, a fan that generates a cooling airflow, or the like are installed in a space behind the back side 102 of the substrate 100 and between the upper cooling part 12 and the lower cooling part 12 in terms of making the communication system 10 compact.

The pluggable modules 20 are inserted in the receptacle assemblies 30 mounted on the substrate 100, thereby these pluggable modules 20 are electrically connected to the substrate 100 via the receptacle assemblies 30, and thus electrically connected to the integrated circuit 13 via patterns applied to the substrate 100.

In this situation, the insertion direction and the extraction direction of each pluggable module 20 are substantially orthogonal to the front side 101 of the substrate 100. Thus, the normal line direction of the front side 101 of the substrate 100 matches the insertion direction and the extraction direction of the pluggable module 20. In the case of Fig. 1 and Fig. 2, the substrate 100 is erected perpendicularly, and the insertion direction and the extraction direction of the pluggable module 20 are substantially parallel to the horizontal direction.

In the following description, the insertion direction and the extraction direction may be collectively denoted as an insertion-extraction direction Die (a first direction).

The receptacle assembly 30 and cages 400, 500 will be described below with several embodiments as examples.

Note that reference 30A, reference 30B, or reference 30C will be used when the receptacle assemblies are distinguished from each other for each embodiment, and reference 30 will be used when no distinction is required.

### [First Embodiment]

A receptacle assembly 30A according to the first embodiment of the present invention will be described below.

The receptacle assembly 30A is a device configured to electrically connect the pluggable module 20 and the substrate 100 to each other as described above.

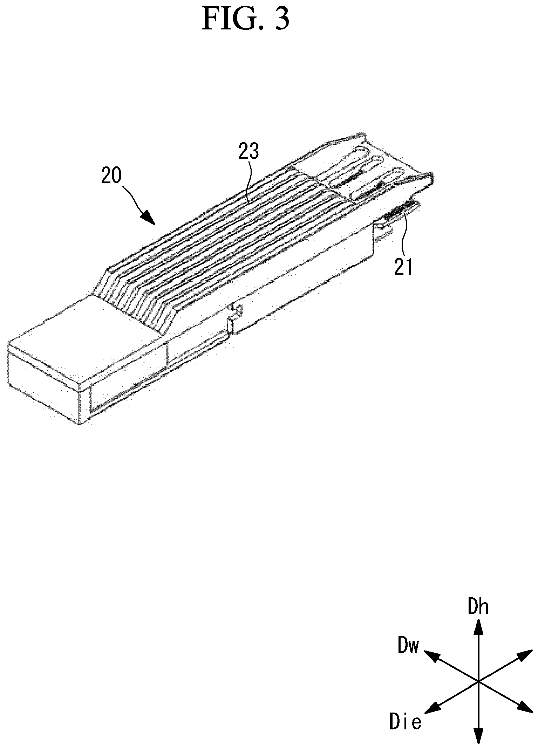

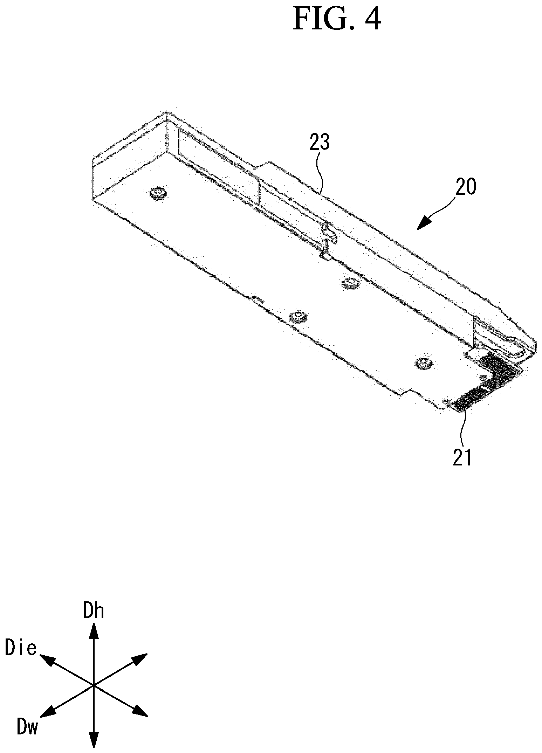

The pluggable module 20 of the present embodiment is an OSFP-XD module of the type having a heat sink (a first heat sink 23) built on the top, as illustrated in Fig. 3 and Fig. 4.

As illustrated in Fig. 3, grooves along the insertion-extraction direction Die are formed in the first heat sink 23, and cooling air flows along the grooves.

The pluggable module 20 has a module substrate 21. A part of the module substrate 21 protrudes externally from the tip of the casing of the pluggable module 20.

The receptacle assembly 30A has a connector 200 and the cage 400.

### < Connector >

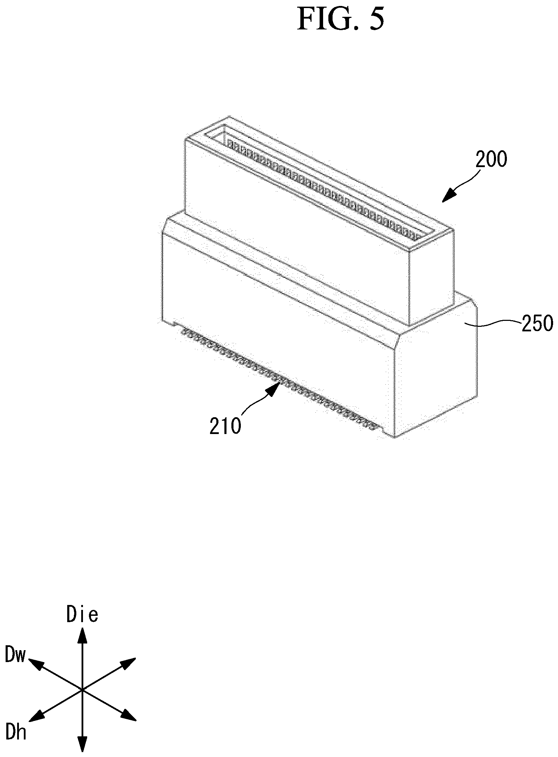

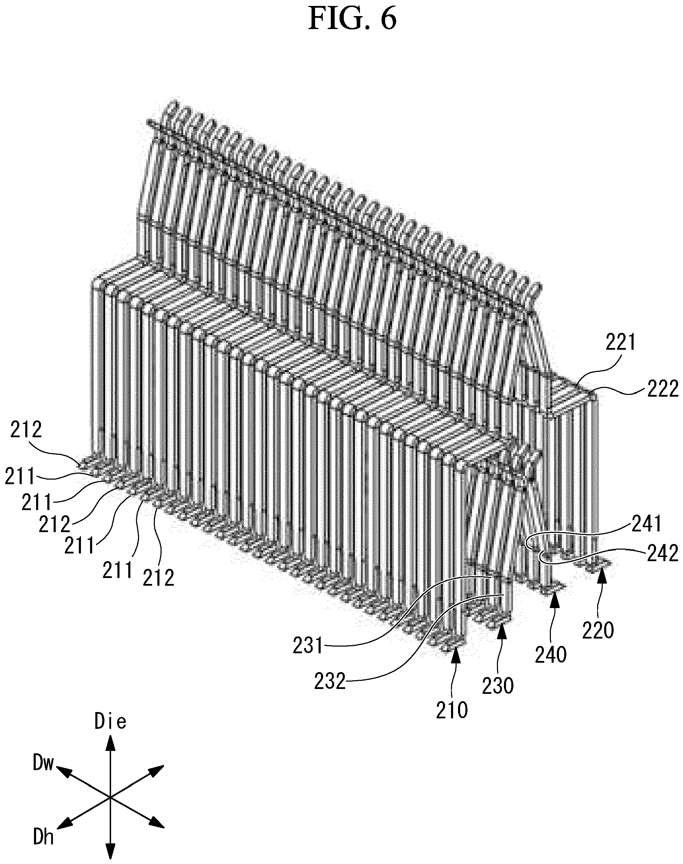

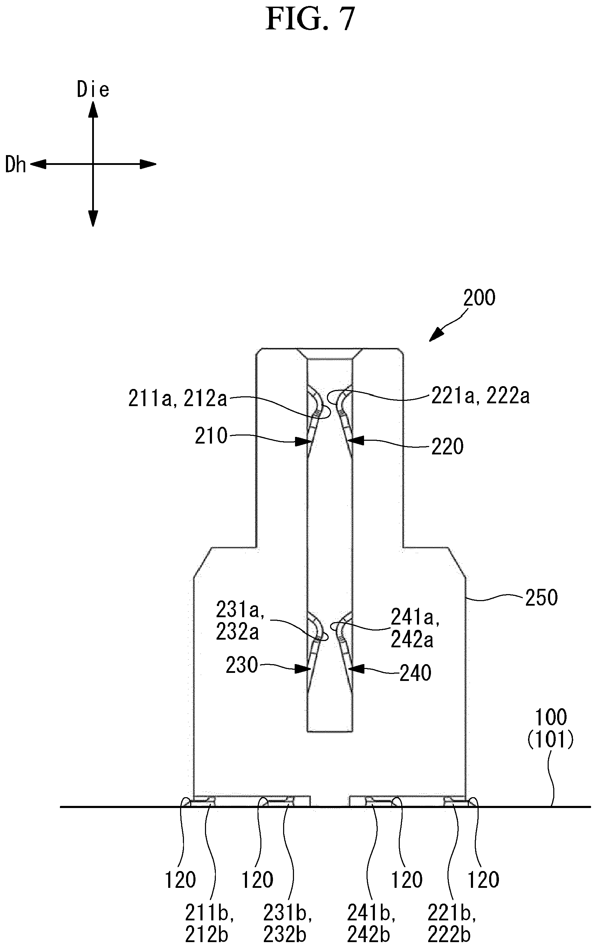

As illustrated in Fig. 5 to Fig. 7, the connector 200 has a first contact pin group 210, a second contact pin group 220, a third contact pin group 230, and a fourth contact pin group 240, and a housing 250 that accommodates and holds these contact pin groups.

The first contact pin group 210 has multiple types of contact pins for different purposes. For example, the first contact pin group 210 has contact pins for high-speed signal transmission (signal pins 211), contact pins for reference potential connection (ground pins 212), contact pins for power supply, and contact pins for low-speed signal transmission.

Each contact pin is an elongated, bent metal component and is aligned along a width direction Dw orthogonal to the insertion-extraction direction Die. Each contact pin is mounted, at its part on the base end side, on the substrate 100 (in detail, an electrode pad 120 formed on the front side 101 of the substrate 100) and is contacted, at its part on the tip side, with the module substrate 21. Note that, for example, each contact pin is mounted on the electrode pad 120 by soldering (the same applies to each contact pin of all the contact pin groups).

The first contact pin group 210 has a section aligned with G-S-S-G-S-S-G-S-S-G-S-S-G, where the signal pin 211 is denoted as "S" and the ground pin 212 is denoted as "G". Thus, there is a section in which a differential pair of signal pins 211 are arranged between a ground pin 212 and another ground pin 212 and arranged adjacent to another differential pair so as to share the ground pin 212.

The second contact pin group 220 is a group paired with the first contact pin group 210 and has multiple types of contact pins for different purposes. For example, the second contact pin group 220 has contact pins for high-speed signal transmission (signal pins 221), contact pins for reference potential connection (ground pins 222), contact pins for power supply, and contact pins for low-speed signal transmission.

Each contact pin is an elongated, bent metal component and is aligned along the width direction Dw. Each contact pin is mounted, at its part on the base end side, on the substrate 100 (in detail, the electrode pad 120 formed on the front side 101 of the substrate 100) and is contacted, at its part on the tip side, with the module substrate 21.

The second contact pin group 220 also has a section aligned with G-S-S-G-S-S-G-S-S-G-S-S-G, where the signal pin 221 is denoted as "S" and the ground pin 222 is denoted as "G". This alignment corresponds to the alignment of respective contact pins of the first contact pin group 210.

Contact point parts 221a, 222a located at tips of respective contact pins of the second contact pin group 220 (contact points contacted with the module substrate 21) face contact point parts 211a, 212a located at tips of respective contact pins of the first contact pin group 210 (contact points contacted with the module substrate 21) in the height direction Dh orthogonal to both the insertion-extraction direction Die and the width direction Dw.

The third contact pin group 230 has multiple types of pins for different purposes. For example, the third contact pin group 230 has contact pins for high-speed signal transmission (signal pins 231), contact pins for reference potential connection (ground pins 232), contact pins for power supply, and contact pins for low-speed signal transmission.

Each contact pin is an elongated, bent metal component and is aligned along the width direction Dw. Each contact pin is mounted, at its part on the base end side, on the substrate 100 (in detail, the electrode pad 120 formed on the front side 101 of the substrate 100) and is contacted, at its part on the tip side, with the module substrate 21.

Contact point parts 231a, 232a located at tips of respective contact pins (contact points contacted with the module substrate 21) are located at positions closer to the substrate 100 in the insertion-extraction direction Die than the contact point parts 211a, 212a of respective contact pins of the first contact pin group 210.

The third contact pin group 230 also has a section aligned with G-S-S-G-S-S-G-S-S-G-S-S-G, where the signal pin 231 is denoted as "S" and the ground pin 232 is denoted as "G".

The fourth contact pin group 240 is a group paired with the third contact pin group 230 and has multiple types of contact pins for different purposes. For example, the fourth contact pin group 240 has contact pins for high-speed signal transmission (signal pins 241), contact pins for reference potential connection (ground pins 242), contact pins for power supply, and contact pins for low-speed signal transmission.

Each contact pin is an elongated, bent metal component and is aligned along the width direction Dw. Each contact pin is mounted, at its part on the base end side, on the substrate 100 (in detail, the electrode pad 120 formed on the front side 101 of the substrate 100) and is contacted, at its part on the tip side, with the module substrate 21.

The fourth contact pin group 240 also has a section aligned with G-S-S-G-S-S-G-S-S-G-S-S-G, where the signal pin 241 is denoted as "S" and the ground pin 242 is denoted as "G". This alignment corresponds to the alignment of respective contact pins of the third contact pin group 230.

Contact point parts 241a, 242a located at tips of respective contact pins of the fourth contact pin group 240 (contact points contacted with the module substrate 21) face contact point parts 231a, 232a located at tips of respective contact pins of the third contact pin group 230 in the height direction Dh.

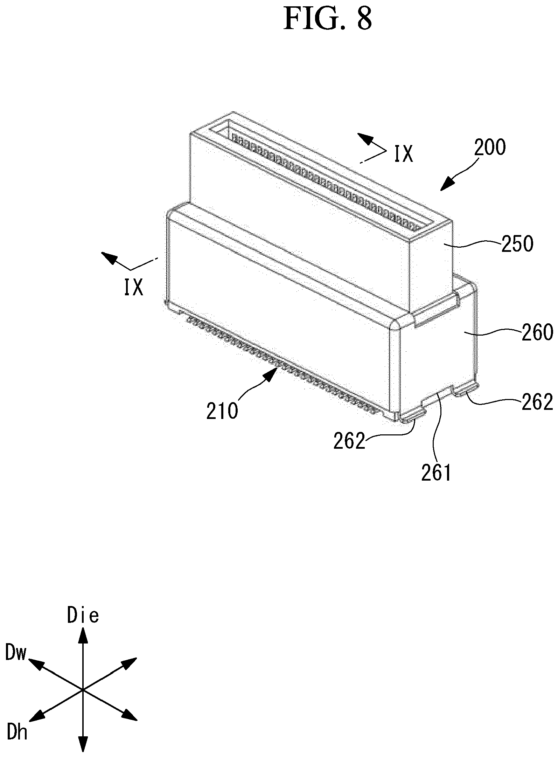

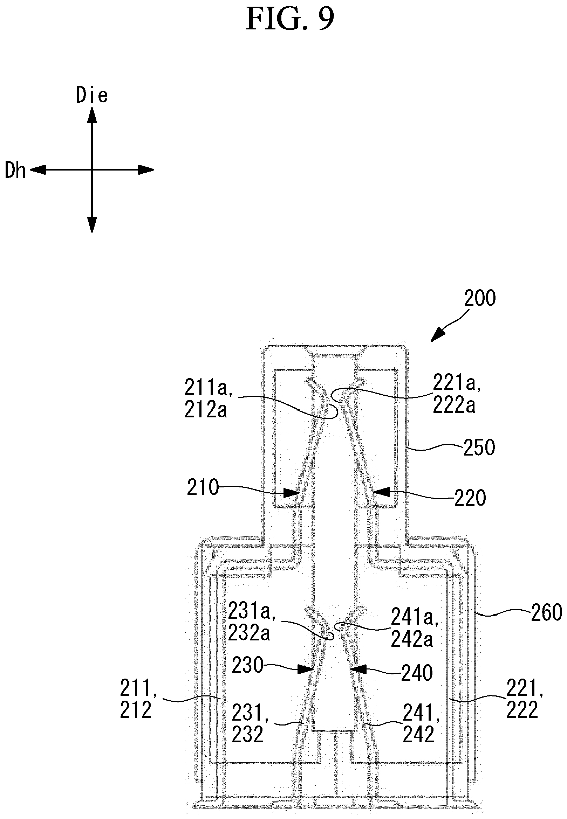

As illustrated in Fig. 8 and Fig. 9, the connector 200 may have a metal shell 260 covering a part of the housing 250.

Fixing tabs 262 are formed at end edges 261 of the shell 260 that face the substrate 100 when mounted.

Each fixing tab 262 is a part to be soldered to a soldering pad 150 formed on the front side 101 of the substrate 100.

By soldering the fixing tabs 262 to the substrate 100, it is possible to firmly mount the connector 200 on the substrate 100.

It is preferable that the width dimension of the fixing tab 262 be larger than the width dimension of the contact pin of each contact pin group in terms of strength.

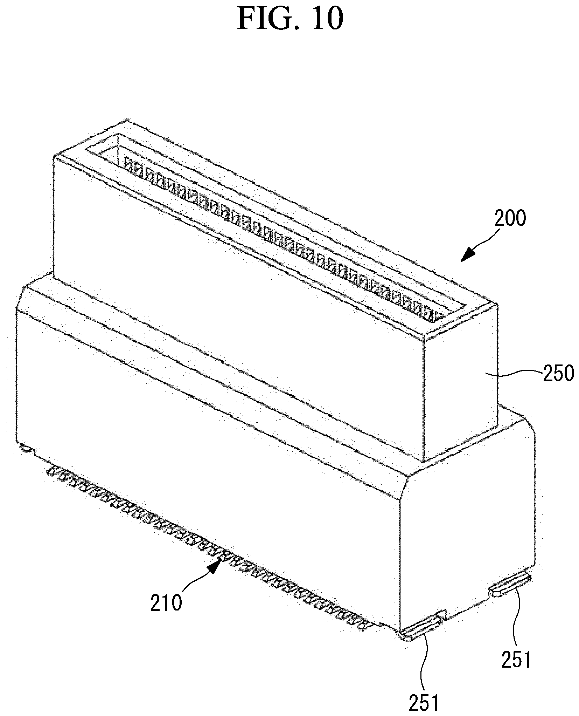

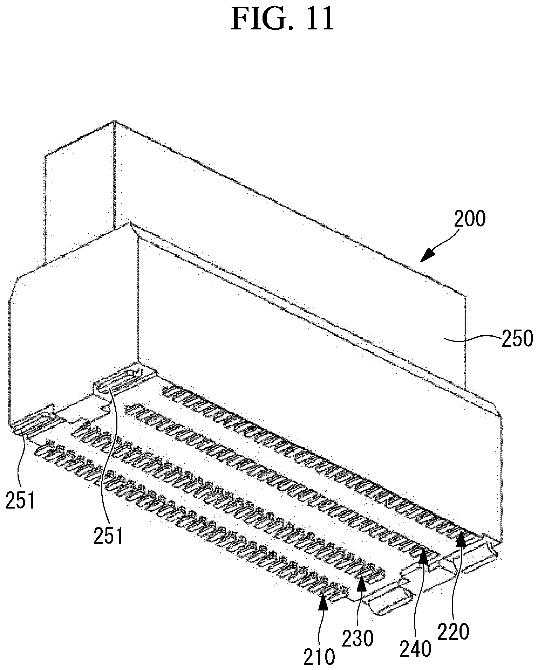

Note that, as illustrated in Fig. 10 and Fig. 11, the connector 200 may have fixing tabs 251 protruding from the bottom face (the face facing the substrate 100) of the housing 250. In such a case, the shell 260 can be omitted.

Further, the connector 200 may have a protrusion (not illustrated) protruding from the bottom face (the face facing the substrate 100) of the housing 250. This protrusion is used for positioning of the connector 200, and for example, when the protrusion is fitted into a hole formed in the substrate 100, the connector 200 is positioned with respect to the substrate 100.

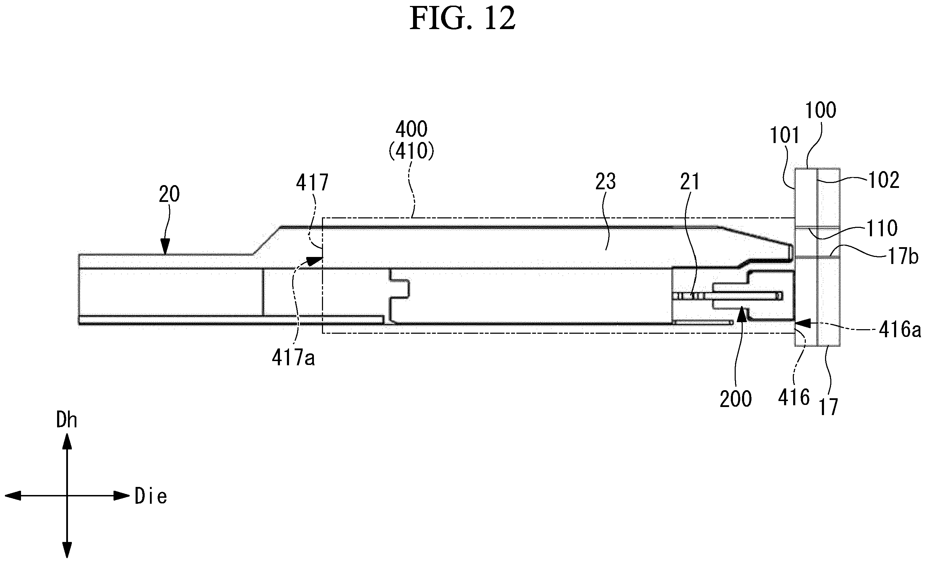

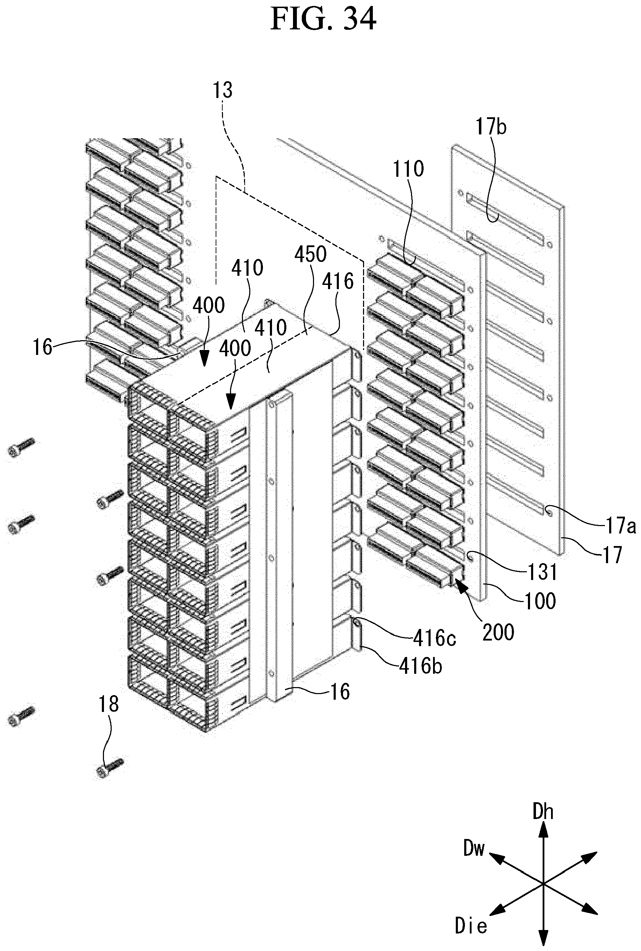

The connector 200 configured as described above is mounted such that the insertion-extraction direction Die of the pluggable module 20 is substantially perpendicular to the front side 101 of the substrate 100, as illustrated in Fig. 12. Further, the connectors 200 accommodated inside cage bodies 410 (a double outer cage 450) are mounted along the height direction Dh in regions of the front side 101 that are present on the opposite side to regions located on both sides of the integrated circuit 13 on the back side 102 of the substrate 100 (see Fig. 34).

The pluggable module 20 is then inserted in the connector 200 along the insertion-extraction direction Die, and thereby the module substrate 21 of the pluggable module 20 is electrically connected to the substrate 100 via contact pins of respective contact pin groups.

A further preferable form of the connector 200 will now be described.

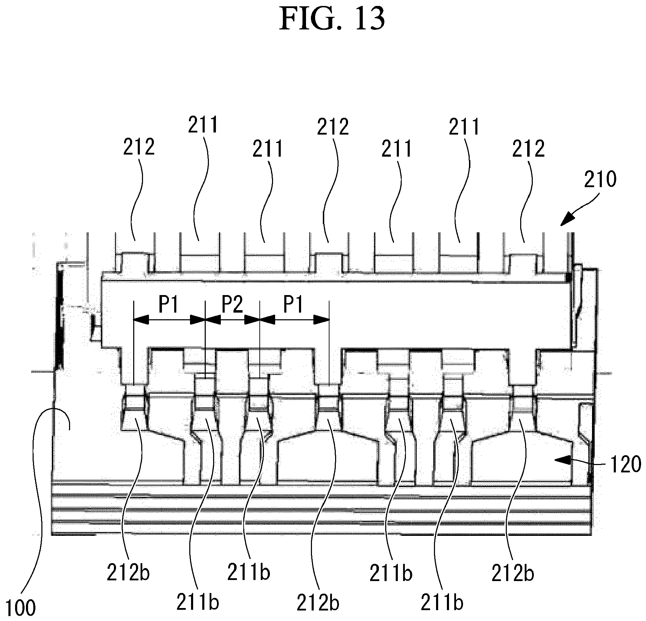

As illustrated in Fig. 13, when the first contact pin group 210 is presented as an example, and when it is defined that a base end part of the signal pin 211 soldered to the electrode pad 120 of the substrate 100 is a mount part 211b and that a base end part of the ground pin 212 soldered to the electrode pad 120 is a mount part 212b, it is preferable that the pitch P1 of the mount part 212b and the mount part 211b be wider than the pitch P2 of the mount parts 211b.

Accordingly, the distance between the mount part 212b of the ground pin 212 and the mount part 211b of the signal pin 211 increases, and this can reduce crosstalk occurring between one differential pair and another differential pair via a common ground pin 212 present between these two differential pairs. Thus, crosstalk between channels can be reduced.

The same applies to the relationship between the mount part 221b of the signal pins 221 and the mount part 222b of the ground pins 222 in the second contact pin group 220, the relationship between the mount part 231b of the signal pins 231 and the mount part 232b of the ground pins 232 in the third contact pin group 230, and the relationship between the mount part 241b of the signal pins 241 and the mount part 242b of the ground pins 242 in the fourth contact pin group 240.

Note that a pitch may be changed also in other portions of the signal pins 211 than the mount parts 211b and other portions of the ground pins 212 than the mount parts 212b.

Further, the configuration to change pitches as described above is also applicable to, for example, a type of connector that is mounted such that the insertion-extraction direction Die of the pluggable module 20 is substantially parallel to the front side 101 of the substrate 100.

Furthermore, the configuration to change pitches as described above is applicable to any type of connectors of receptacle assemblies regardless of the type of pluggable modules.

### < Cage >

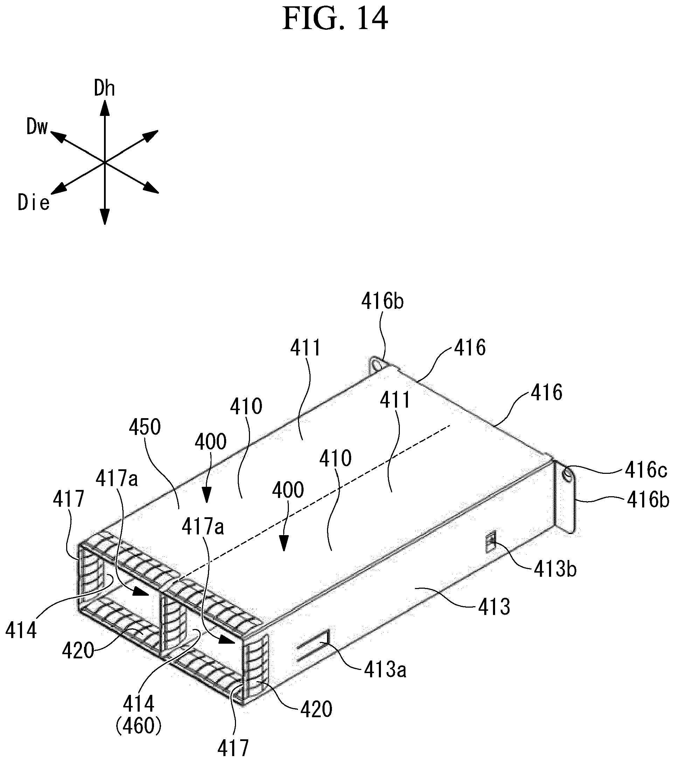

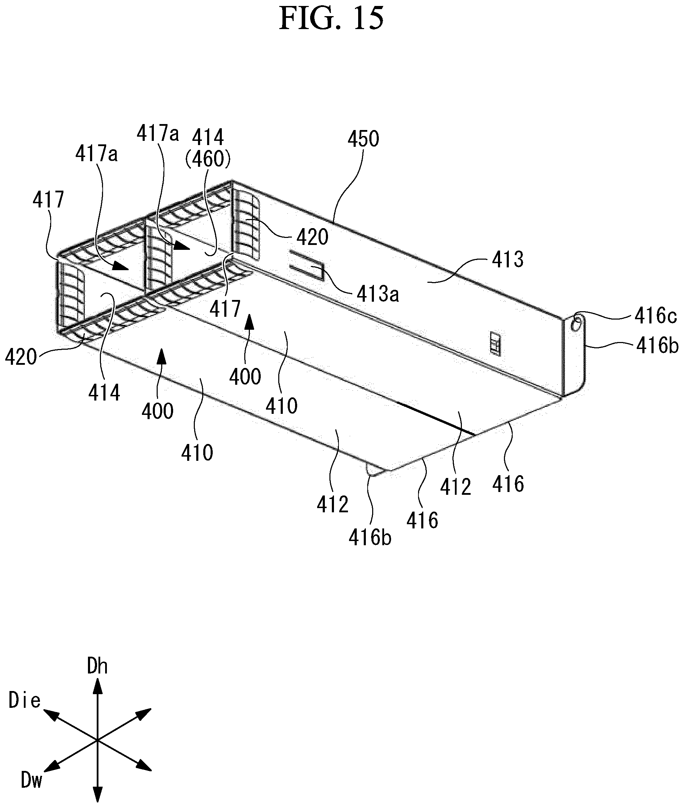

As illustrated in Fig. 14 and Fig. 15, the cage 400 has a cage body 410.

Note that, in Fig. 14 and Fig. 15, two cage bodies 410 are adjacent to, preferably, are connected to each other in the width direction Dw. The details of the cage bodies 410 of a double configuration will be described later.

Each cage body 410 is a rectangular cylindrical component extending in the insertion-extraction direction Die and has a top wall 411 and a bottom wall 412 facing each other in the height direction Dh and a right wall 413 and a left wall 414 facing each other in the width direction Dw, and a space (in which the pluggable module 20 is inserted) is defined by these walls.

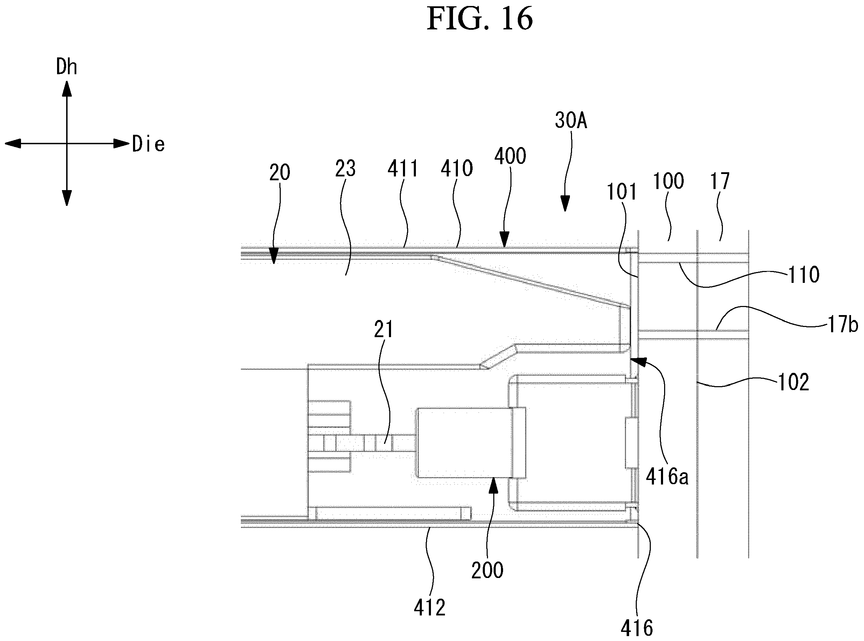

As illustrated in Fig. 14, Fig. 16, and Fig. 17, a rear end edge 416 of the cage body 410 facing the substrate 100 when mounted defines substantially a rectangular rear opening 416a. As illustrated in Fig. 16, when the cage 400 is mounted on the substrate 100, the connector 200 mounted on the substrate 100 is accommodated in the space inside a portion including the rear opening 416a of the cage body 410.

Further, as illustrated in Fig. 14 and Fig. 15, a front end edge 417 on the opposite side to the rear end edge 416 defines substantially a rectangular front opening 417a. The pluggable module 20 is inserted from the front opening 417a along the insertion-extraction direction Die. EMI fingers 420 are provided on respective sides of the front end edge 417.

The cage bodies 410 of the double configuration will now be described.

The cage bodies 410 of the double configuration correspond to a combination of two cage bodies 410 having a common external wall.

The cage bodies 410 of the double configuration will be described below in detail with reference to two examples.

### « Example 1 of Cage Body »

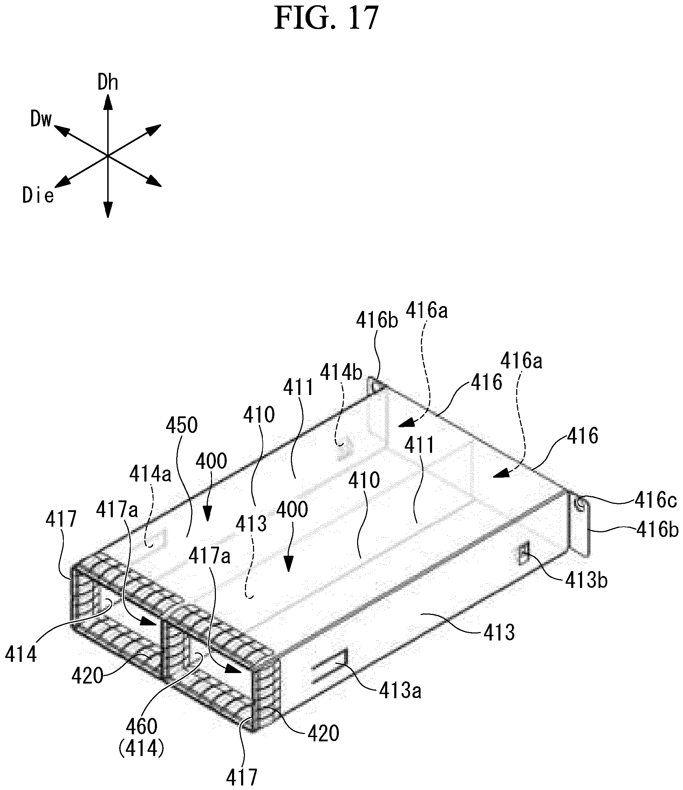

As illustrated in Fig. 17 to Fig. 19, the cage bodies 410 of the double configuration are formed of a double outer cage 450 as a common external wall and a single partition wall 460 (a partition plate).

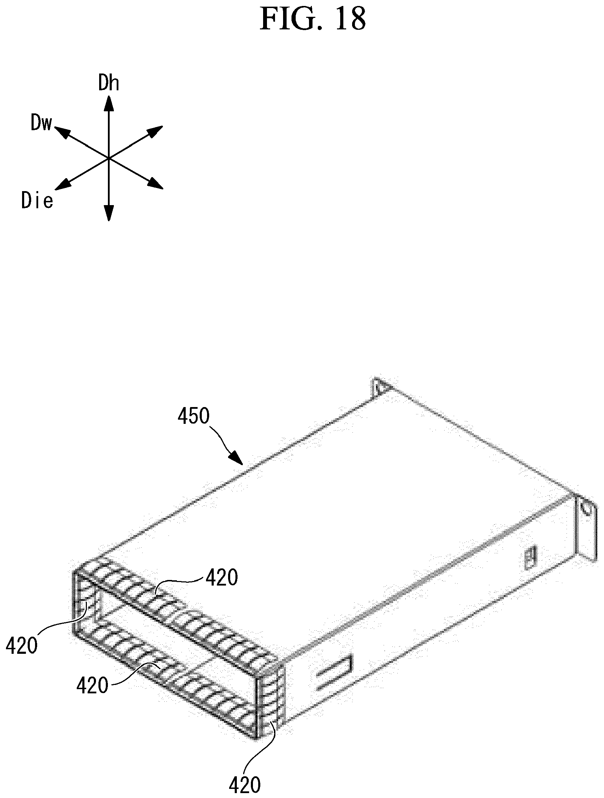

As illustrated in Fig. 18, the double outer cage 450 is a rectangular cylindrical component that extends in the insertion-extraction direction Die and is wider in the width direction Dw. The size of the space defined by the double outer cage 450 is naturally large enough to accommodate a plurality of pluggable modules 20 (in this example, two pluggable modules 20 aligned in the width direction Dw).

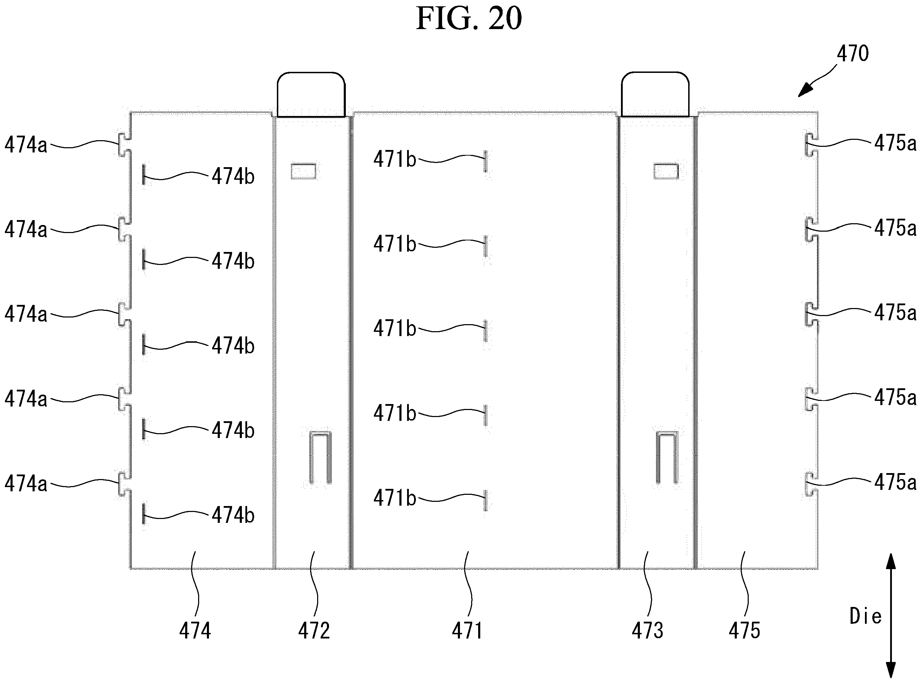

As illustrated in Fig. 20, the double outer cage 450 is formed of a single plate material 470 punched by a press or the like into a predetermined shape. The plate material 470 is formed of a first plate-like part 471, a second plate-like part 472, a third plate-like part 473, a fourth plate-like part 474, and a fifth plate-like part 475 and is bent on boundaries between respective faces and formed into a rectangular cylindrical shape.

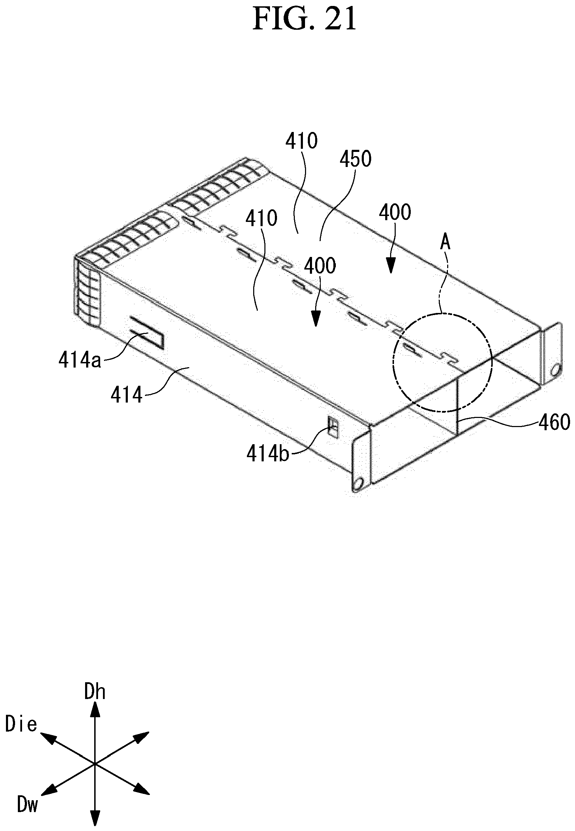

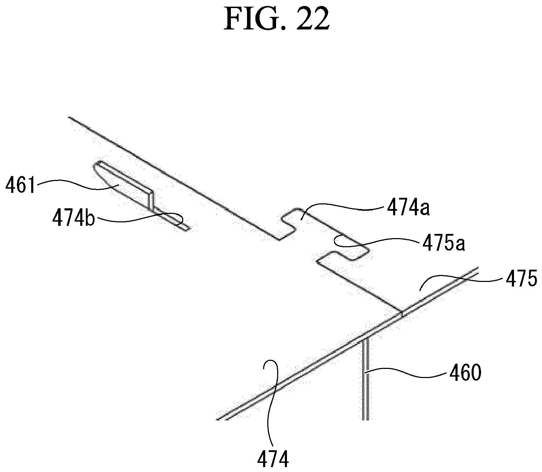

A plurality of latch claws 474a are provided along the insertion-extraction direction Die at one side edge of the plate material 470 (the side edge of the fourth plate-like part 474), and a plurality of notches 475a each having a shape adapted to the shape of the latch claw 474a are provided along the insertion-extraction direction Die in the other side edge of the plate material 470 (the side edge of the fifth plate-like part 475). Further, as illustrated in Fig. 21 and Fig. 22, the latch claws 474a are fitted into corresponding notches 475a and crimped when the plate material 470 is bent into the rectangular cylindrical shape, and thereby a rigidly integrated rectangular cylindrical double outer cage 450 is formed. In this state, one face facing the first plate-like part 471 is formed by the fourth plate-like part 474 and the fifth plate-like part 475. Note that the first plate-like part 471 corresponds to bottom walls 412 (or top walls 411) of the two cage bodies 410, and the one face formed by the fourth plate-like part 474 and the fifth plate-like part 475 corresponds to the top walls 411 (or the bottom walls 412) of the two cage bodies 410.

As illustrated in Fig. 20, the first plate-like part 471 is provided with a plurality of elongated hook holes 471b (engagement holes) in a line along the insertion-extraction direction Die. Further, the fourth plate-like part 474 is provided with a plurality of elongated hook holes 474b (engagement holes) in a line along the insertion-extraction direction Die. In the rectangular cylindrical double outer cage 450, each hook hole 471b and each hook hole 474b face each other in the height direction Dh.

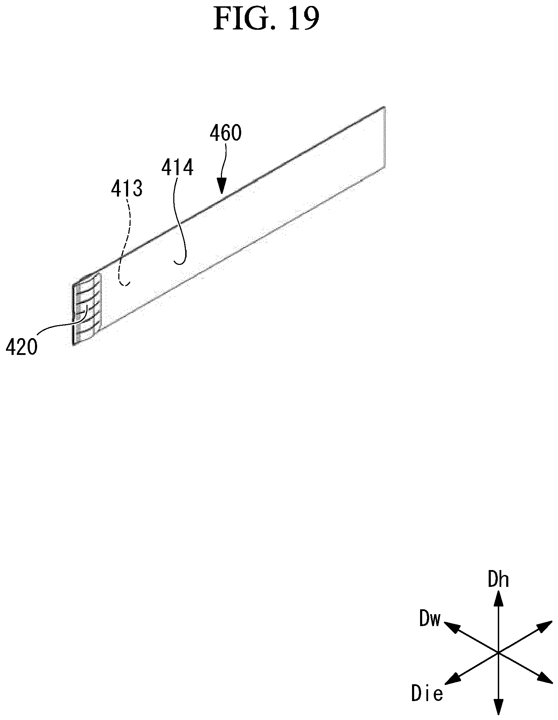

As illustrated in Fig. 19, the partition wall 460 is a plate-like component extending in the insertion-extraction direction Die and erected in the height direction Dh. The partition wall 460 is a component for not only partitioning the space defined by the double outer cage 450 but also serving as a beam to structurally reinforce the double outer cage 450.

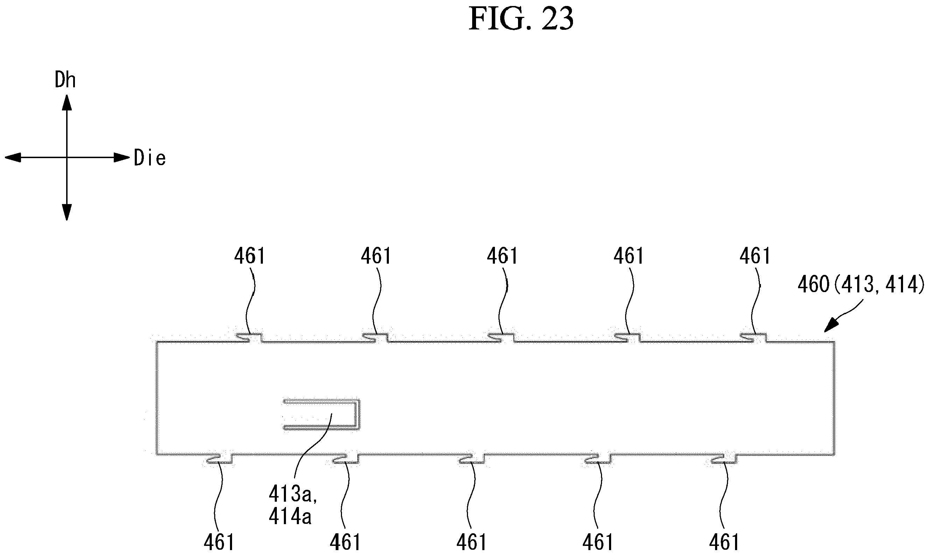

As illustrated in Fig. 23, a plurality of hooks 461 (protrusions) are provided along the insertion-extraction direction Die on the top edge and the bottom edge of the partition wall 460 that face each other in the height direction Dh. Further, as illustrated in Fig. 21 and Fig. 22, each hook 461 is inserted into and engaged with each hook hole 471b and each hook hole 474b described above, and thereby the partition wall 460 is fixed to the double outer cage 450. In detail, after the hooks 461 are inserted in the hook holes 471b, the partition wall 460 can be fixed by being moved in the insertion-extraction direction Die from the rear to the front. Note that any other fixing methods that can fix the partition wall 460 to the double outer cage 450 may be employed.

As illustrated in Fig. 19 and Fig. 23, the partition wall 460 is arranged at the center in the width direction Dw in the space defined by the double outer cage 450 and divides the space inside the double outer cage 450 into two (equally bisected) in the width direction Dw.

Accordingly, the pair of cage bodies 410 having the same shapes aligned in the width direction Dw are rigidly formed. In this state, the right wall 413 of one cage body 410 and the left wall 414 of the other cage body 410 connected thereto are formed of a common partition wall 460.

Herein, to equally bisect the space inside the double outer cage 450 in the width direction Dw, it is required for each hook hole 474b to be located at the center of one face formed by the fourth plate-like part 474 and the fifth plate-like part 475 in the width direction Dw (naturally, each hook hole 471b facing each hook hole 474b is located at the center of the first plate-like part 471 in the width direction Dw). Thus, as illustrated in Fig. 20, in the plate material 470 developed from the double outer cage 450, the width dimension of the fourth plate-like part 474 (except for the portion of the latch claw 474a) provided with each hook hole 474b is larger than the width dimension of the fifth plate-like part 475 (except for the portion of the notch 475a).

Note that, when the width dimension of the fifth plate-like part 475 is larger than the width dimension of the fourth plate-like part 474, hook holes may be provided in the fifth plate-like part 475.

As illustrated in Fig. 23, respective hooks 461 provided on the top edge of the partition wall 460 are arranged in a staggered manner in the insertion-extraction direction Die with respect to respective hooks 461 provided on the bottom edge of the partition wall 460.

Accordingly, when the cage bodies 410 of the double configuration are stacked in the height direction Dh, it is possible to prevent interference between each hook 461 provided on the bottom edge of a partition wall 460 located above and each hook 461 provided on the top edge of a partition wall 460 located below.

### « Example 2 of Case Body »

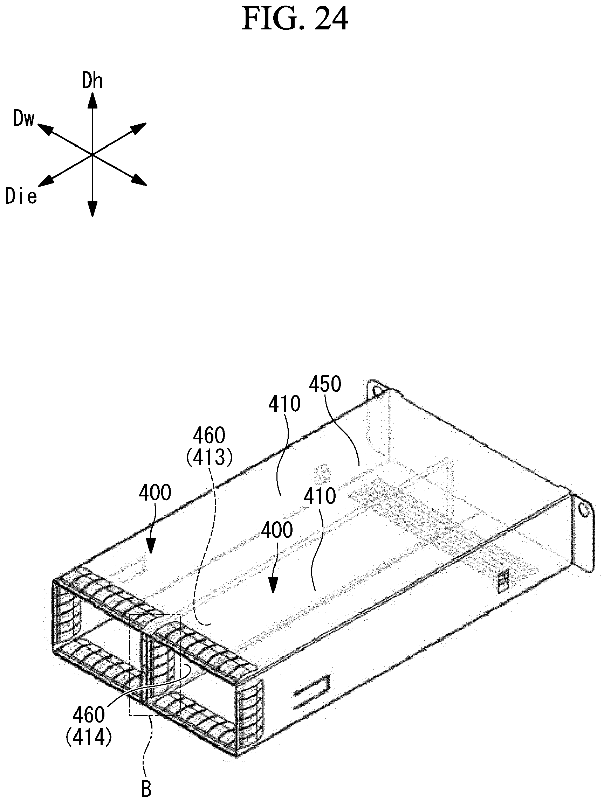

As illustrated in Fig. 24, the cage bodies 410 of the double configuration are formed of the double outer cage 450 and two partition walls 460. The use of two partition walls 460 can improve the structural strength.

The double outer cage 450 is a rectangular cylindrical component that extends in the insertion-extraction direction Die and is wider in the width direction Dw in the same manner as Example 1.

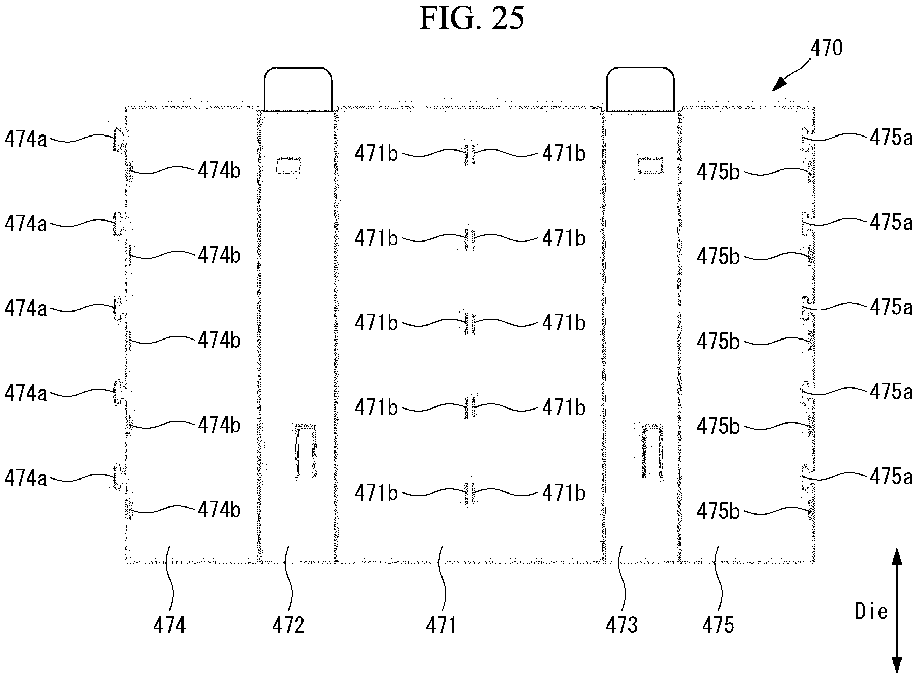

As illustrated in Fig. 25, this double outer cage 450 is formed of a single plate material 470 punched by a press or the like into a predetermined shape. The plate material 470 is formed of a first plate-like part 471, a second plate-like part 472, a third plate-like part 473, a fourth plate-like part 474, and a fifth plate-like part 475 and is bent on boundaries between respective faces and formed into a rectangular cylindrical shape.

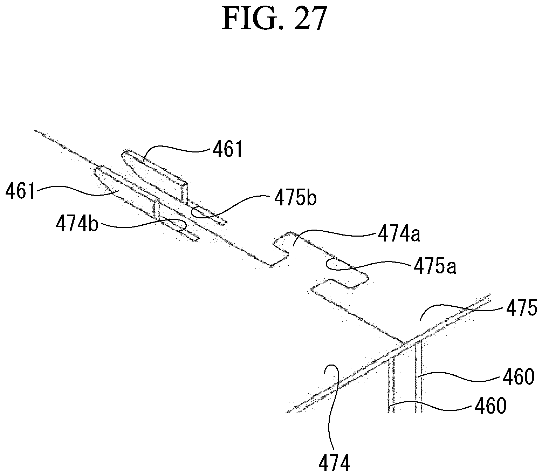

A plurality of latch claws 474a are provided along the insertion-extraction direction Die at one side edge of the plate material 470 (the side edge of the fourth plate-like part 474), and a plurality of notches 475a each having a shape adapted to each shape of the latch claws 474a are provided along the insertion-extraction direction Die in the other side edge of the plate material 470 (the side edge of the fifth plate-like part 475). Further, as illustrated in Fig. 25 and Fig. 27, each latch claw 474a is fitted into each notch 475a and crimped when the plate material 470 is bent into the rectangular cylindrical shape, and thereby a rigidly integrated, rectangular cylindrical double outer cage 450 is formed.

As illustrated in Fig. 25, the first plate-like part 471 is provided with a plurality of hook holes 471b in two lines along the insertion-extraction direction Die. Further, the fourth plate-like part 474 is provided with a plurality of hook holes 474b in a line along the insertion-extraction direction Die. Further, the fifth plate-like part 475 is provided with a plurality of hook holes 475b in a line along the insertion-extraction direction Die. In the rectangular cylindrical double outer cage 450, each hook hole 471b on one line and each hook hole 474b face each other in the height direction Dh, and each hook hole 471b on the other line and each hook hole 475b face each other in the height direction Dh.

The configuration of each partition wall 460 is the same as that of Example 1.

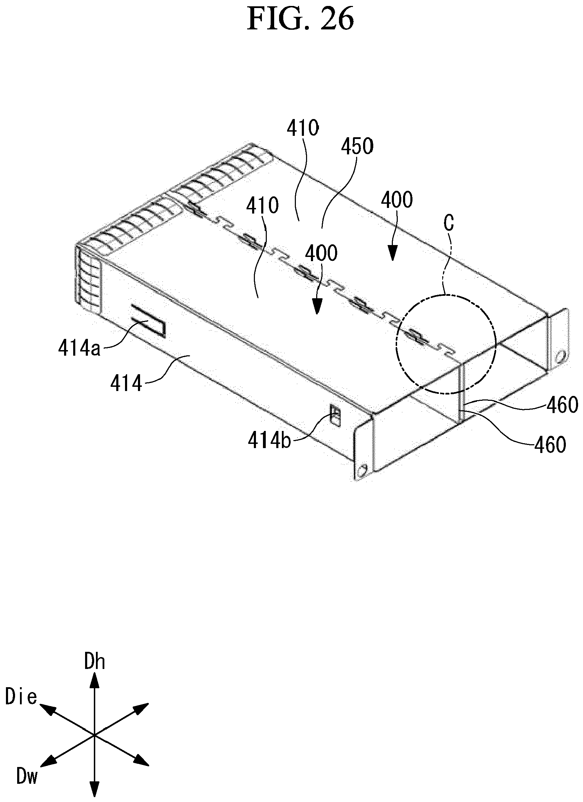

As illustrated in Fig. 24 and Fig. 26, the two partition walls 460 are arranged adjacently at substantially the center in the width direction Dw in the space defined by the double outer cage 450. In detail, the two partition walls 460 are arranged evenly so that the space defined by the double outer cage 450 and one partition wall 460 (the space corresponding to one cage body 410) and the space defined by the double outer cage 450 and the other partition wall 460 (the space corresponding to the other cage body 410) have the same shape.

Accordingly, a pair of cage bodies 410 having the same shape aligned in the width direction Dw are rigidly formed. In this state, the right wall 413 of one cage body 410 is formed of one partition wall 460, and left wall 414 of the other cage body 410 is formed of the other partition wall 460.

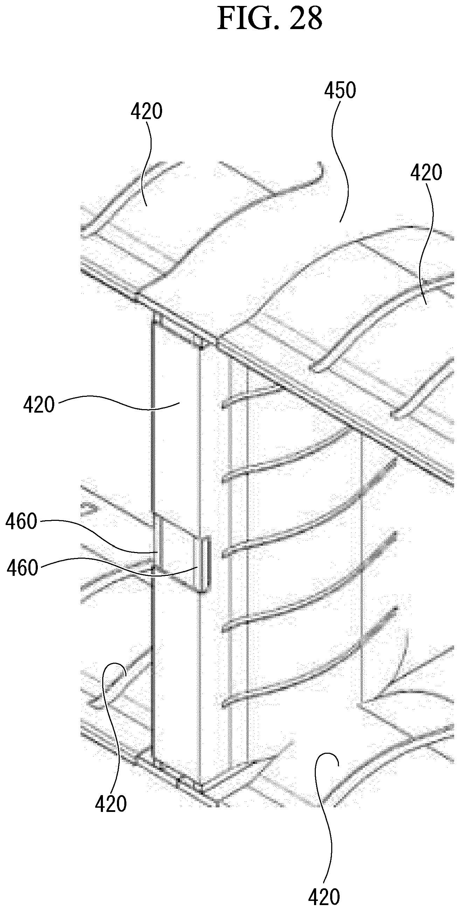

Note that, as illustrated in Fig. 24 and Fig. 28, the EMI finger 420 is provided so as to collectively cover ends of two partition walls 460. Thus, a common EMI finger 420 is provided on two partition walls 460.

In the plate material 470 of Example 2, the width dimension of the fourth plate-like part 474 (except for the portion of the latch claw 474a) provided with each hook hole 474b is equal to the width dimension of the fifth plate-like part 475 (except for the portion of the notch 475a) provided with each hook hole 475b. Thus, when the plate material 470 has been bent and formed into the double outer cage 450, the side edge of the fourth plate-like part 474 and the side edge of the fifth plate-like part 475 are arranged symmetrically with respect to the insertion-extraction direction Die at substantially the center of the double outer cage 450.

In this example, respective hook holes 474b are provided near the side edge of the fourth plate-like part 474 and respective hook holes 475b are provided near the side edge of the fifth plate-like part 475. Thus, when the double outer cage 450 has been formed, respective hook holes 474b and respective hook holes 475b are also arranged symmetrically with respect to the insertion-extraction direction Die at substantially the center of the double outer cage 450. In other words, respective hook holes 474b and respective hook holes 475b are located near the seam which is present at substantially the center of the double outer cage 450. Thus, the partition walls 460 fixed to respective hook holes 474b and respective hook holes 475b are also arranged near the seam which is present at substantially the center of the double outer cage 450. Accordingly, respective partition walls 460 support areas near the side edge of the fourth plate-like part 474 and near the side edge of the fifth plate-like part 475, and this can improve the structural strength near the seam.

In this example, the distance between the hook hole 474b and the side edge of the fourth plate-like part 474 and the distance between the hook hole 475b and the side edge of the fifth plate-like part 475 are designed so as to ensure distances sufficient to enable machining by a press method.

Note that the cage bodies 410 are not necessarily required to have a double configuration, and may have a single-body (single-port) configuration or may have a triple or more-number configuration in the width direction Dw.

The "single-body (single-port) configuration" as used herein means a form such that a space in which a single pluggable module 20 is inserted is defined by a single rectangular cylindrical outer cage.

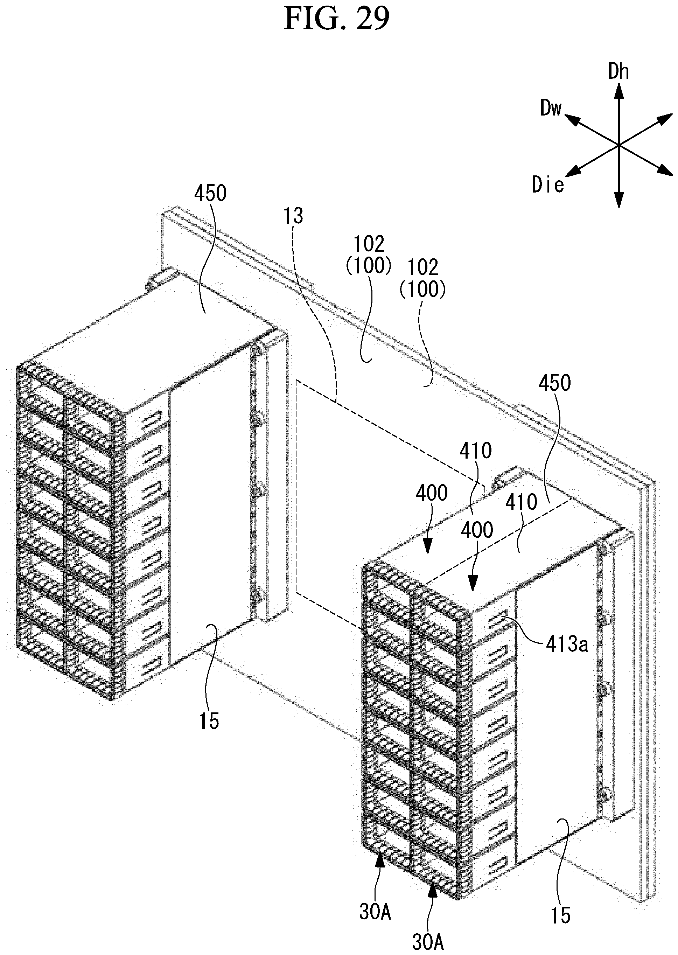

The cage 400 of the double configuration configured as described above is mounted such that the insertion-extraction direction Die of the pluggable module 20 is substantially perpendicular to the front side 101 of the substrate 100, as illustrated in Fig. 29. Thus, the cage 400 is mounted such that the extending direction of the cylindrical cage bodies 410 (double outer cages 450) is substantially perpendicular to the front side 101 of the substrate 100. Further, these cages 400 (double outer cages 450) are mounted along the height direction Dh in regions of the front side 101, which are present on the opposite side to regions located on both sides of the integrated circuit 13 on the back side 102 of the substrate 100, so as to correspond to the arrangement of the connector 200.

The pluggable module 20 is then inserted in the cage body 410 along the insertion-extraction direction Die and thereby guided to the connector 200 mounted on the substrate 100, and the module substrate 21 of the pluggable module 20 is inserted in the connector 200.

Note that the pluggable module 20 is latched and positioned by fixing claws 413a or stopper claws 413b formed on the right wall 413 and fixing claws 414a or stopper claws 414b formed on the left wall 414 of the cage body 410 (see Fig. 17, Fig. 21, and Fig. 23). Thus, the amount of insertion of the module substrate 21 into the connector 200 is determined by the positions of the fixing claws 413a or the stopper claws 413b and the fixing claws 414a or the stopper claws 414b.

The method of mounting (fixing) the cages 400 (double outer cages 450) on the substrate 100 will be described later.

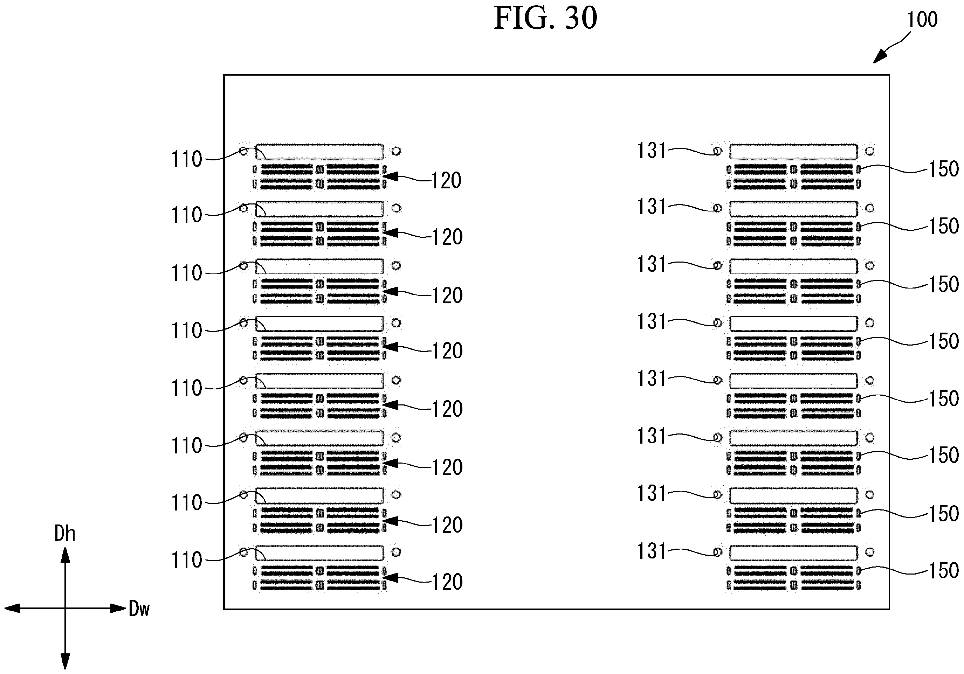

As illustrated in Fig. 30, the substrate 100 on which the cages 400 are mounted has substrate openings 110.

As illustrated in Fig. 12, Fig. 16, and Fig. 30, each substrate opening 110 is a hole penetrating between the front side 101 and the back side 102 of the substrate 100. The substrate opening 110 is formed above the electrode pad 120 in the height direction Dh.

In the present embodiment, as illustrated in Fig. 12 and Fig. 16, when the receptacle assembly 30A has been mounted on the substrate 100, the region inside the cage body 410 in which the first heat sink 23 of the pluggable module 20 is arranged overlaps the position where the substrate opening 110 is formed when viewed in the insertion-extraction direction Die. Thus, the substrate opening 110 is formed on the extension line along the insertion-extraction direction Die in a region inside the cage body 410 in which the first heat sink 23 is arranged.

This allows cooling air flowing along the grooves formed in the first heat sink 23 (see Fig. 3) to smoothly flow to the back side 102 of the substrate 100 via the substrate opening 110, and this can improve cooling performance.

### < Connecting Panel >

As illustrated in Fig. 29, in the receptacle assembly 30A, sets of cages 400 of the double configuration are mounted on the substrate 100 over multiple levels in the height direction Dh.

In this state, it is preferable that a common connecting panel 15 be attached to the right walls 413 of the cage bodies 410 (double outer cages 450) of the cages 400 aligned in the height direction. The connecting panel 15 is a single plate-like member that connects a plurality of right walls 413 aligned in the height direction to each other.

Further, although not illustrated, it is preferable that a common connecting panel 15 be also attached to the left walls 414 of the cage bodies 410 (double outer cages 450) aligned in the height direction.

By attaching the connecting panel 15, it is possible to rigidly integrate connected bodies of the cages 400 aligned in the height direction Dh. Further, the integration of the cages 400 allows for easier handling compared to a case where respective cages 400 are handled individually. Further, compared to a case where respective cages 400 are handled individually, positional accuracy of the cage 400 in the insertion-extraction direction Die can be ensured, and this leads to smooth insertion and extraction of the pluggable module 20 and can realize improvement on durability of the cage 400 and the pluggable module 20 associated with insertion and extraction thereof.

### < Modified Example of Cage Body >

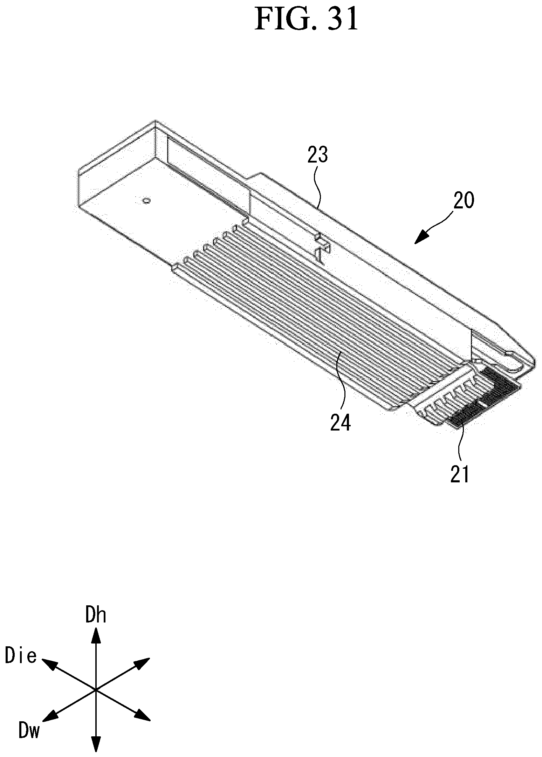

As illustrated in Fig. 31, the pluggable module 20 may be an OSFP-XD module of the type having a second heat sink 24 built on the bottom in addition to the first heat sink 23. Grooves along the insertion-extraction direction Die are formed in the second heat sink 24, and cooling air flows along the grooves.

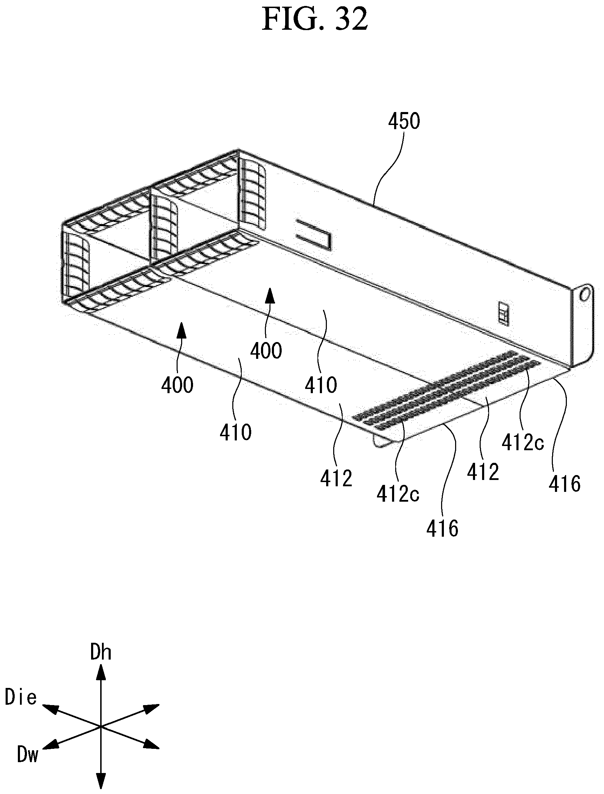

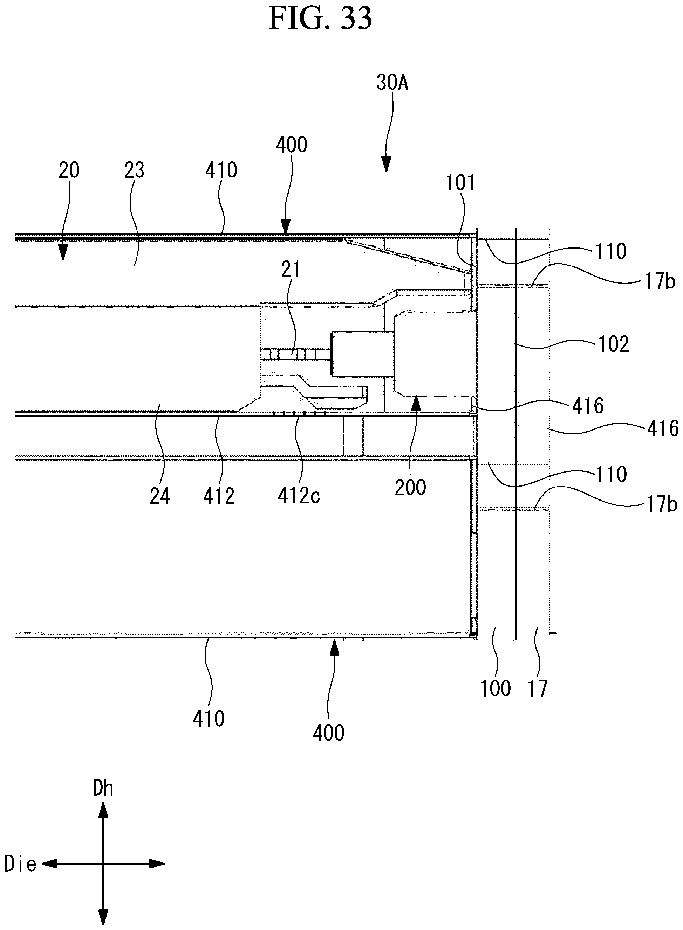

When using the pluggable module 20 having the second heat sink 24, it is preferable to form a plurality of vent holes 412c in the bottom wall 412 of the cage body 410, as illustrated in Fig. 32 and Fig. 33.

Each vent hole 412c is a hole penetrating through the bottom wall 412. The vent hole 412c is formed near the rear end edge 416 located downstream of the airflow.

By providing the vent holes 412c, it is possible to cause cooling air flowing along the grooves formed in the second heat sink 24 (see Fig. 31) to flow to outside of the cage body 410.

Note that, as illustrated in Fig. 33, air guided to outside of the cage body 410 flows to the back side 102 of the substrate 100 via another substrate opening 110 formed for another receptacle assembly 30A mounted below the cage body 410 of interest.

### < Mounting Method (Fixing Method) of Cage >

For example, the cage 400 is mounted (fixed) on the substrate 100 as with Example 1 to Example 4 described below.

Note that the shape or the configuration of the cage body 410 and the shape or the configuration of the substrate 100 differ among respective examples, and these points will be described together.

### « Example 1 of Mounting Method (Fixing Method) »

As illustrated in Fig. 34, the mounting method according to the present example is to provide a flange 416b as a fixing part to each cage body 410 and use respective flanges 416b and also one back plate 17 (a first plate) and two base plates 16 (second plates) to fix respective cage bodies 410 (respective double outer cages 450) to the substrate 100.

As illustrated in Fig. 17, the rear end edge 416 of the cage body 410 is provided with the flange 416b expanding in the width direction Dw.

Specifically, out of two cage bodies 410 aligned in the width direction Dw, the rear end edge 416 formed on the right wall 413 of the right cage body 410 in Fig. 17 is provided with the flange 416b expanding to the right, and the rear end edge 416 formed on the left wall 414 of the left cage body 410 in Fig. 17 is provided with the flange 416b expanding to the left. Thus, in view of a double outer cage 450, the flanges 416b are formed on both the ends in the width direction Dw.

Note that, when the cage body 410 is used as a single body (a single port), two flanges 416b can be formed on one cage body 410.

Further, when the cage body 410 is used as a single body (a single port), in addition to or instead of the two flanges 416b, flanges expanding in the height direction Dh may be provided at the rear end edge 416 formed on the top wall 411 and the rear end edge 416 formed on the bottom wall 412 of the cage body 410.

A hole 416c is formed in each flange 416b.

The hole 416c is a circular hole penetrating through the flange 416b. A fixing screw 18 (see Fig. 34) is inserted through the hole 416c.

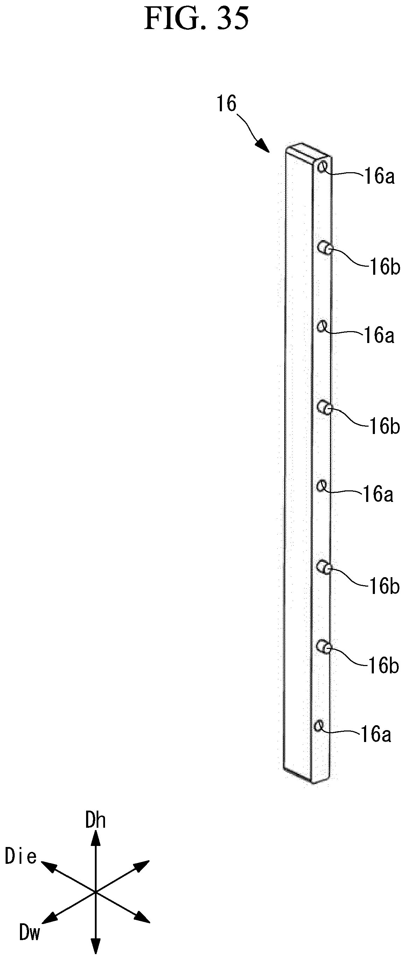

As illustrated in Fig. 34 and Fig. 35, the base plate 16 is a rectangular bar-shape member extending in the height direction Dh. The base plate 16 is molded by die casting, for example. An example of the material is zinc or a zinc alloy.

A plurality of through holes 16a and a plurality of positioning pins 16b are formed aligned in one line in the height direction Dh in and to a predetermined face of the base plate 16.

Each through hole 16a is a hole penetrating through the base plate 16. The fixing screw 18 (see Fig. 34) is inserted through the through hole 16a.

Each positioning pin 16b is a columnar protrusion protruding from the predetermined face of the base plate 16. While molded by die casting as described above, the positioning pin 16b may be provided on the base plate 16 by press-fitting or adhesion, for example.

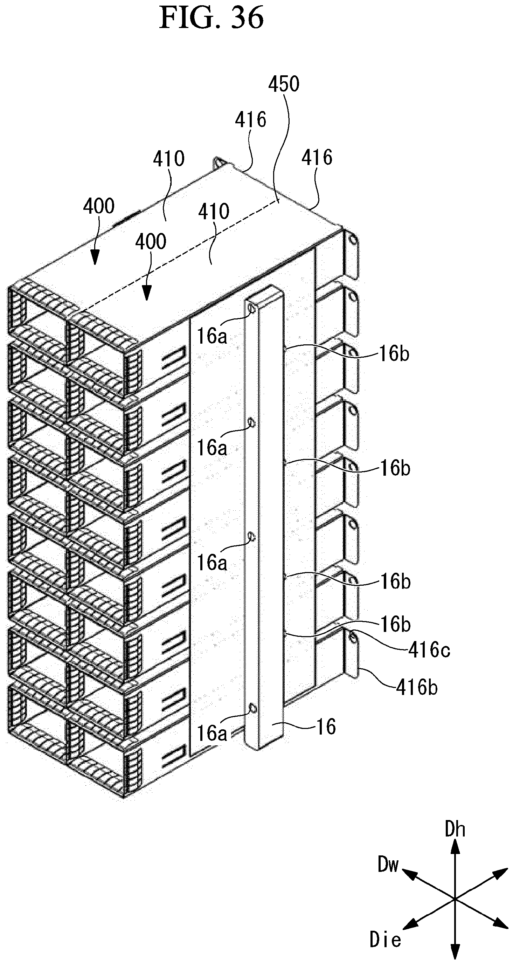

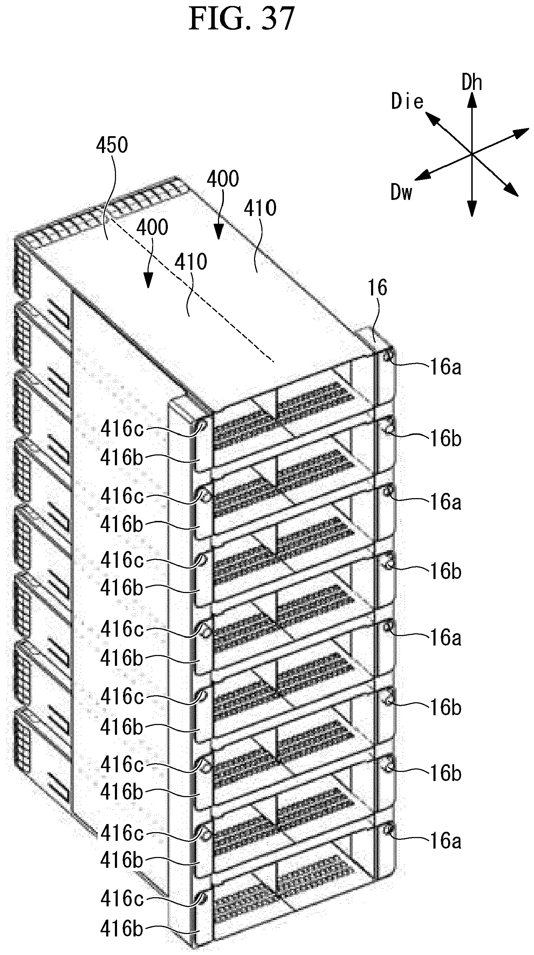

As illustrated in Fig. 36 and Fig. 37, the positions of the through holes 16a and the positioning pins 16b correspond to the positions of the holes 416c formed in the flange 416b.

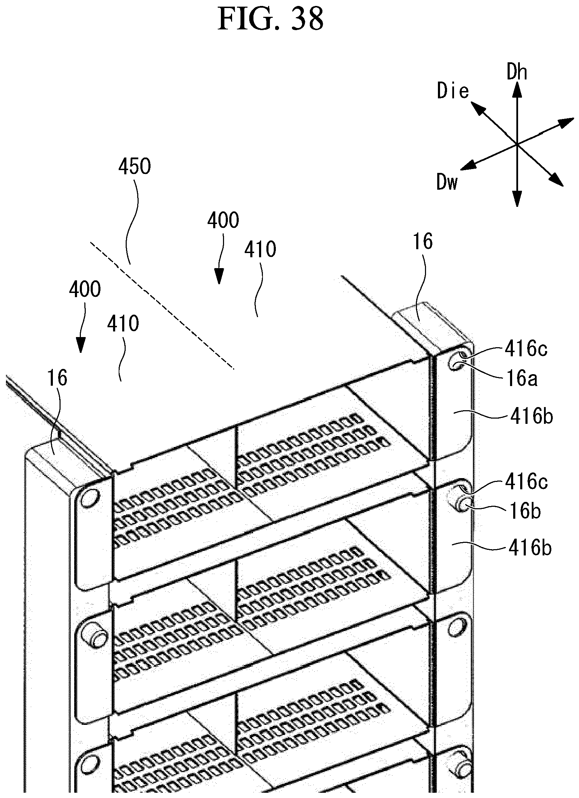

Further, as illustrated in Fig. 38, in a state where the base plate 16 is in contact with the flanges 416b, the positioning pins 16b protrude to the backside out of the holes 416c formed in the flanges 416b.

Each hole 416c corresponds to either one of the through hole 16a or the positioning pin 16b.

In the case of Fig. 36 and Fig. 37, the first, third, fifth, and eighth left and right holes 416c from the top correspond to the through holes 16a, and the second, fourth, sixth, and seventh left and right holes 416c from the top correspond to the positioning pins 16b.

Note that it is preferable that the uppermost (first) hole 416c and the lowermost (eighth) hole 416c correspond to the through holes 16a in terms of stable fastening by the screw 18.

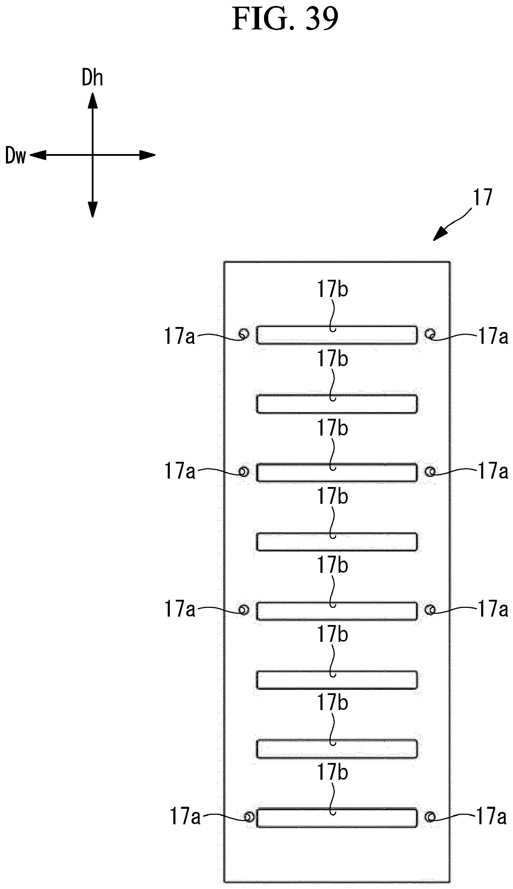

As illustrated in Fig. 34 and Fig. 39, the back plate 17 is a flat plate member.

The back plate 17 is provided with a plurality of screw holes 17a and back plate openings 17b.

Each screw hole 17a is a hole into which a screw inserted through the through hole 16a of the base plate 16, the hole 416c of the flange 416b, and a through hole 131 of the substrate 100 is screwed. Thus, the positions of the screw holes 17a correspond to the positions of the through holes 16a. In the case of Fig. 34 and Fig. 39, there are four pairs of (that is, eight) screw holes 17a.

Each back plate opening 17b is a laterally elongated hole penetrating through the back plate 17. As illustrated in Fig. 12, the positions of the back plate openings 17b overlap the positions where the substrate openings 110 is formed. This allows cooling air flowing along the grooves formed in the first heat sink 23 (see Fig. 3) to smoothly flow to the back side 102 of the substrate 100 via the substrate opening 110 and the back plate openings 17b.

Note that the plurality of back plate openings 17b illustrated in Fig. 39 may be integrated along the height direction Dh. In such a case, the back plate 17 will have a rectangular frame-like shape.

Further, it is possible to form the back plate openings 17b so as to connect and integrate the first and second ones together, the third and fourth ones together, the fifth and sixth ones together, and the seventh and eighth ones together from the top in Fig. 39 into four openings, and it is possible to change the way of connecting and integration as appropriate taking the strength of the back plate 17, the strength of the substrate 100, or the like into consideration.

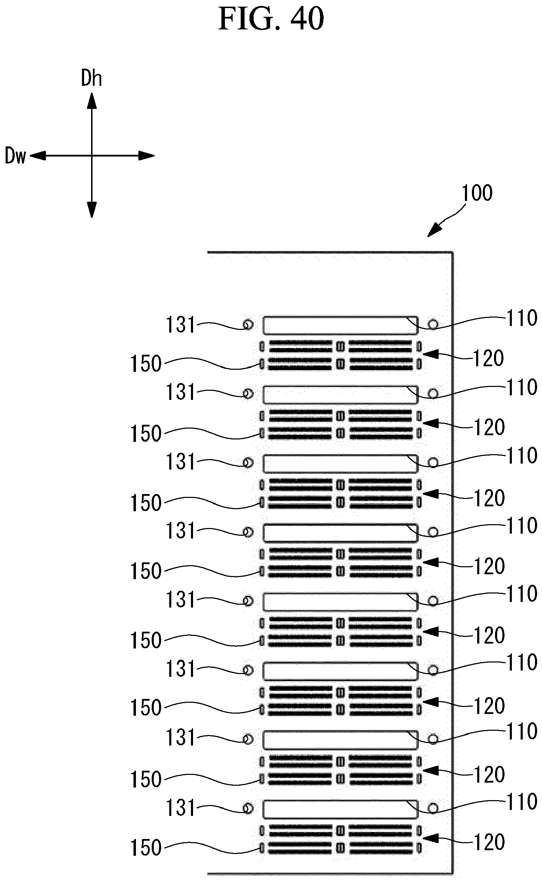

As illustrated in Fig. 34 and Fig. 40, through holes 131 are formed in the substrate 100. Each through hole 131 is a hole penetrating between the front side 101 and the back side 102 of the substrate 100.

The through hole 131 functions as a hole through which the screw 18 inserted through the through hole 16a of the base plate 16 and the hole 416c of the flange 416b is inserted or as a hole in which the positioning pin 16b protruding out of the hole 416c formed in the flange 416b is secured.

Thus, the positions of the through holes 131 correspond to the positions of the through holes 16a and the positions of the positioning pins 16b of the base plate 16, that is, the positions of all the holes 416c of the flanges 416b.

The flanges 416b and also the base plate 16 and the back plate 17 configured as described above are used, and thereby the cage body 410 is fixed to the substrate 100 on which the connector 200 is mounted in advance.

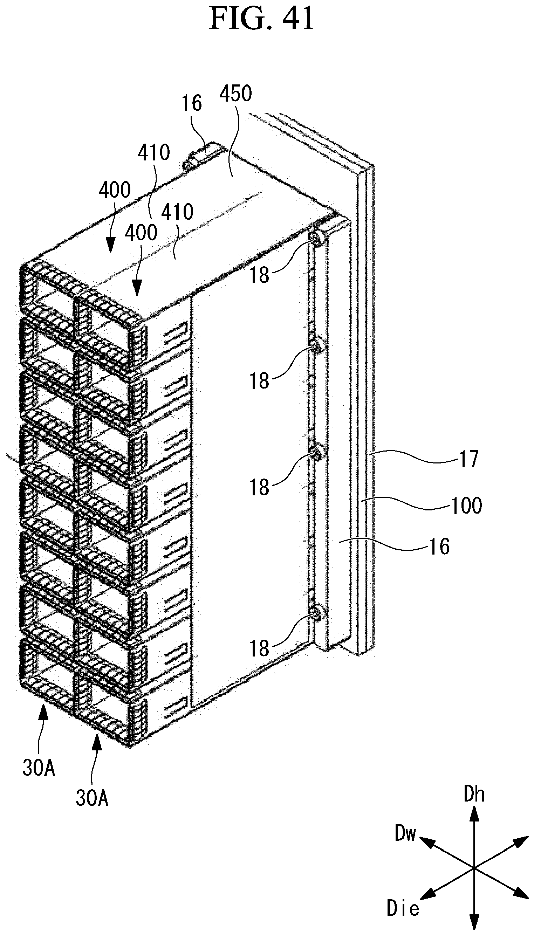

Specifically, as illustrated in Fig. 34 and Fig. 41, the screws 18 are inserted from the front of the base plate 16 through a set of the base plate 16, the flanges 416b, the substrate 100, and the back plate 17 arranged in this order along the insertion-extraction direction Die and are screwed into the screw holes 17a of the back plate 17, thereby the set is fastened, and the cage body 410 is fixed to the substrate 100.

In this state, naturally, shaft parts of the screws 18 penetrate through the through holes 16a of the base plate 16, the holes 416c of the flanges 416b, and the through holes 131 of the substrate 100 and then reach the back plate 17.

In Fig. 34 and Fig. 41, the first, third, fifth, and eighth cage bodies 410 (double outer cages 450) from the top are positioned and fixed by the screws 18, and the second, fourth, sixth, and seventh cage bodies 410 (double outer cages 450) from the top are positioned by the positioning pins 16b.

Note that the positions or the number of screws 18 illustrated in Fig. 34 and Fig. 41 are examples and, obviously, can be changed as appropriate in accordance with specifications.

In any cases, the base plates 16 are in contact with the flanges 416b by a plane, the flanges 416b are in contact with the front side 101 of the substrate 100 by a plane, and the back plate 17 is in contact with the back side 102 of the substrate 100 by a plane.

In this state, the cage bodies 410 are positioned in the insertion-extraction direction Die with respect to the substrate 100 by the flanges 416b in contact with the substrate 100.

### <<< Modified Example 1 to Example 1 of Mounting Method (Fixing Method) >>>

In Example 1, the plurality of cage bodies 410 (plurality of double outer cages 450) are fixed to the substrate 100 by using two base plates 16.

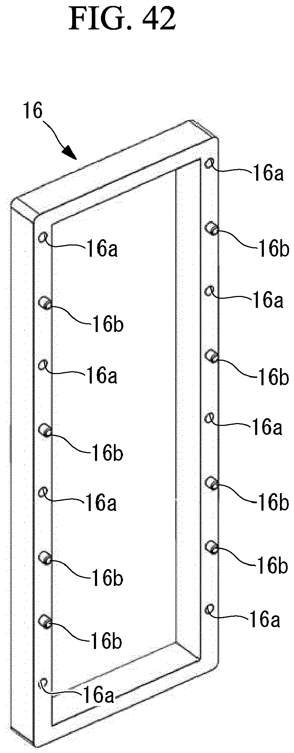

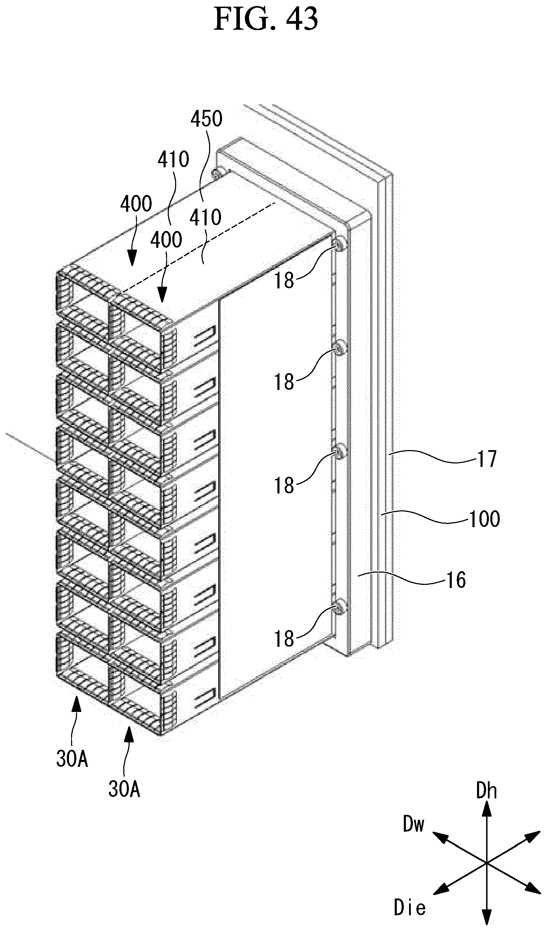

In contrast, in Modified example 1, as illustrated in Fig. 42 and Fig. 43, the two base plates 16 of Example 1 may be integrated into a single base plate 16 having a rectangular frame-like shape (an O-shape). Specifically, the shape may be such that the top ends of the two base plates 16 of Example 1 may be connected to each other and the bottom ends of the two base plates 16 of Example 1 may be connected to each other by bar-like parts extending in the width direction Dw.

This facilitates handling of the base plate 16.

### <<< Modified Example 2 to Example 1 of Mounting Method (Fixing Method) >>>

In Modified example1, the base plate 16 having a rectangular frame-like shape is molded by die casting. Further, the positioning pins 16b are integrally formed by die casting.

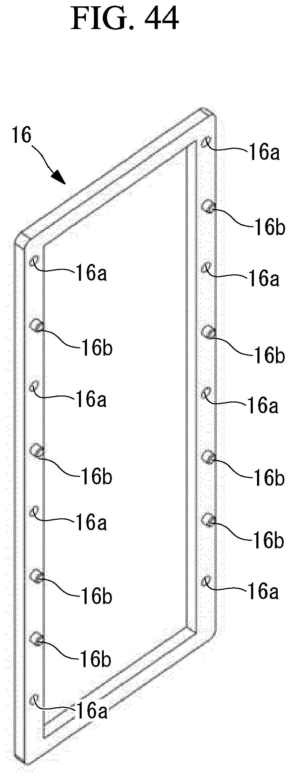

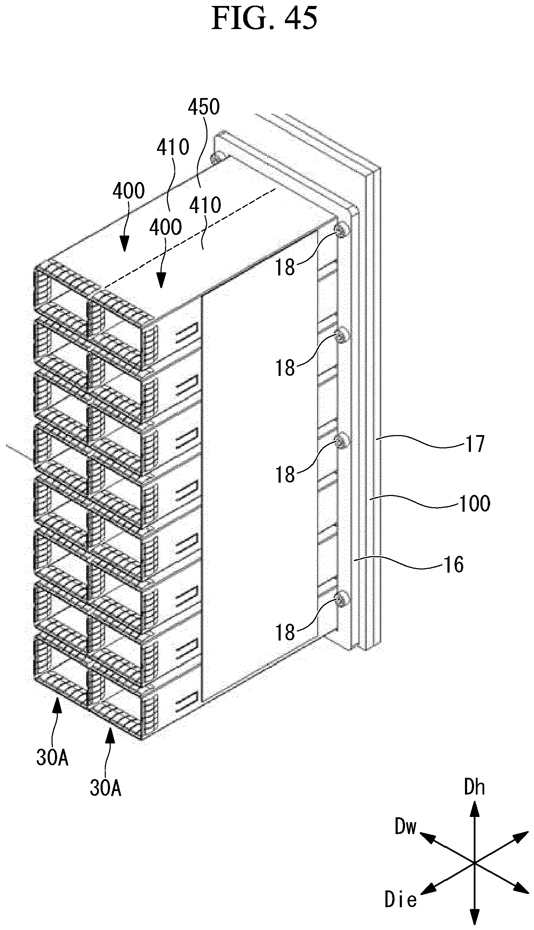

In contrast, in Modified example 2, as illustrated in Fig. 44 and Fig. 45, the positioning pins 16b are fixed to the pressed-out base plate 16 by press-fitting or adhesion, for example. Further, compared to Modified example 1, the base plate 16 is thinned into a plate shape. An example of the material is stainless steel.

By employing press working, it is possible to produce the base plate 16 less expensively and more accurately than when employing die casting.

### <<< Modified Example 3 to Example 1 of Mounting Method (Fixing Method) >>>

When the cage body 410 is used in a single-body (a single-port) configuration and when flanges (holes for the screws 18 are not required) are formed at the rear end edges 416 of all the walls of the cage body 410, the cage body 410 may be fixed to the substrate 100 by the following method.

Thus, the screw 18 may be inserted through from the front of the base plate 16 and screwed into the screw hole 17a of the back plate 17 to fix the cage body 410 to the substrate 100 with four flanges expanding in the height direction Dh and the width direction Dw being interposed between the base plate 16 and the substrate 100. In such a case, openings through which the cage bodies 410 are inserted and which correspond to the cage bodies 410 in one-to-one manner are formed in the single base plate 16, and the number of such openings is the same as that of cage bodies 410. For example, when the cage bodies 410 are arranged in two by eight, the openings formed in the base plate 16 are also arranged in two by eight.

Note that, in a state where the cage body 410 is inserted through the opening of the base plate 16, each flange comes into contact with the rear face of the base plate 16 and functions as a stopper to prevent the cage body 410 from falling out of the opening.
Further, it is preferable to form a protruding portion having the same thickness dimension as the flange to a face (a rear face) of the base plate 16 where the flange is located.

The base plate 16 is manufactured by sheet metal press working or die casting, for example.

### « Example 2 of Mounting Method (Fixing Method) »

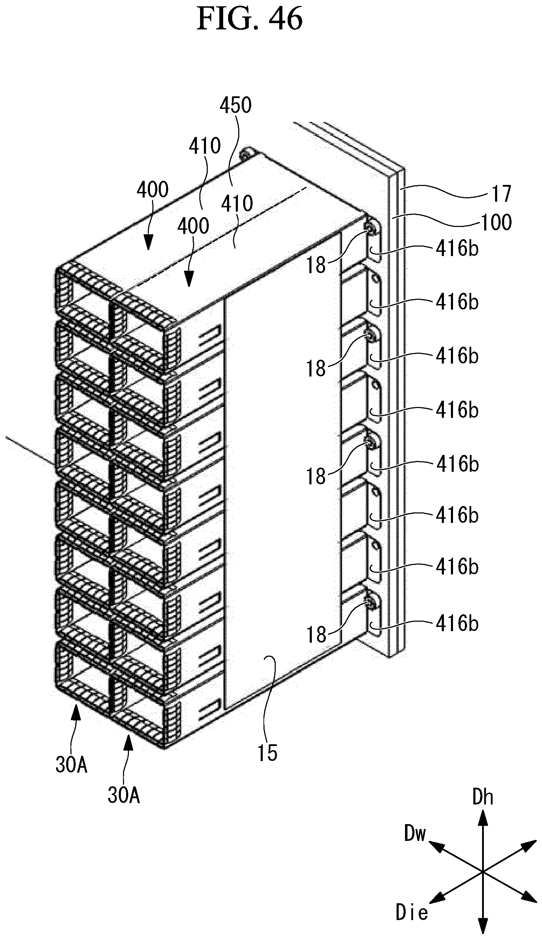

As illustrated in Fig. 46, the mounting method according to the present example is to provide the flanges 416b to each cage body 410 and use these flanges 416b and one back plate 17 (a first plate) to fix respective cage bodies 410 (respective double outer cages 450) to the substrate 100.

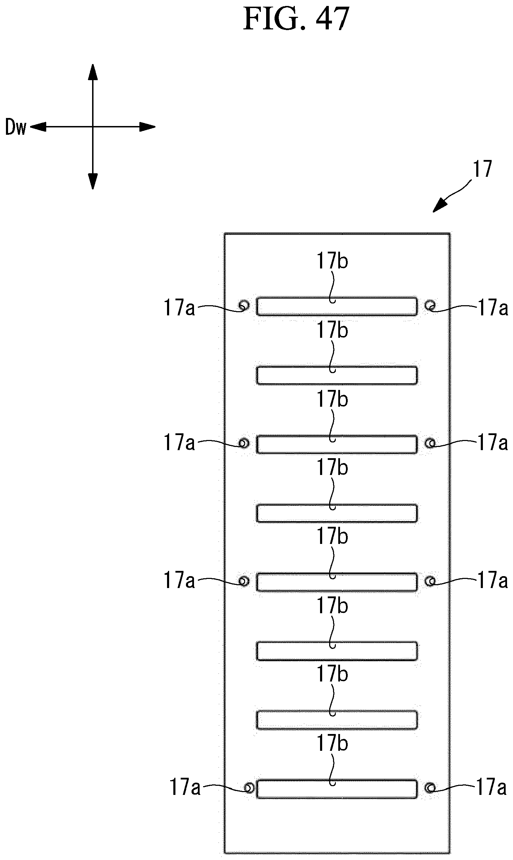

### As illustrated in Fig. 47, the back plate 17 is a flat plate member.

The back plate 17 is provided with a plurality of screw holes 17a and back plate openings 17b.

Each screw hole 17a is a hole into which the screw 18 inserted through the hole 416c of the flange 416b and the through hole 131 of the substrate 100 is screwed. Thus, the positions or the number of screw holes 17a correspond to the positions or the number of holes 416c.

The back plate opening 17b is the same as that of Example 1.

The flanges 416b and the back plate 17 configured as described above are used, and thereby the cage body 410 is fixed to the substrate 100 on which the connector 200 is mounted in advance.

Specifically, as illustrated in Fig. 46, the screws 18 are inserted from the front of the flange 416b through a set of the flanges 416b, the substrate 100, and the back plate 17 arranged in this order and are screwed into the screw holes 17a of the back plate 17, thereby the set is fastened, and the cage body 410 is fixed to the substrate 100.

In this state, naturally, shaft parts of the screws 18 penetrate through the holes 416c of the flanges 416b and the through holes 131 of the substrate 100 and then reach the back plate 17.

In Fig. 46, respective flanges 416b of the first, third, fifth, and eighth cage bodies 410 (double outer cages 450) from the top are positioned and fixed by the screws 18. On the other hand, the second, fourth, sixth, and seventh cage bodies 410 (double outer cages 450) from the top are connected to the first, third, fifth, and eighth cage bodies 410 (double outer cages 450) via the connecting panel 15 and thus are not required to be fixed by the screws 18.

However, when the connecting panel 15 is not provided, respective flanges 416b of all the cage bodies 410 (double outer cages 450) are required to be fixed by the screws 18.

Note that the positions or the number of screws 18 illustrated in Fig. 46 are examples and, obviously, can be changed as appropriate in accordance with specifications.

In any cases, the flanges 416b are in contact with the front side 101 of the substrate 100 by a plane, and the back plate 17 is in contact with the back side 102 of the substrate 100 by a plane.

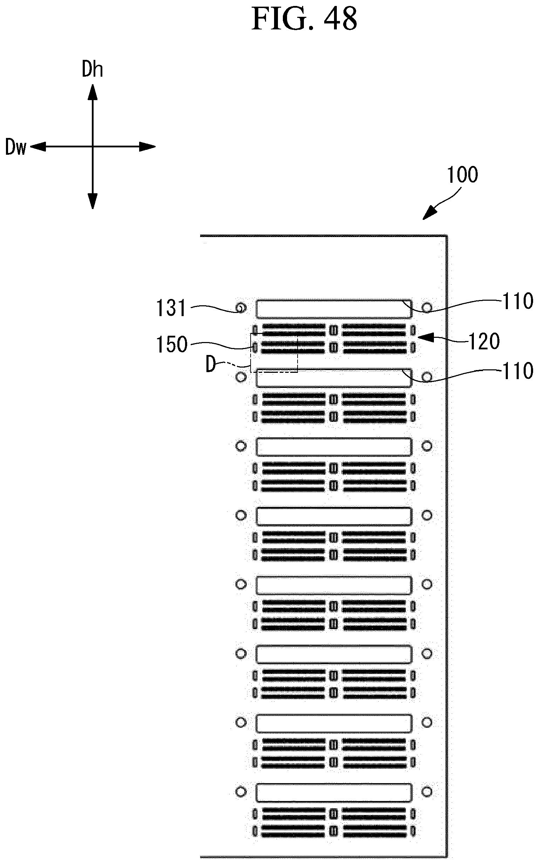

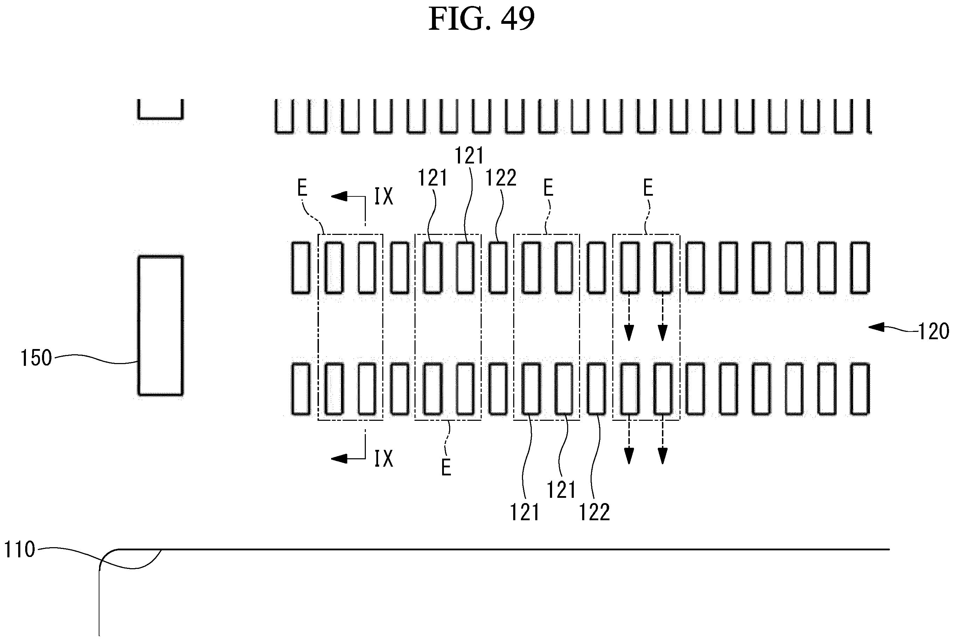

In Example 1 and Example 2 described above, it is not required to form a mechanism or structure (for example, a through hole 132 of Example 3 described later) for fixing the cage body 410 near the electrode pad 120 on the substrate 100, as illustrated in Fig. 48 and Fig. 49.

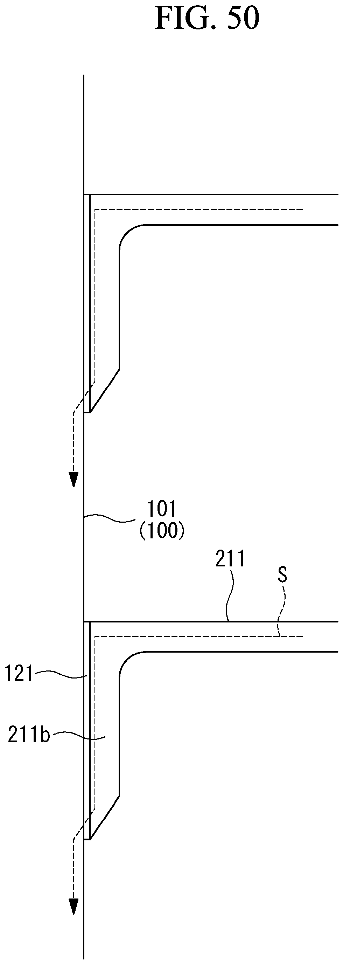

Thus, for example, there is a spatial margin near the electrode pad 120 used for high-speed signal transmission (high-speed signaling pads 121) as indicated by E (with two-dot chain line frames) illustrated in Fig. 49, and this makes it possible to increase flexibility of wiring (routing) from the high-speed signaling pad 121 in the substrate 100. Specifically, as illustrated in Fig. 50, such routing that causes the signal S to flow in an extending direction of the mount part 211b of the signal pin 211 can be taken in the substrate 100, for example.

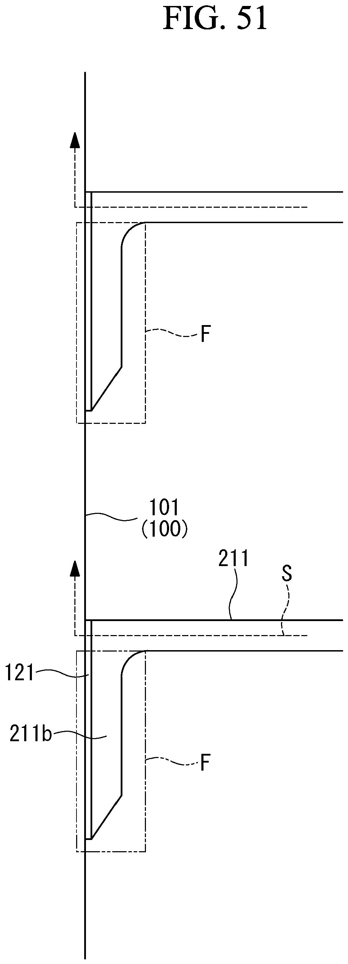

However, as illustrated in Fig. 51, if such routing that causes the signal S to flow opposite to the extending direction of the mount part 211b is taken (has to be taken for a space constraint) in the substrate 100, the major portion of the mount part 211b (for example, the part F indicated in Fig. 51) is a stub. Thus, occurrence of an insertion loss or the like will deteriorate transmission characteristics.

### « Example 3 of Mounting Method (Fixing Method) »

In Example 1 and Example 2, the flanges 416b are used to fix the cage body 410 to the substrate 100.

In contrast, in the present example, press-fit pins 416d (pins) as the fixing part are used instead of the flanges 416b to fix the cage body 410 to the substrate 100.

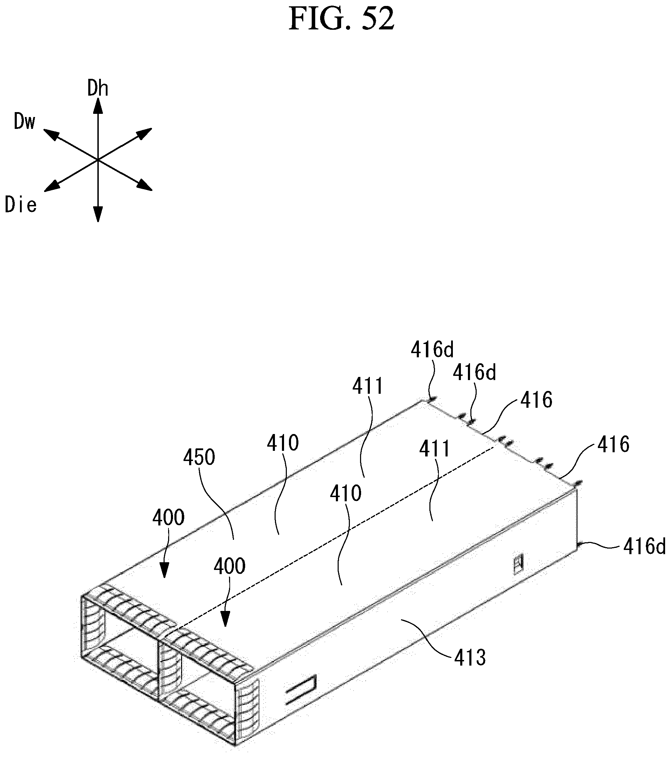

As illustrated in Fig. 52, a plurality of press-fit pins 416d protruding in the insertion-extraction direction Die are provided at the rear end edges 416 of the cage bodies 410.

Specifically, the press-fit pins 416d are provided at the rear end edges 416 formed on the top wall 411 and the bottom wall 412.

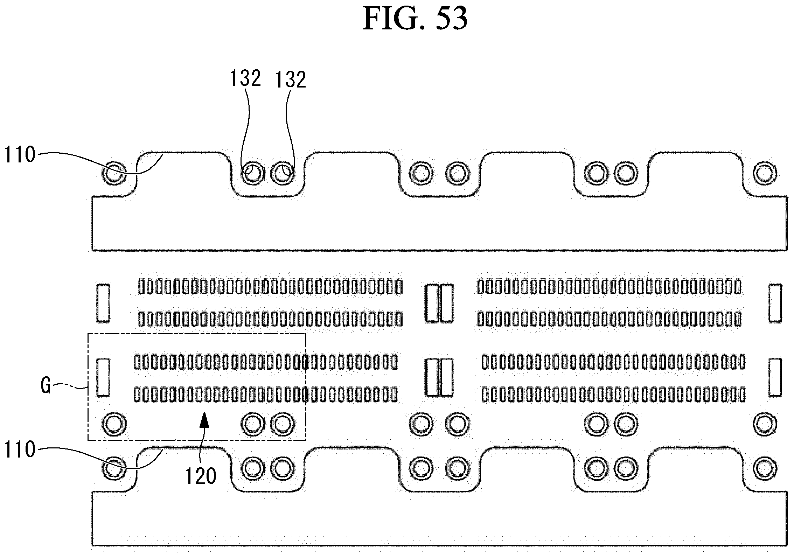

As illustrated in Fig. 53, through holes 132 are formed in the substrate 100. Each through hole 132 is a hole penetrating between the front side 101 and the back side 102 of the substrate 100.

The through hole 132 functions as a hole into which the press-fit pin 416d of the cage body 410 is press-fitted. Thus, the positions of the through holes 132 correspond to the positions of the press-fit pins 416d of the cage body 410.

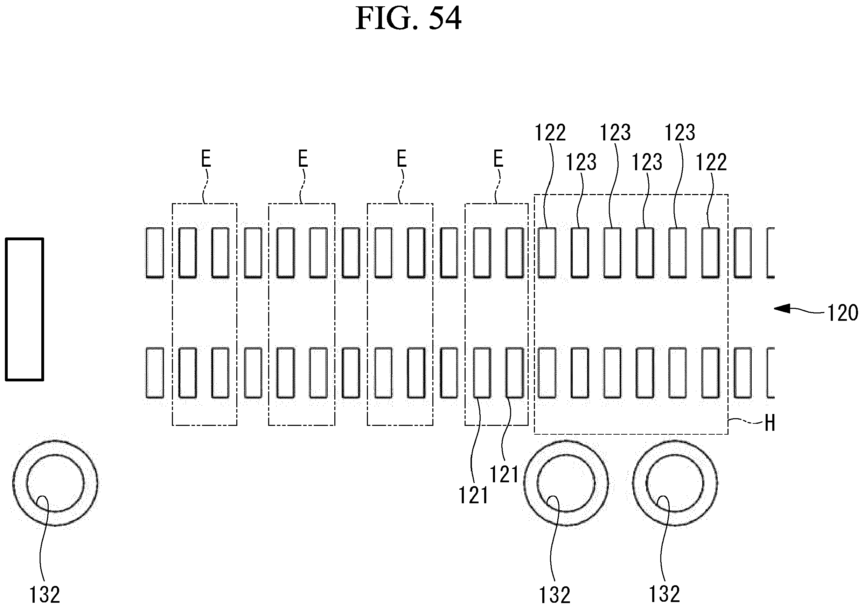

Note that, as illustrated in Fig. 54, it is preferable not to arrange the through hole 132 near the high-speed signaling pad 121. Conversely, it is preferable to arrange the through hole 132 near the electrode pad 120 (a grounding pad 122) used for reference potential connection or an electrode pad 123 used for other purposes. Fig. 54 illustrates a block of the grounding pads 122 and the electrode pads 123 used for other purposes, which is indicated by H (with a dashed line frame). Further, the through holes 132 are arranged near the part indicated by H.

Thus, there is a spatial margin near the high-speed signaling pads 121, and this makes it possible to increase flexibility of wiring (routing) from the high-speed signaling pad 121 in the substrate 100 and obtain good signal transmission performance.

Note that an example of the electrode pad 123 used for other purposes is a pad for SCL, VCC, or LPWn/PRSn.

Further, as illustrated in Fig. 53, a large area of the substrate opening 110 is ensured by arranging a plurality of through holes 132 collectively as much as possible such as arranging them adjacently to each other.

The press-fit pins 416d and the through holes 132 configured as described above are used, and thereby the cage body 410 is fixed to the substrate 100 on which the connector 200 is mounted in advance.

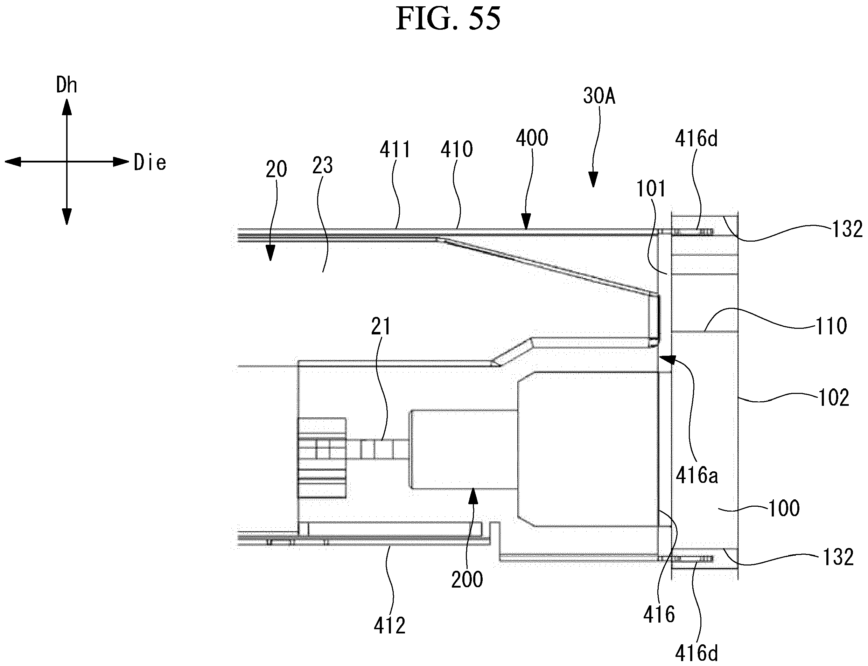

Specifically, as illustrated in Fig. 55, the press-fit pins 416d are press-fitted into the through holes 132, and thereby the cage body 410 is fixed to the substrate 100.

Note that the press-fit pins 416d may be provided on the right wall 413 and the left wall 414 instead of or in addition to the top wall 411 and the bottom wall 412. In such a case, obviously, the positions of the through holes 132 correspond to the positions of the press-fit pins 416d provided on the right wall 413 and the left wall 414.

Further, instead of the press-fit pins 416d, soldering pins may be employed. In such a case, the soldering pins are fixed to the substrate100 by being soldered after inserted through the through holes 132.

### [Second Embodiment]

A receptacle assembly 30B according to a second embodiment of the present invention will be described below.

The receptacle assembly 30B is a device for electrically connecting the pluggable modules 20 to the substrate 100 as described above.

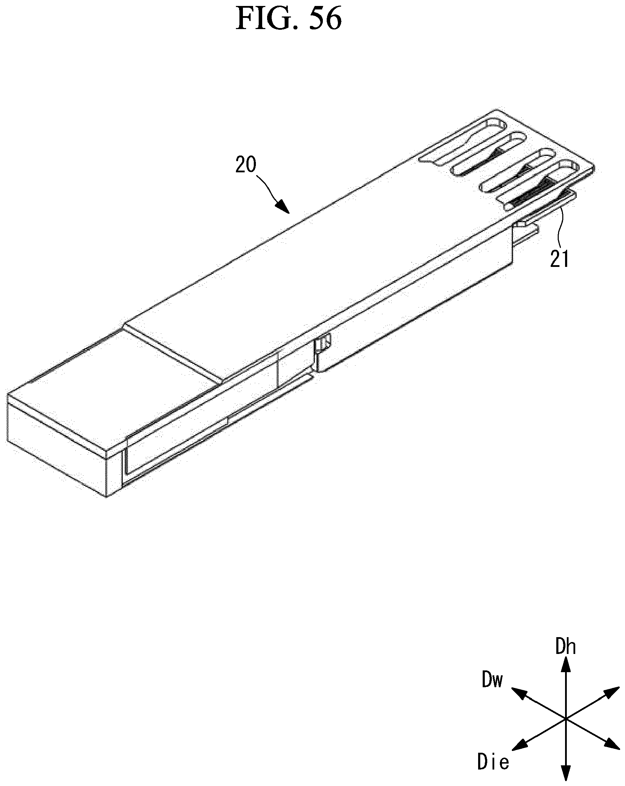

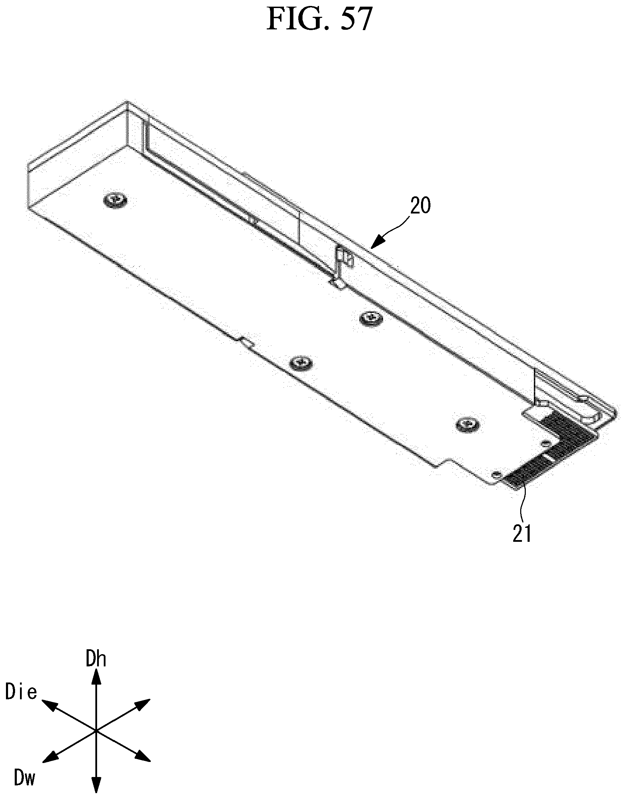

The pluggable module 20 of the present embodiment is an OSFP-XD module of the type having no built-in heat sink, as illustrated in Fig. 56 and Fig. 57.

The receptacle assembly 30B has the connector 200 and the cage 500.

### < Connector >

The connector 200 has the same configuration as that described in the first embodiment. Thus, the connector 200 is a connector associated with an OSFP-XD module.

### < Cage>

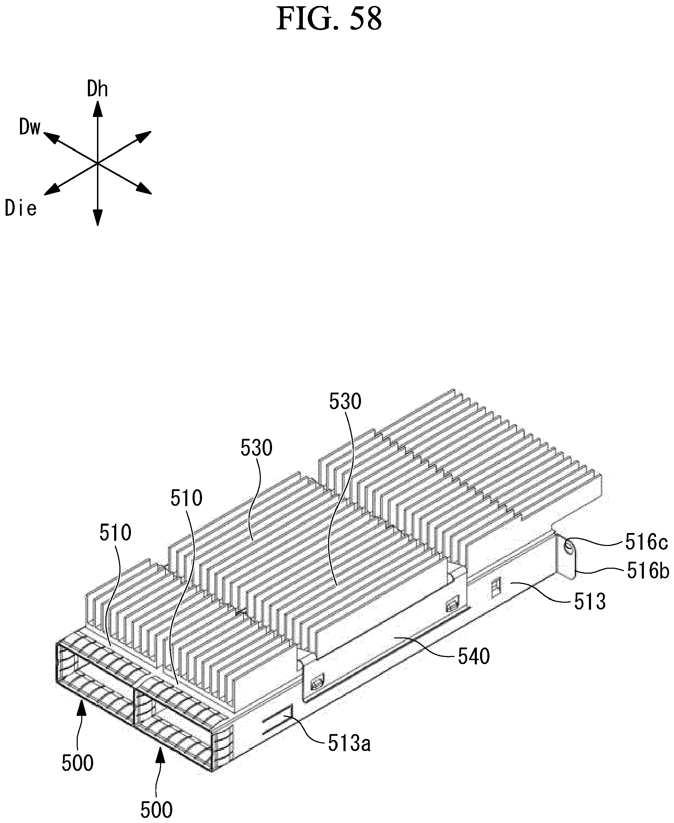

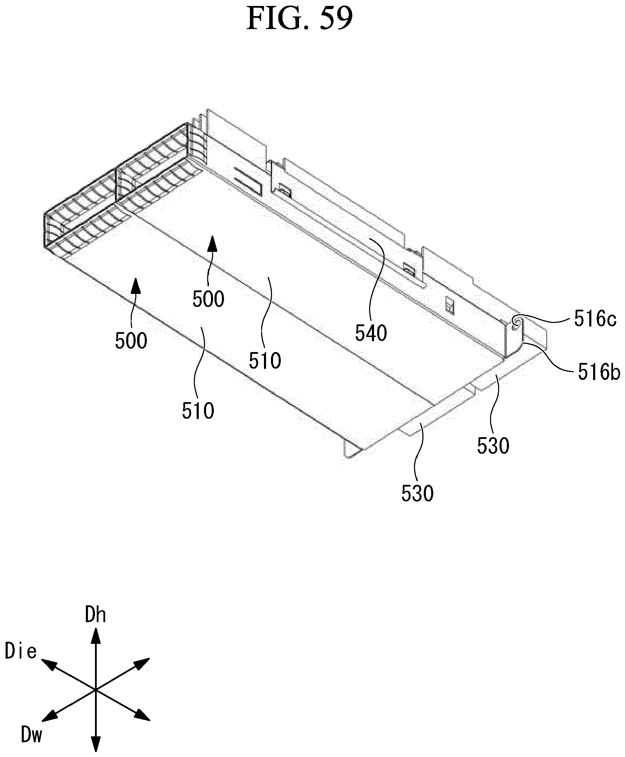

As illustrated in Fig. 58 to Fig. 60, the cage 500 has the cage body 510 and a heat sink 530.

Note that, in each of Fig. 58 to Fig. 60, two cage bodies 510 are adjacent to and preferably connected to each other in the width direction Dw. The details of the double configuration will be described later.

Each cage body 510 is a rectangular cylindrical component extending in the insertion-extraction direction Die and has a top wall 511 and a bottom wall 512 facing each other in the height direction Dh and a right wall 513 and a left wall 514 facing each other in the width direction Dw, and a space (in which the pluggable module 20 is inserted) is defined by these walls.

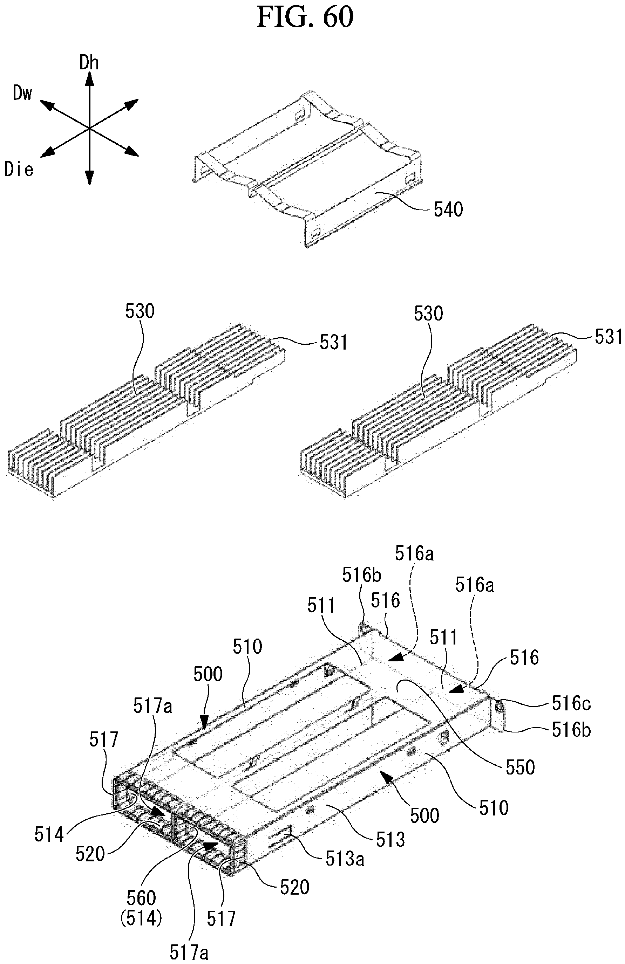

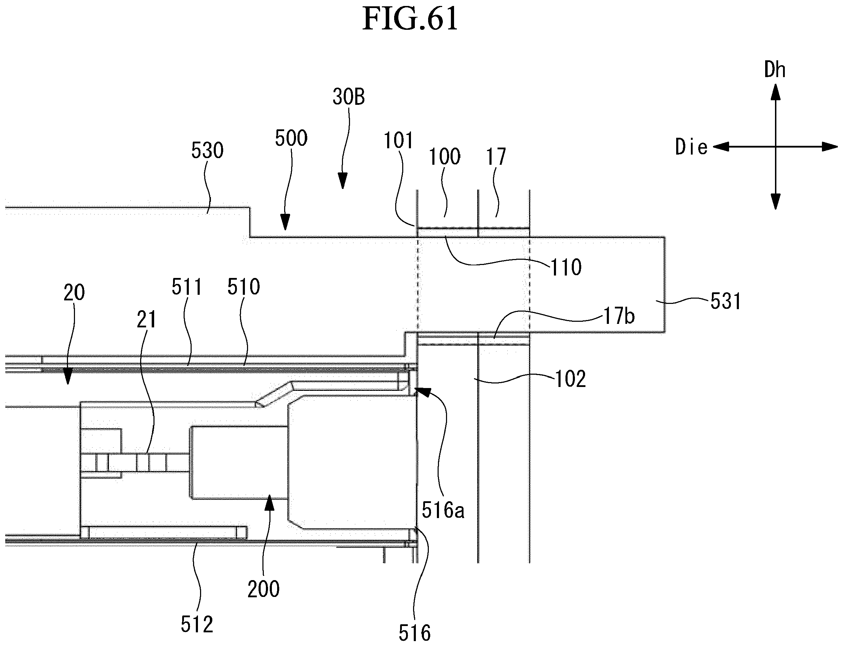

As illustrated in Fig. 60, a rear end edge 516 of the cage body 510 facing the substrate 100 when mounted defines substantially a rectangular rear opening 516a. As illustrated in Fig. 61, when the cage 500 is mounted on the substrate 100, the connector 200 mounted on the substrate 100 is accommodated in the space inside a portion including the rear opening 516a of the cage body 510.

Further, as illustrated in Fig. 60, a front end edge 517 on the opposite side to the rear end edge 516 defines substantially a rectangular front opening 517a. The pluggable module 20 is inserted from the front opening 517a along the insertion-extraction direction Die. A plurality of EMI fingers 520 are provided on respective sides of the front end edge 517.

As illustrated in Fig. 58 and Fig. 60, heat sinks 530 are installed to the outer faces of the top walls 511 of the cage bodies 510.

As illustrated in Fig. 60, two heat sinks 530 are fixed to two cage bodies 510 connected in the width direction Dw by one clip 540.

The heat sink 530 has a structure that comes into contact with at least the top surface of the pluggable module 20 inserted in the cage body 510 via the opening formed in the top wall 511 of the cage body 510 and thereby can dissipate heat from the pluggable module 20.

Grooves along the insertion-extraction direction Die are formed in the heat sink 530, and cooling air flows along these grooves from the front end edge 517 to the rear end edge 516.

The cage bodies 510 of a double configuration will now be described.

The cage bodies 510 of the double configuration correspond to a combination of two cage bodies 510 having a common outer wall.

The cage bodies 510 of the double configuration will be described below in detail with reference to two examples.

### « Example 1 of Cage Body »

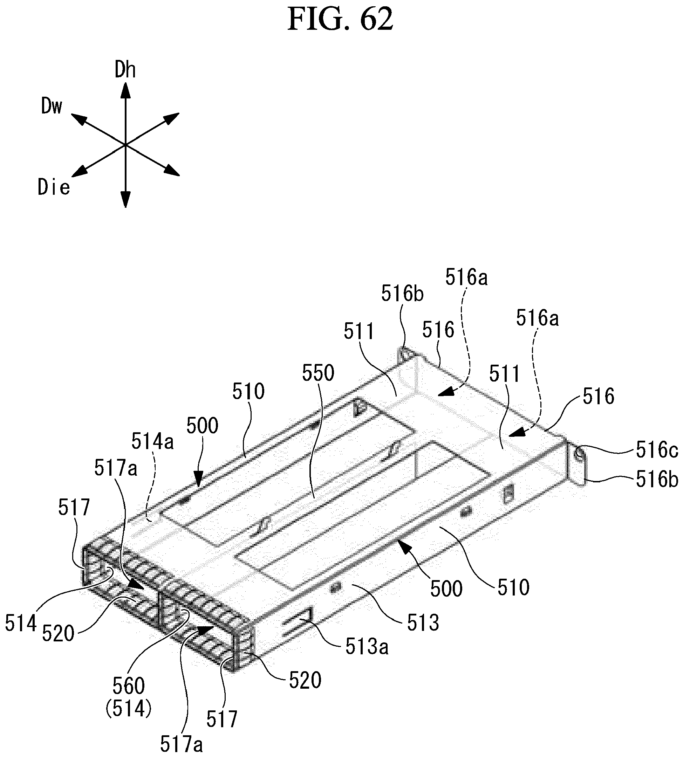

As illustrated in Fig. 62 to Fig. 64, the cage bodies 510 of the double configuration are formed of a double outer cage 550 as the common outer wall and a single partition wall 560.

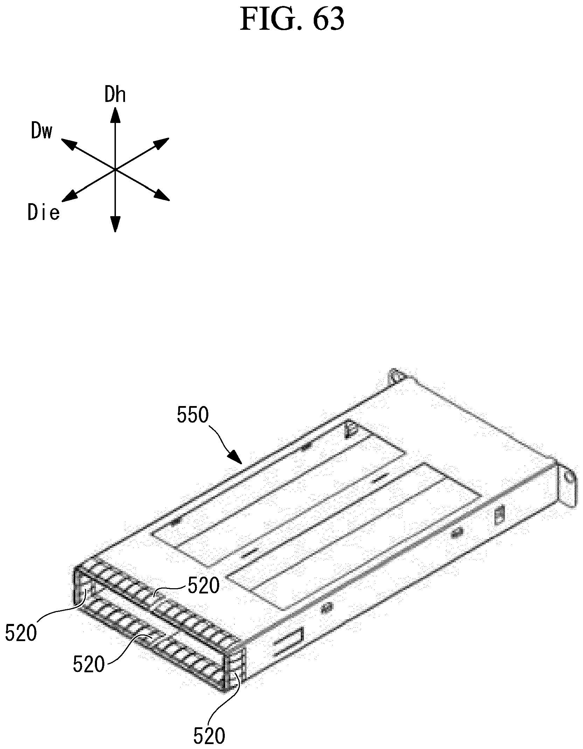

As illustrated in Fig. 63, the double outer cage 550 is a rectangular cylindrical component extending in the insertion-extraction direction Die, which is wider in the width direction Dw. The size of the space defined by the double outer cage 550 is naturally large enough to accommodate a plurality of pluggable modules 20 (in this example, two pluggable modules 20 aligned in the width direction Dw).

The double outer cage 550 is formed of a single plate material punched by a press or the like into a predetermined shape in the same manner as the double outer cage 450 according to Example 1 of the first embodiment, and a plurality of latch claws and a plurality of notches are formed. The latch claws are fitted into corresponding notches and crimped when the plate material is bent into the rectangular cylindrical shape, and thereby a rigidly integrated rectangular cylindrical double outer cage 550 is formed.

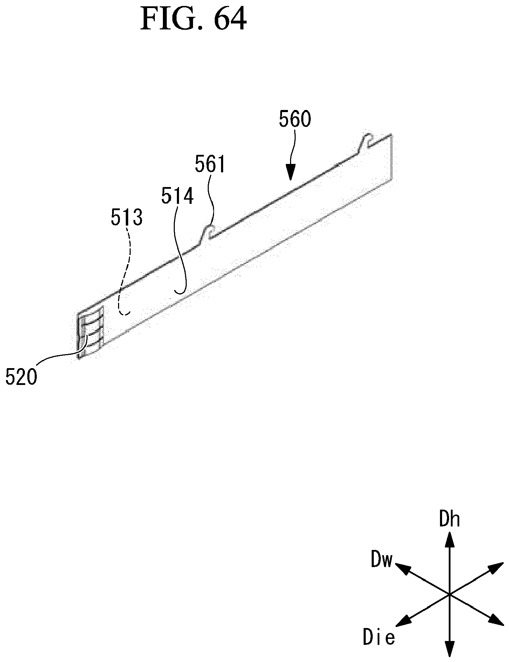

As illustrated in Fig. 64, the partition wall 560 is a plate-like component extending in the insertion-extraction direction Die and erected in the height direction Dh in the same manner as the partition wall 460 of the first embodiment and provided with hooks 561. The partition wall 560 is a component for not only partitioning the space defined by the double outer cage 550 but also serving as a beam to structurally reinforce the double outer cage 550.

The partition wall 560 is arranged at the center in the width direction Dw in the space defined by the double outer cage 550 and divides the space inside the double outer cage 550 into two (equally bisected) in the width direction Dw.

Accordingly, the pair of cage bodies 510 arranged in the width direction Dw are rigidly formed. In this state, the right wall 513 of one cage body 510 and the left wall 514 of the other cage body 510 connected thereto are formed of a common partition wall 560.

### « Example 2 of Case Body »

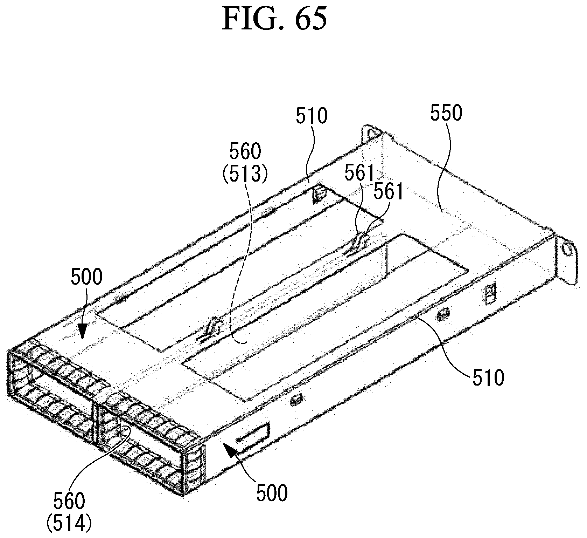

As illustrated in Fig. 65, the cage bodies 510 of the double configuration are formed of the double outer cage 550 and two partition walls 560 in the same manner as the cage bodies 410 of the double configuration according to Example 2 of the first embodiment.

Note that the cage bodies 510 are not necessarily required to have a double configuration and may have a single-body (a single-port) configuration or may have a triple or more-number configuration.

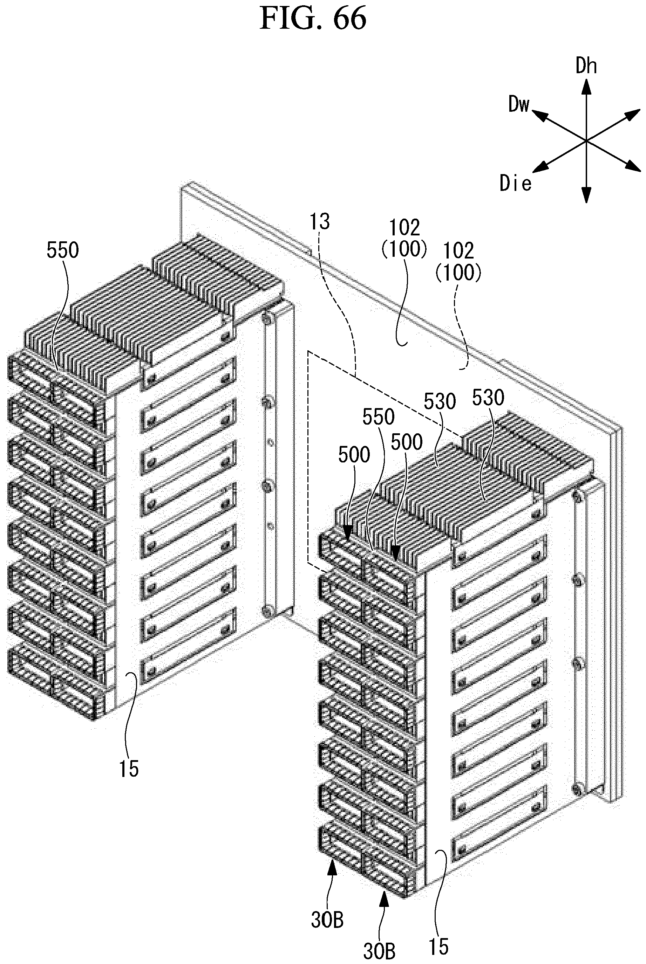

The cage 500 of the double configuration configured as described above is mounted such that the insertion-extraction direction Die of the pluggable module 20 is substantially perpendicular to the front side 101 of the substrate 100, as illustrated in Fig. 66. Thus, the cage 500 is mounted such that the extending direction of the cylindrical cage bodies 510 (double outer cages 550) is substantially perpendicular to the front side 101 of the substrate 100. Further, these cages 500 are mounted along the height direction Dh in regions of the front side 101, which are present on the opposite side to regions located on both sides of the integrated circuit 13 on the back side 102 of the substrate 100, in the same manner as the first embodiment.

The pluggable module 20 is then inserted in the cage body 510 along the insertion-extraction direction Die and thereby guided to the connector 200 mounted on the substrate 100, and the module substrate 21 of the pluggable module 20 is inserted in the connector 200.

Note that the pluggable module 20 is positioned and latched by fixing claws 513a formed on the right wall 513 and fixing claws (not illustrated) formed on the left wall 514 of the cage body 510 in the same manner as the first embodiment. Thus, the amount of insertion of the module substrate 21 into the connector 200 is determined by the positions of the fixing claws 513a and the fixing claws.

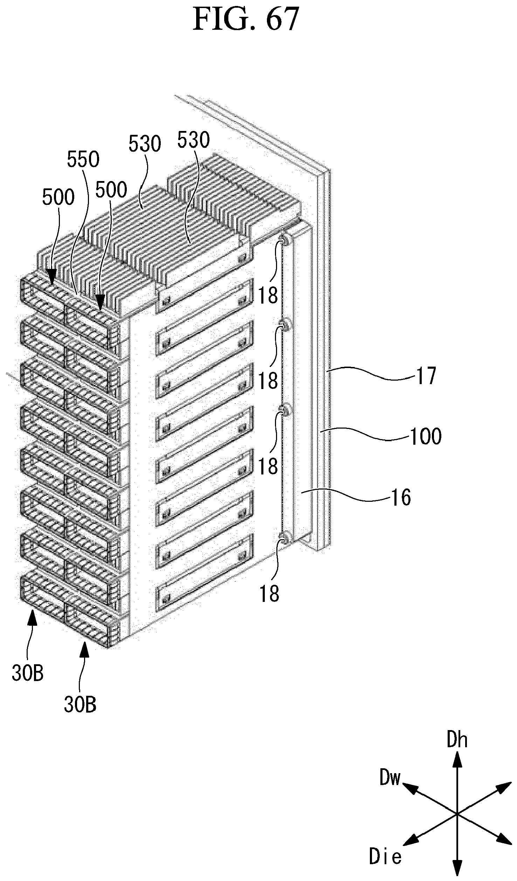

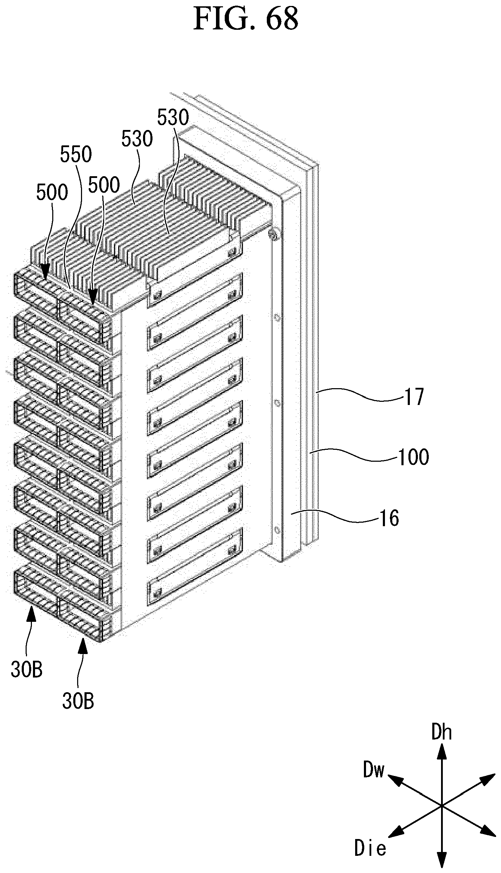

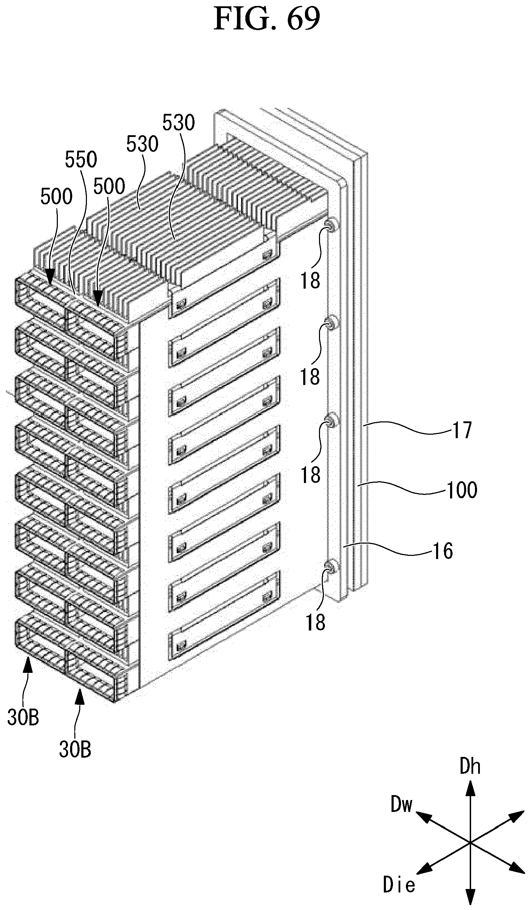

The method of mounting (fixing) the cage 500 on the substrate 100 is the same as that of the first embodiment, as illustrated in Fig. 67 to Fig. 71.

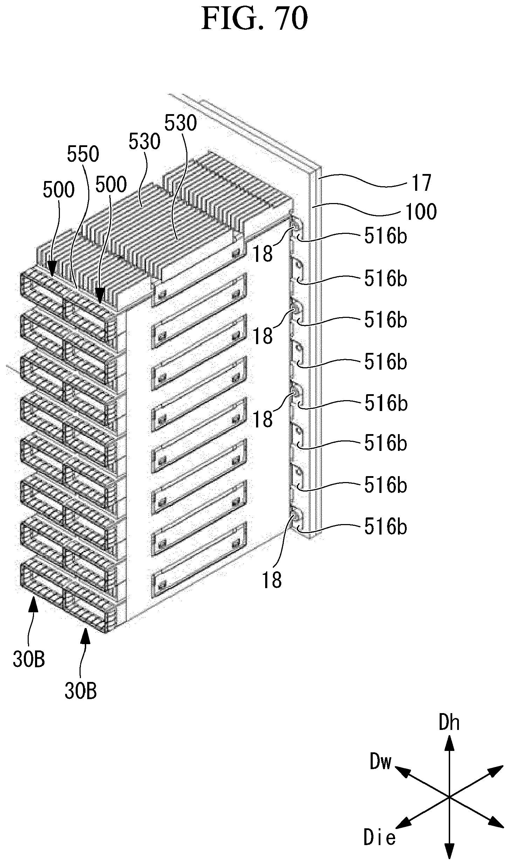

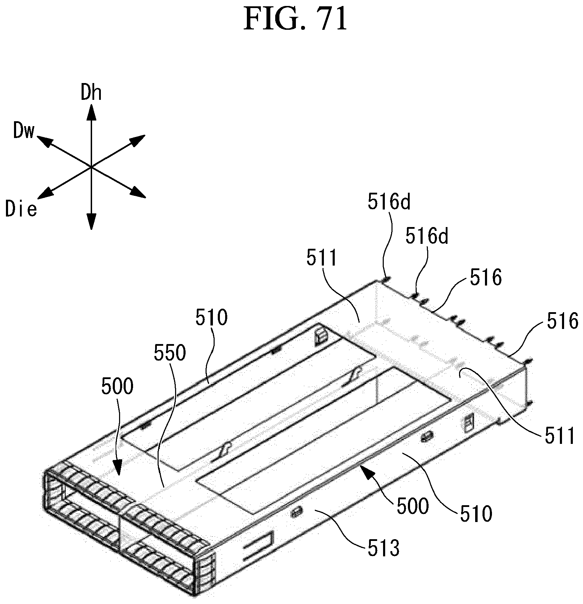

Thus, as illustrated in Fig. 67 to Fig. 69, the cage bodies 510 provided with flanges 516b in which holes 516c are formed (see Fig. 61) and the base plate 16, the back plate 17, and the screws 18 may be used. Further, as illustrated in Fig. 70, the cage bodies 510 provided with flanges 516b in which holes 516c are formed (see Fig. 61) and the back plate 17 and the screws 18 may be used. Further, as illustrated in Fig. 71, press-fit pins 516d or soldering pins provided at the rear end edges 516 of the cage bodies 510 may be used.

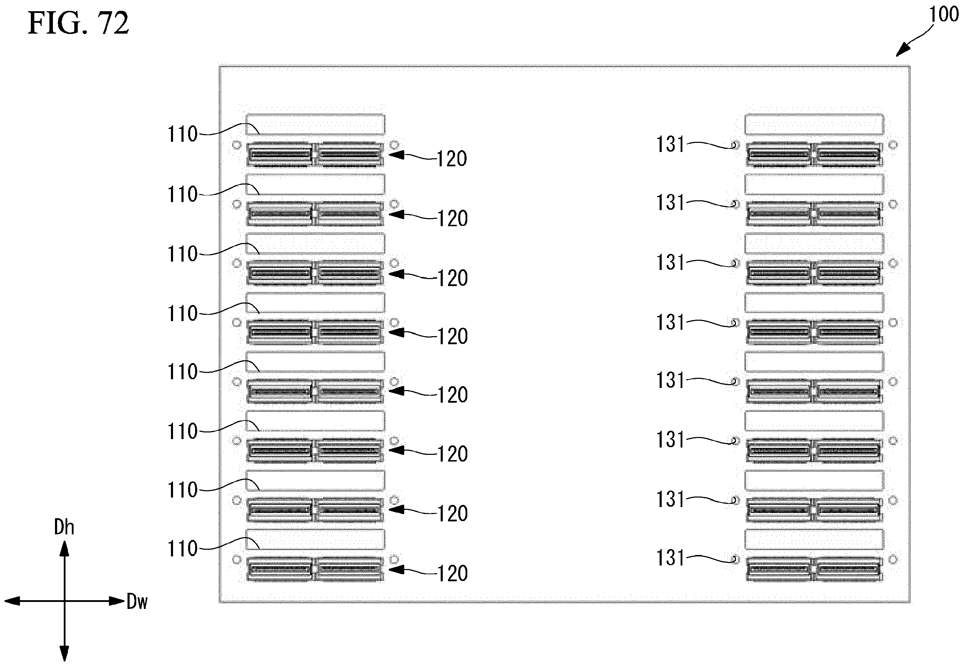

As illustrated in Fig. 72, the substrate 100 on which the cages 500 are mounted has the substrate openings 110.

Each substrate opening 110 is a hole penetrating between the front side 101 and the back side 102 of the substrate 100. The substrate opening 110 is formed above the electrode pad 120 in the height direction Dh.

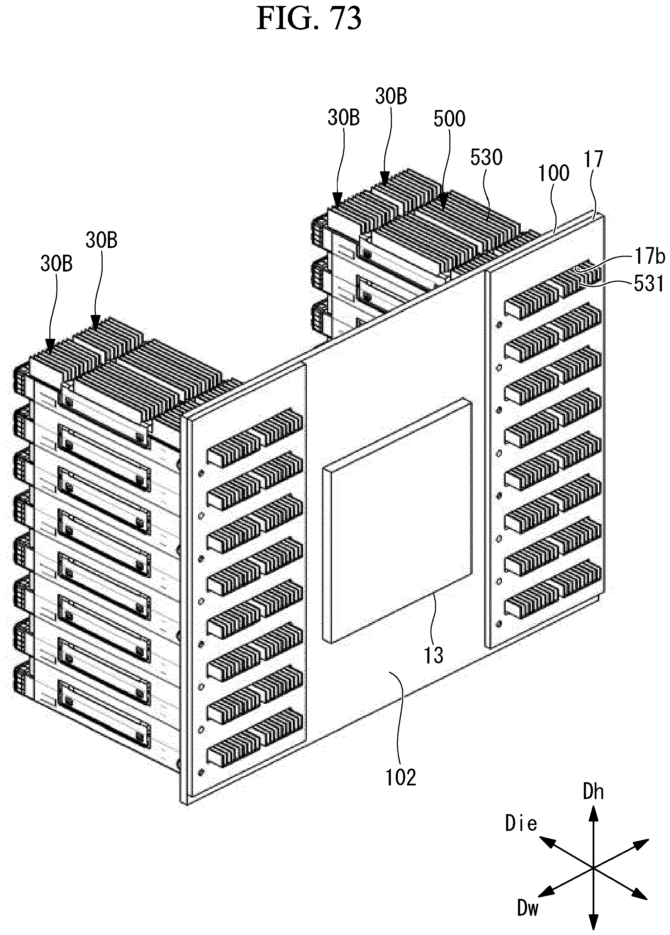

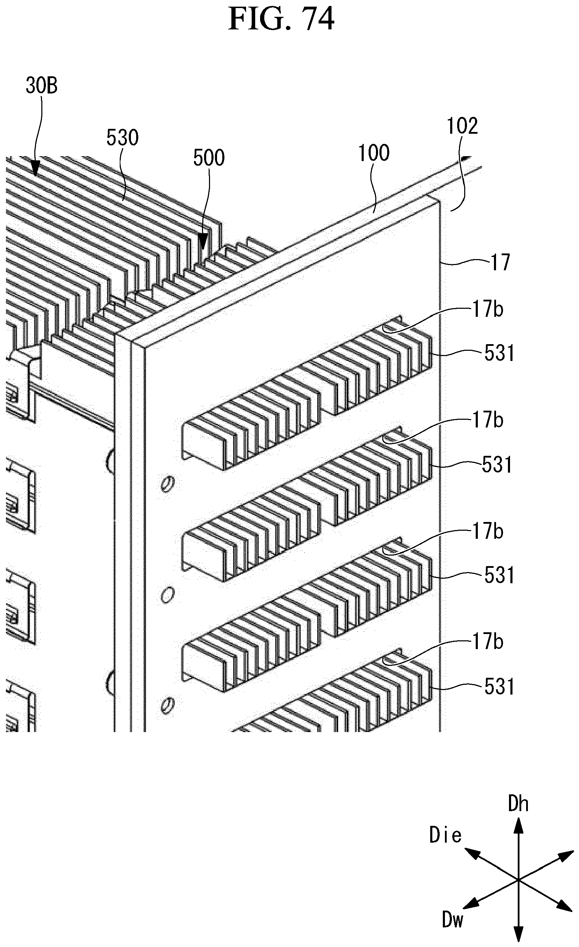

In the present embodiment, as illustrated in Fig. 61, Fig. 73, and Fig. 74, the heat sink 530 of the cage 500 is designed to have a length dimension such that a rear end 531 protrudes out of both the substrate opening 110 formed in the substrate 100 and the back plate opening 17b formed in the back plate 17 when the cage 500 is mounted on the substrate 100.

This allows cooling air flowing along grooves formed in the heat sink 530 (see Fig. 58) to smoothly flow to the back side of the back plate 17.

### < Connecting Panel >

As illustrated in Fig. 66, in the receptacle assembly 30B, a set of cages 500 of the double configuration are mounted on the substrate 100 over multiple levels in the height direction Dh.

In this state, it is preferable that a common connecting panel 15 be attached to the right walls 513 of the cage bodies 510 (double outer cages 550) of the cages 500 aligned in the height direction. The connecting panel 15 is a single plate-like member that connects a plurality of right walls 513 aligned in the height direction to each other.

Further, although not illustrated, it is preferable that a common connecting panel 15 be also attached to the left walls 514 of the cage bodies 510 (double outer cages 550) aligned in the height direction.

By attaching the connecting panel 15, it is possible to rigidly integrate connected bodies of the cages 500 aligned in the height direction Dh. Further, the integration of the cages 500 allows for easier handling than in a case where respective cages 500 are handled individually. Further, compared to a case where respective cages 500 are handled individually, positional accuracy of the cage 500 in the insertion-extraction direction Die can be ensured, and therefore, this leads to smooth insertion and extraction of the pluggable module 20 and can realize improvement on durability of the cage 500 and the pluggable module 20 associated with insertion and extraction thereof.

### < Modified Example of Cage Body >

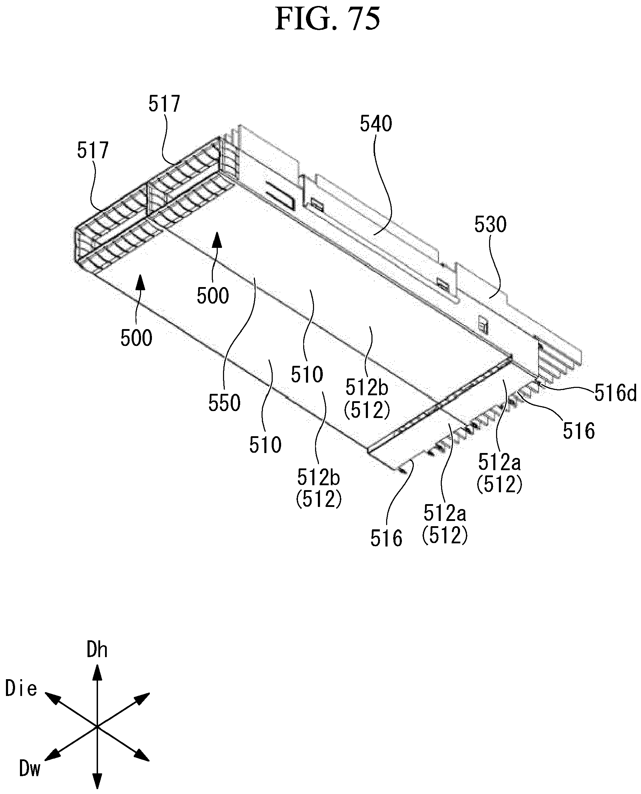

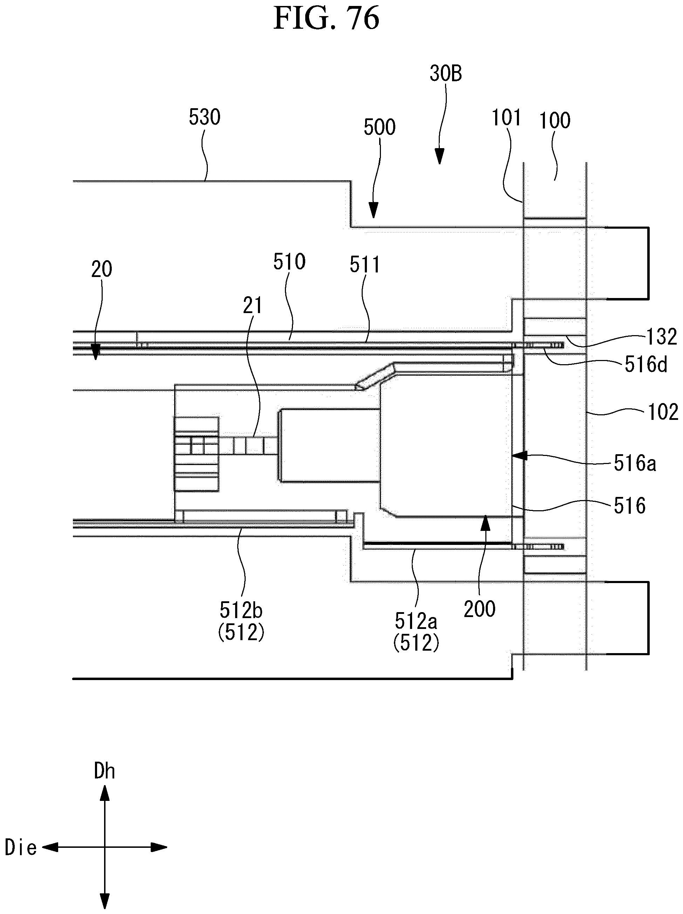

As illustrated in Fig. 75 and Fig. 76, the bottom wall 512 of the cage body 510 is formed of a rear-side bottom wall 512a including the rear end edge 516 and a front-side bottom wall 512b including the front end edge 517, and it is preferable that the rear-side bottom wall 512a be offset from the front-side bottom wall 512b. Specifically, it is preferable that the rear-side bottom wall 512a be offset from the front-side bottom wall 512b so that the dimension in the height direction Dh of the cage body 510 expands.

This configuration is particularly advantageous when using the press-fit pins 516d or the soldering pins to mount the cage 500 on the substrate 100. The reason is as follows.

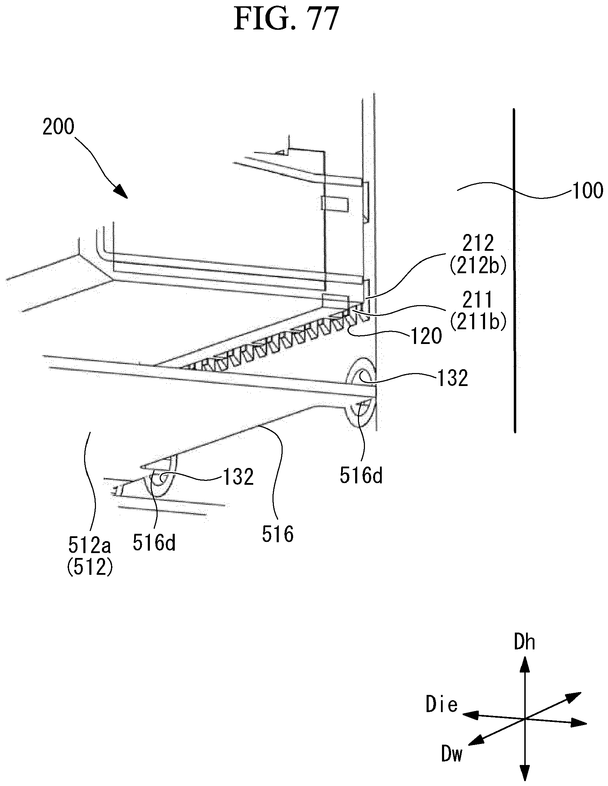

Thus, as illustrated in Fig. 77, because the rear-side bottom wall 512a is offset, the press-fit pins 516d provided on the rear-side bottom wall 512a are shifted downward. Thus, the through holes 132 for inserting the press-fit pins 516d can also be shifted downward. Accordingly, the through holes 132 is spaced apart from the electrode pads 120 on the substrate 100. This can reduce an impact caused by the through holes 132 on signal transmission. Further, a spatial margin is provided, and this enables easy implementation of SMT mounting of a connector. Further, flexibility of wiring (routing) from the electrode pads 120 on the substrate 100 can be increased, and the optimal wiring for high-speed signals can be realized.

### [Third Embodiment]

A receptacle assembly 30C according to a third embodiment of the present invention will be described below.

The receptacle assembly 30C is a device for electrically connecting the pluggable modules 20 to the substrate 100 as described above.

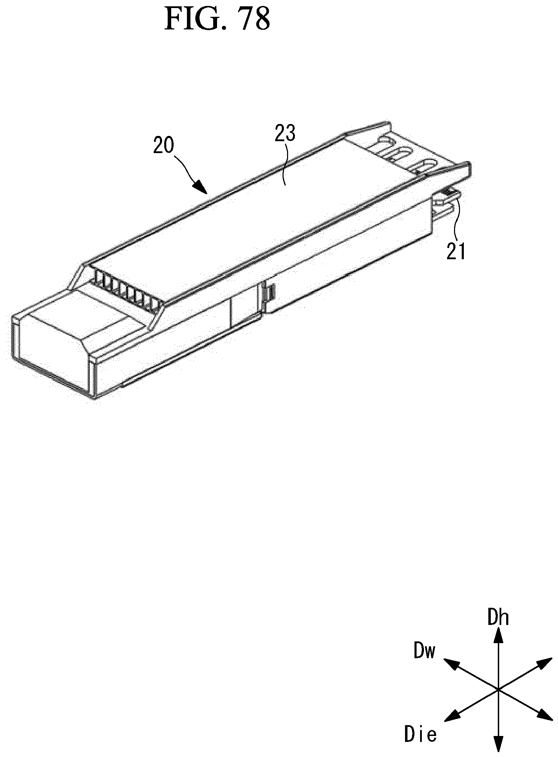

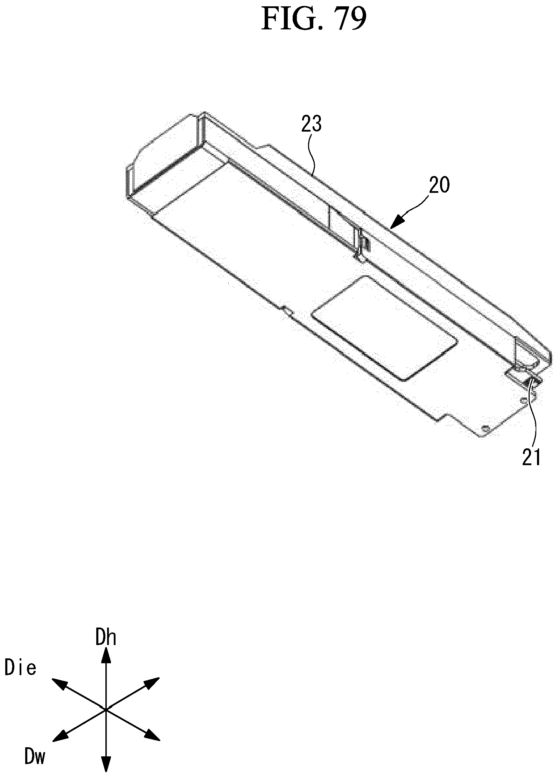

The pluggable module 20 of the present embodiment is an OSFP module of the type having a heat sink (a first heat sink 23) built on the top, as illustrated in Fig. 78 and Fig. 79.

Grooves along the insertion-extraction direction Die are formed in the first heat sink 23 in the same manner as the first embodiment, and cooling air flows along these grooves.

The pluggable module 20 has the module substrate 21. A part of the module substrate 21 protrudes outward from the tip of the casing of the pluggable module 20.

The receptacle assembly 30C has the connector 300 and the cage 400.

### < Connector >

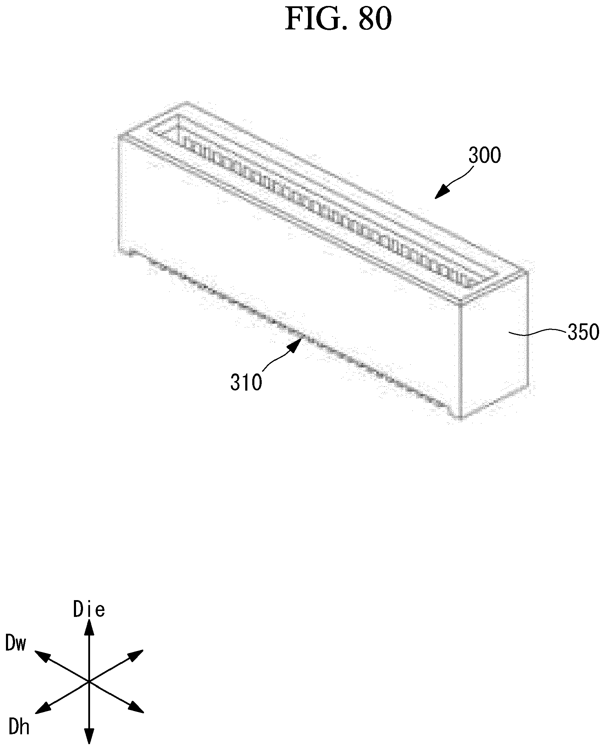

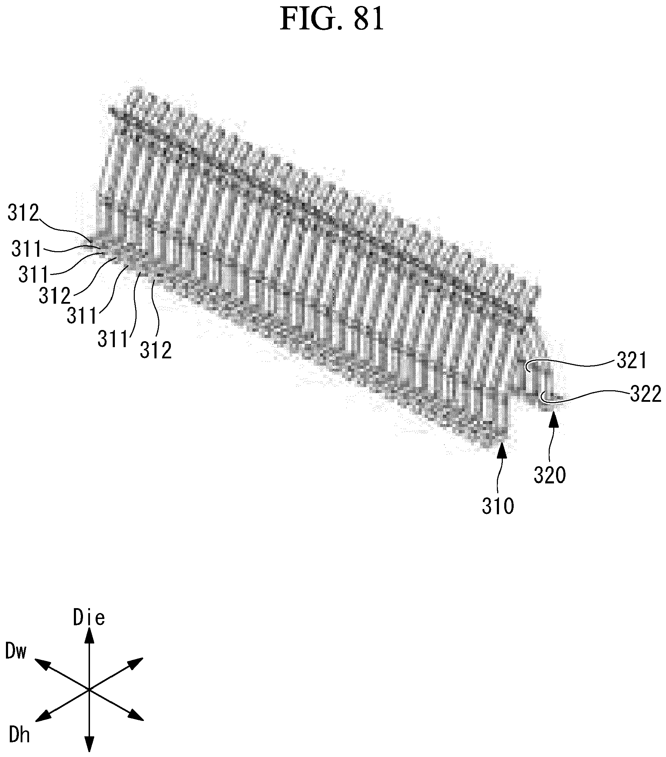

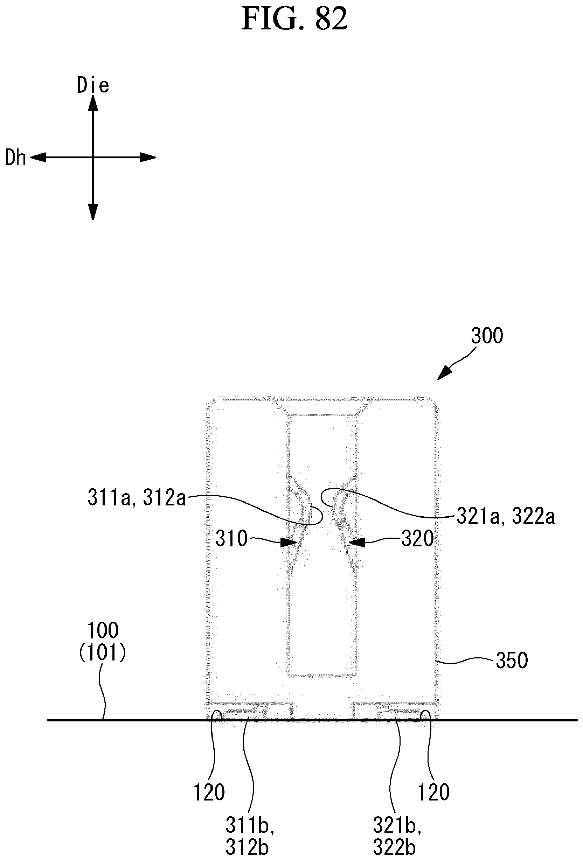

As illustrated in Fig. 80 to Fig. 82, the connector 300 has a first contact pin group 310, a second contact pin group 320, and a housing 350 that accommodates and holds these contact pin groups.

The first contact pin group 310 has multiple types of contact pins for different purposes. For example, the first contact pin group 310 has contact pins used for high-speed signal transmission (signal pins 311), contact pins used for reference potential connection (ground pins 312), contact pins for power supply, and contact pins for low-speed signal transmission.

Each contact pin is an elongated, bent metal component and is aligned along a width direction Dw. Each contact pin is mounted, at its part on the base end side, on the substrate 100 (in detail, an electrode pad 120 formed on the front side 101 of the substrate 100) and is contacted, at its part on the tip side, with the module substrate 21.

The first contact pin group 310 has a section aligned with G-S-S-G-S-S-G-S-S-G-S-S-G, where the signal pin 311 is denoted as "S" and the ground pin 312 is denoted as "G". Thus, there is a section in which a differential pair of signal pins 311 are arranged between a ground pin 312 and another ground pin 312 and arranged adjacent to another differential pair so as to share the ground pin 312.

The second contact pin group 320 is a group paired with the first contact pin group 310 and has multiple types of contact pins for different purposes. For example, the second contact pin group 320 has contact pins for high-speed signal transmission (signal pins 321), contact pins for reference potential connection (ground pins 322), contact pins for power supply, and contact pins for low-speed signal transmission.

Each contact pin is an elongated, bent metal component and is aligned along the width direction Dw. Each contact pin is mounted, at its part on the base end side, on the substrate 100 (in detail, the electrode pad 120 formed on the front side 101 of the substrate 100) and is contacted, at its part on the tip side, with the module substrate 21.

The second contact pin group 320 also has a section aligned with G-S-S-G-S-S-G-S-S-G-S-S-G, where the signal pin 321 is denoted as "S" and the ground pin 322 is denoted as "G". This alignment corresponds to the alignment of respective contact pins of the first contact pin group 310.

Contact point parts 321a, 322a located at tips of respective contact pins of the second contact pin group 320 (contact points contacted with the module substrate 21) face contact point parts 311a, 312a located at tips of respective contact pins of the first contact pin group 310 (contact points contacted with the module substrate 21) in the height direction Dh.

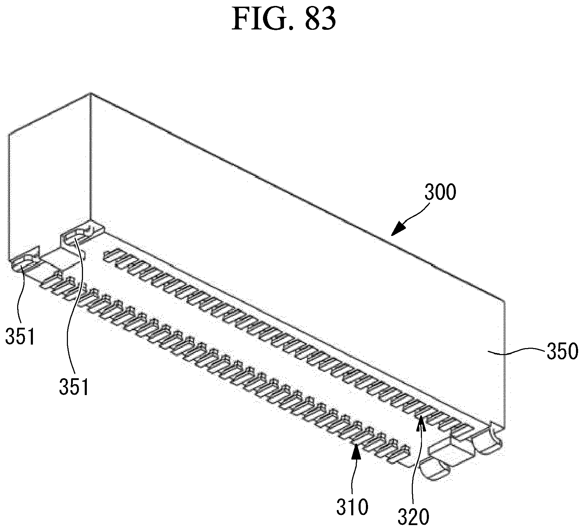

The connector 300 may have a shell similar to the shell 260 of the first embodiment. Further, as illustrated in Fig. 83, the connector 300 may have fixing tabs 351 protruding from a face of the housing 350 (a face facing the substrate 100) instead of the shell.

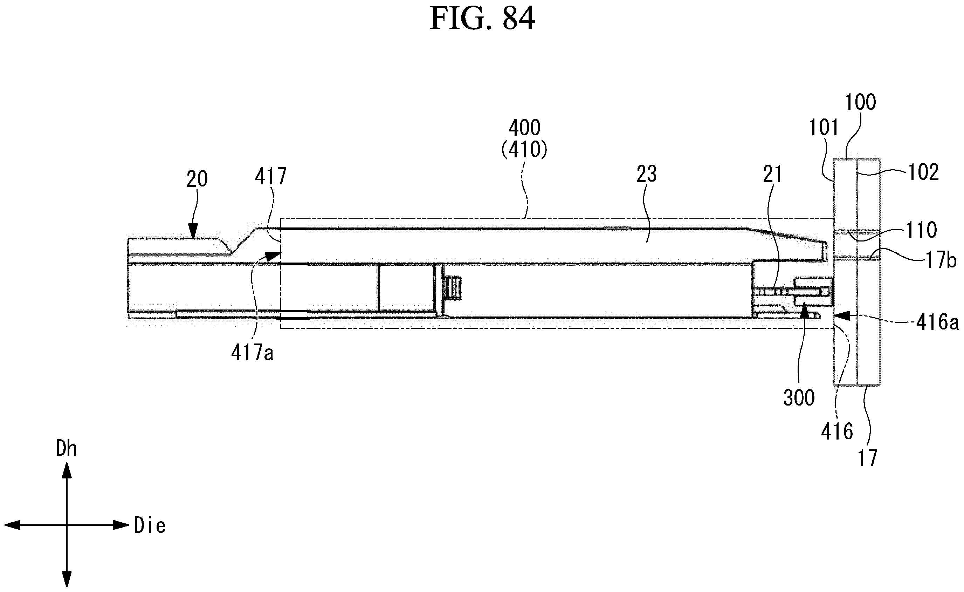

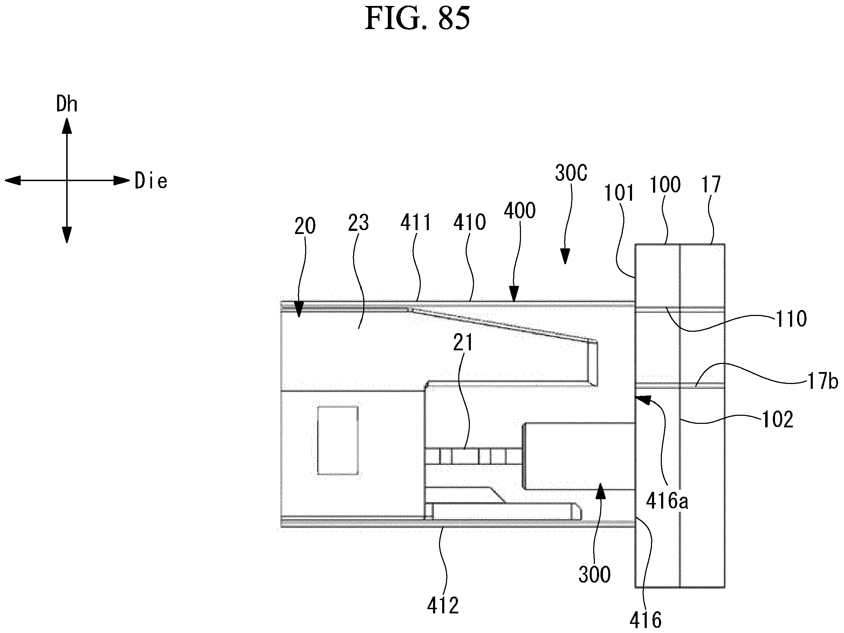

The connector 300 configured as described above is mounted such that the insertion-extraction direction Die of the pluggable module 20 is substantially perpendicular to the front side 101 of the substrate 100, as illustrated in Fig. 84 and Fig. 85. Further, the connectors 300 are mounted along the height direction Dh in regions of the front side 101 that are present on the opposite side to regions located on both sides of the integrated circuit 13 on the back side 102 of the substrate 100 in the same manner as the first embodiment.

The pluggable module 20 is then inserted in the connector 300 along the insertion-extraction direction Die, and thereby the module substrate 21 of the pluggable module 20 is electrically connected to the substrate 100 via contact pins of respective contact pin groups.

Herein, in the connector 300, in the same manner as the connector 200 of the first embodiment, when it is defined that base end parts of the signal pins 311, 321 soldered to the electrode pads 120 of the substrate 100 are mount parts 311b, 321b and that the base end parts of the ground pins 312, 322 soldered to the electrode pads 120 is mount parts 312b, 322b, it is preferable that the pitch of the mount part 312b, 322b and the mount part 311b, 321b be wider than the pitch of a mount part 311b, 321b and another mount part 311b, 321b. This can reduce crosstalk between channels.

### < Cage >

The cage 400 has the same configuration as that of the first embodiment. However, the pluggable module 20 of the present embodiment is the OSFP while the pluggable module 20 of the first embodiment is the OSFP-XD, and there are differences in dimensions, shapes, or the like of respective parts in a strict sense.

Further, the method of mounting (fixing) the cage 400 onto the substrate 100 is also the same as that of the first embodiment.

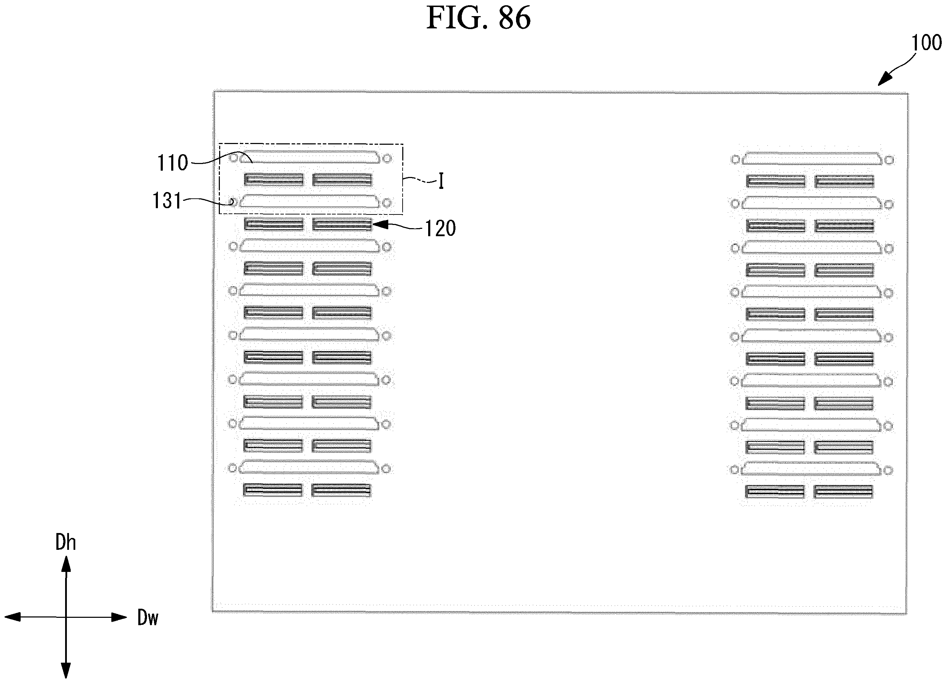

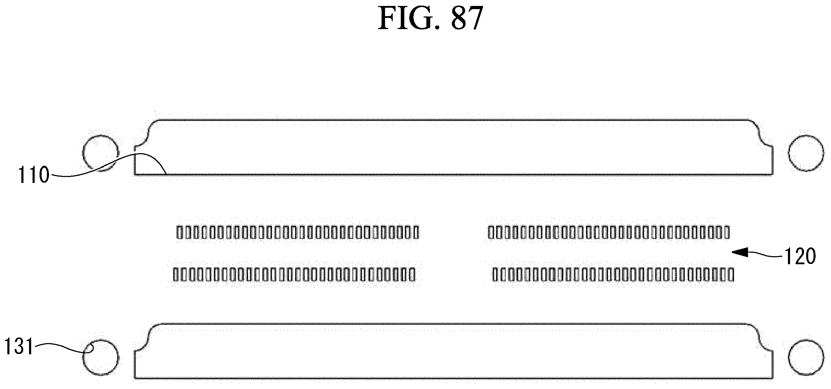

As illustrated in Fig. 86 and Fig. 87, the substrate 100 on which the cages 400 are mounted has the substrate openings 110. In the same manner as the first embodiment, the substrate opening 110 overlaps a region inside the cage body 410 in which the first heat sink 23 of the pluggable module 20 is arranged when viewed in the insertion-extraction direction Die.

However, the arrangement of the electrode pads 120 on the substrate 100 corresponds to the OSFP module. Thus, while a plurality of electrode pads 120 aligned in a line are arranged in four lines in the substrate 100 associated with the connector 200 of the first embodiment, a plurality of electrode pads 120 aligned in a line are arranged in two lines in the substrate 100 associated with the connector 300 of the present embodiment.

Note that the number of lines such as four lines or two lines as used herein is associated with a single receptacle assembly 30. Thus, when eight receptacle assemblies 30 are arranged in the height direction Dh, blocks each including four lines of electrode pads 120 or blocks each including two lines of electrode pads 120 are aligned in eight levels in the height direction Dh.

### < Connecting Panel >

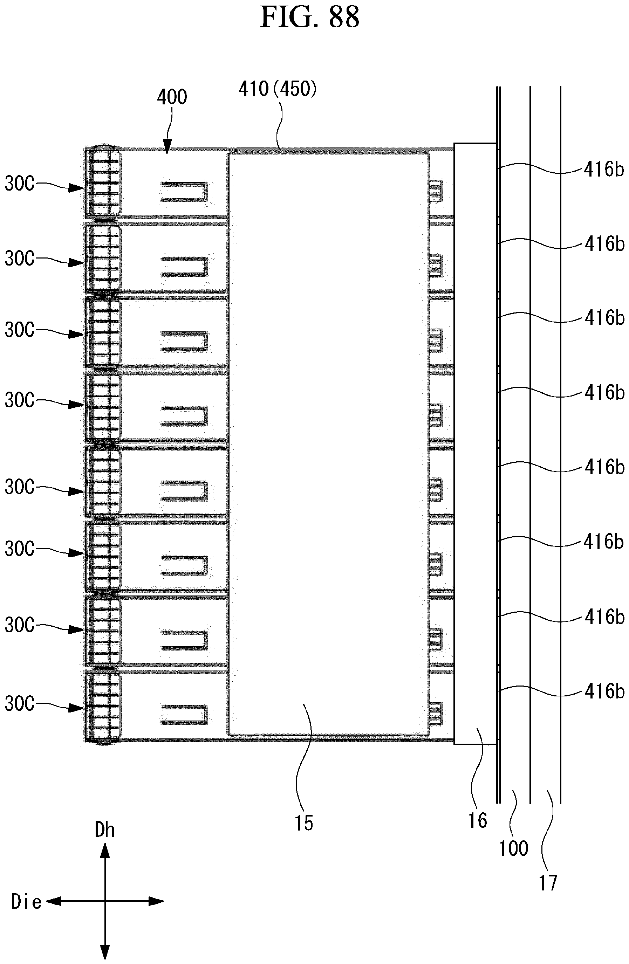

As illustrated in Fig. 88, it is preferable that the connecting panel 15 be attached to the receptacle assemblies 30C in the same manner as the first embodiment.

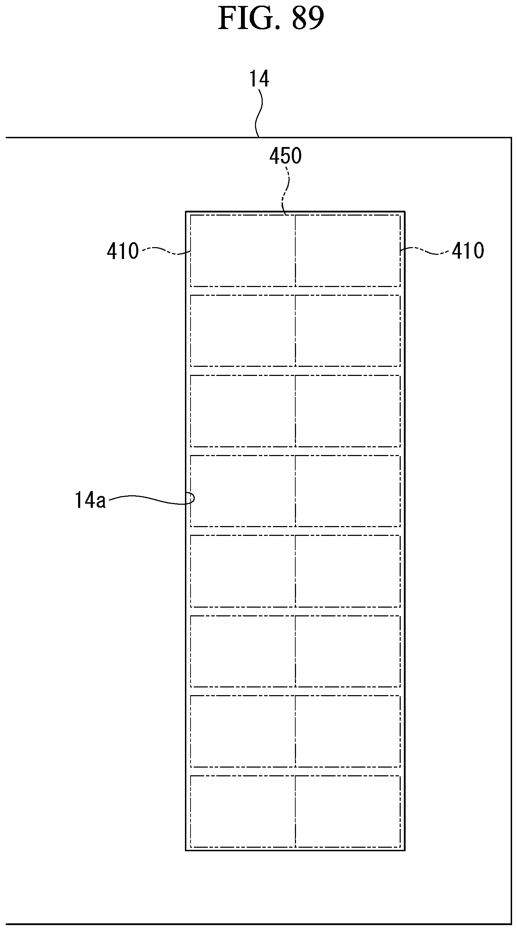

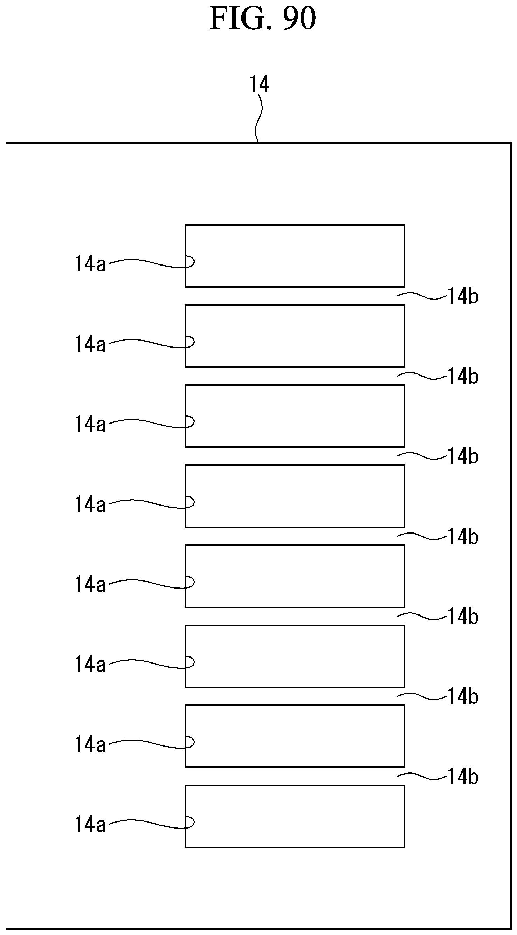

Herein, when the dimension in the height direction Dh of the cage body 410 (double outer cage 450) is substantially the same as the pitch between the cage bodies 410 (double outer cages 450) aligned in the height direction Dh, the panel openings 14a of the front panel 14 illustrated in Fig. 1 are required to be integrated (see Fig. 89). This is because it is not possible to provide a beam part 14b partitioning the panel openings 14a from each other as illustrated in Fig. 90, for example, due to a small clearance between the cage bodies 410 in the height direction Dh.

If the connecting panel 15 were not provided, there would be a likelihood of respective cage bodies 410 being unstable inside the integrated wide panel openings 14a when some external force works on these cage bodies 410. In contrast, with the connecting panel 15 being provided, respective cage bodies 410 (respective double outer cages 450) can be rigidly integrated, and this can reduce the likelihood of these case bodies 410 being unstable inside the panel openings 14a.

In other words, by providing the connecting panel 15, it is possible to integrate the panel openings 14a of the front panel 14, and this makes it possible to easily form the panel openings 14a.

### < Modified Example of Cage Body >

When the pluggable module 20 is an OSFP module of the type having the second heat sink 24 built on the bottom in addition to the first heat sink 23, the vent holes 412c may be formed in the bottom wall 412 of the cage body 410 in the same manner as the first embodiment.

### [Advantageous Effect]

According to respective embodiments described above, the following advantageous effects are achieved.

The connectors 200, 300 and the cages 400, 500 are mounted on the substrate 100 such that the insertion-extraction direction Die is substantially orthogonal to the front side 101 of the substrate 100, and thus a plurality of receptacle assemblies 30 can be arranged (mounted) in a region of the front side 101 corresponding to a region around a portion of the back side 102 of the substrate 100 on which the integrated circuit 13 is mounted. Thus, the distances of patterns from the receptacle assemblies 30 mounted on the front side 101 to the integrated circuit 13 mounted on the back side 102 can be shortened compared to the conventional type. Accordingly, an ultrahigh-speed signal (for example, 200 Gbps or higher) with a short transmittable distance can be suitably transmitted via patterns applied to the substrate 100.

The "conventional type" as used herein refers to those in which a plurality of receptacle assemblies are arranged (mounted) in one direction (one line) or a U-shape so as to be located along the edge end of the substrate so that the insertion-extraction direction is substantially parallel to a face of a substrate, for example.

Further, when the flange 416b, 516b is provided at the rear end edge 416, 516 of the cage body 410, 510, by causing the flange 416b, 516b to come into contact with the substrate 100, it is possible to position the cage body 410, 510 based on the flange 416b, 516b as a reference with respect to the substrate 100. Accordingly, the pluggable module 20 latched to the cage body 410, 510 is also positioned with respect to the substrate 100.

Further, the flanges 416b, 516b can be used to mount (fix) the cages 400, 500 onto the substrate 100.

For example, when the base plate 16 and the back plate 17 are used to mount (fix) the cages 400, 500 onto the substrate 100, these plates are fastened in a state where the flanges 416b, 516b and the substrate 100 are interposed between these plates, and thus the cages 400, 500 can be firmly mounted on (fixed to) the substrate 100 with the flanges 416b, 516b being pressed against the substrate 100.

Further, when the back plate 17 and the flanges 416b, 516b are used to mount (fix) the cages 400, 500 onto the substrate 100, the plate and the flanges are fastened in a state where the substrate 100 is interposed between these plate and flanges, and thus the cages 400, 500 can be firmly mounted on (fixed to) the substrate 100 with the flanges 416b, 516b being pressed against the substrate 100.

Further, when pins such as the press-fit pins 416d or the soldering pins are provided at the rear end edge 416 of the cage body 410, 510, these pins can be used to easily mount (fix) the cage 400, 500 onto the substrate 100.

Further, when spaces defined by the double outer cages 450, 550 and the partition wall 460, 560 function as the cage bodies 410, 510, a plurality of cage bodies 410, 510 having a common outer wall can be collectively formed.

Further, the partition wall 460, 560 can work as a reinforcement material that improves the structural strength of the cage body 410, 510. In particular, when a plurality of partition walls 460, 560 are present, the structural strength can be more improved.

Further, when the receptacle assembly 30 has a connecting panel 15, the cages 400, 500 (double outer cages 450, 550) can be connected to each other by the connecting panel 15. Thus, the connected bodies of the plurality of cages 400, 500 can be rigidly integrated.

Accordingly, for example, even when the panel openings 14a of the front panel 14 in which respective cages 400, 500 are inserted are combined into one piece in terms of a good machining property, respective cages 400, 500 are not unstable inside the panel openings 14a. Further, handling is easier than in a case where respective cages 400, 500 are handled individually.

Further, as with the first embodiment and the third embodiment, at least one vent hole 412c is formed in the bottom wall 412 of the cage body 410. Thus, when the pluggable module 20 has the second heat sink 24, air flowing along the second heat sink 24 is allowed to flow to outside of the cage body 410 via the vent hole 412c.

Further, when each of the contact pin groups 210, 220, 230, 240, 310, 320 has a predetermined portion in which two adjacent signal pins 211, 221, 231, 241, 311, 321 (differential pairs) are arranged between two ground pins 212, 222, 232, 242, 312, 322 and, in the predetermined portion, the pitch between the ground pin 212, 222, 232, 242, 312, 322 and the signal pin 211, 221, 231, 241, 311, 321 is wider than the pitch between a signal pin 211, 221, 231, 241, 311, 321 and another signal pin 211, 221, 231, 241, 311, 321, crosstalk occurring between a first differential pair and a second differential pair that are adjacent to each other interposing the common ground pin 212, 222, 232, 242, 312, 322 can be reduced. Thus, crosstalk between channels can be reduced.

Further, when the connector 200 has the shell 260 covering the housing 250, the fixing tab 262 is provided at the end edge 261 of the shell 260, and the width dimension of the fixing tab 262 is larger than the width dimension of a contact pin, it is possible to more firmly mount the connector 200 on the substrate 100 by using the fixing tab 262 to solder the shell 260 to the substrate 100. This can reduce a likelihood of damage being caused in a mount portion of the connector 200 when the pluggable module 20 is inserted or extracted. The same applies to the connector 300.

Further, when the connector 200 has the fixing tab 262 and has a larger width dimension of the fixing tab 262 than the width dimension of a contact pin, it is possible to more firmly mount the connector 200 on the substrate 100 by using the fixing tab 262 to solder the shell 260 to the substrate 100. This can reduce a likelihood of damage being caused in a mount portion of the connector 200 when the pluggable module 20 is inserted or extracted. The same applies to the connector 300.

### [Modified Example 1]

As the pluggable module 20, an OSFP module of the type having no built-in heat sink (a module associated with the connector 300) may be employed, and the cage 500 having a heat sink 530 may be employed.

### [Modified Example 2]

Although the receptacle assemblies 30 according to the embodiment described above is mounted on the substrate 100 as a set in which the width direction Dw by the height direction Dh is 2 x 8, the number thereof is not particularly limited. For example, a set of receptacle assemblies 30 of 2 x 4 may be employed.

### [Modified Example 3]

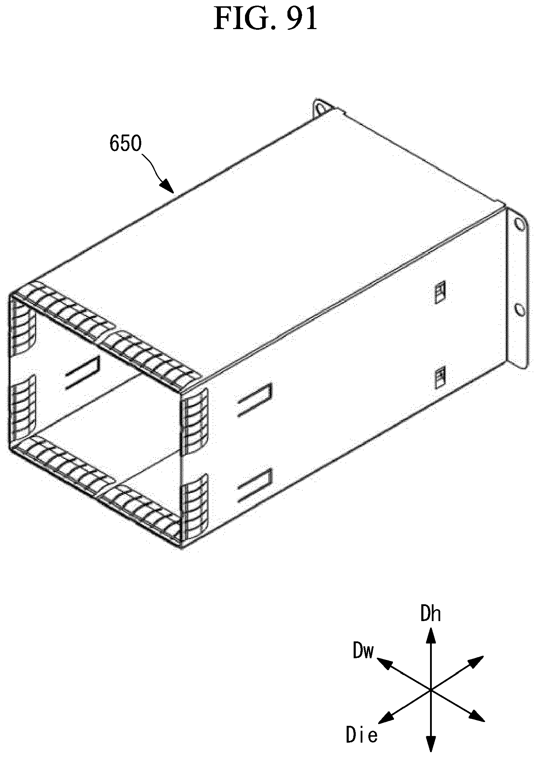

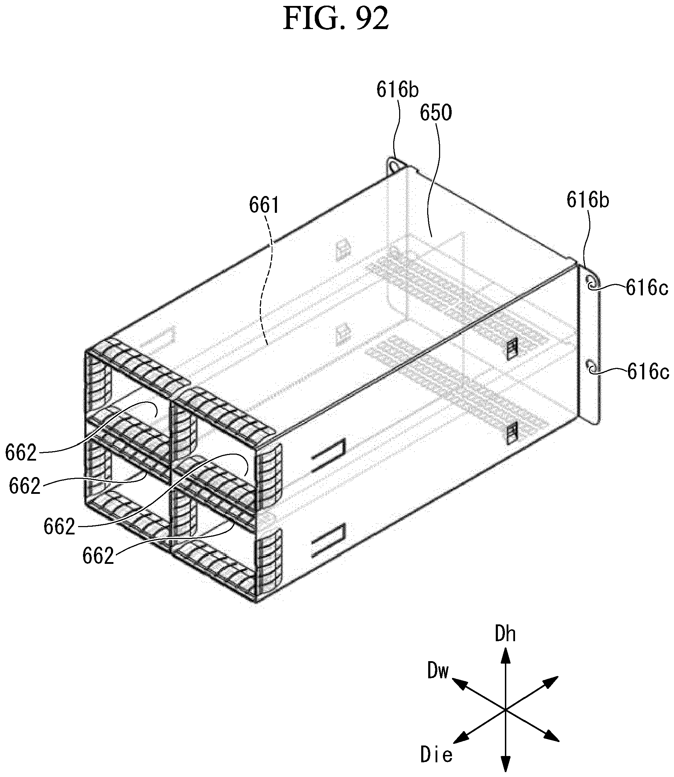

Instead of the double outer cage 450, 550 of 2 x 1, a quadruple outer cage 650 of 2 x 2 may be used, as illustrated in Fig. 91 and Fig. 92.

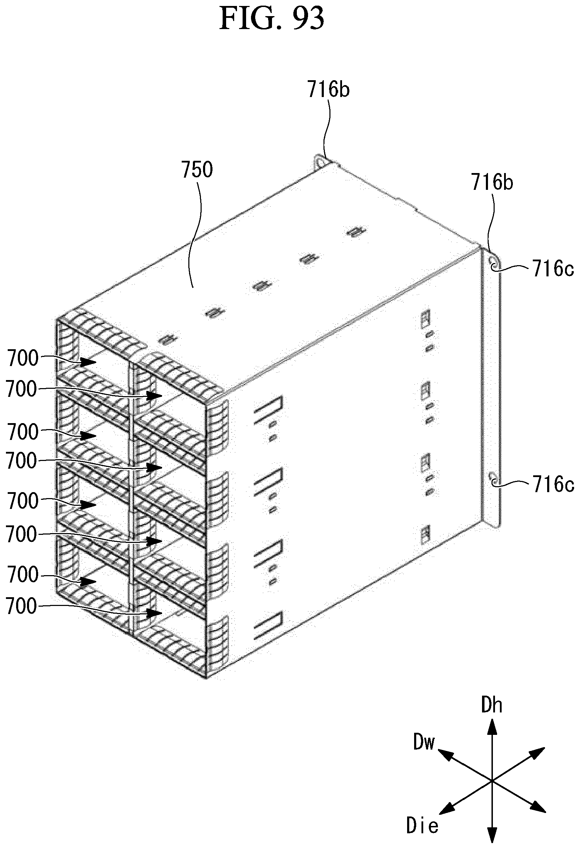

In such a case, the space inside the quadruple outer cage 650 is divided into four in the width direction Dw and the height direction Dh by one vertical partition wall 661 and four horizontal partition walls 662, for example. Further, each divided space corresponds to a space defined by each cage body (the space in which the pluggable module 20 is inserted). It is also possible to employ a sextuple outer cage of 2 x 3 or an octuple outer cage 750 of 2 x 4 (Fig. 93).

To employ a configuration of 2 x n (n is a natural number greater than or equal to 2) such as the quadruple outer cage 650 illustrated in Fig. 92 or the octuple outer cage 750 illustrated in Fig. 93, flanges 616b or flanges 716b may be formed continuously in the height direction Dh (flange integrated type) as illustrated in Fig. 92 or Fig. 93.

Further, to employ a configuration of 2 x m (m is a natural number greater than or equal to 3), it is not required to provide holes at positions corresponding to all the levels in the flanges formed continuously in the height direction Dh.

For example, in the octuple outer cage 750 illustrated in Fig. 93, it is only required to provide holes 716c in the flanges 716b corresponding to the positions of the first and fourth cages 700 from the top (four positions in total). Even in such a case, the cages 700 corresponding to the second and third from the top are integrated with the cages 700 corresponding to the first and fourth from the top and are thus not required to be separately positioned or fixed.

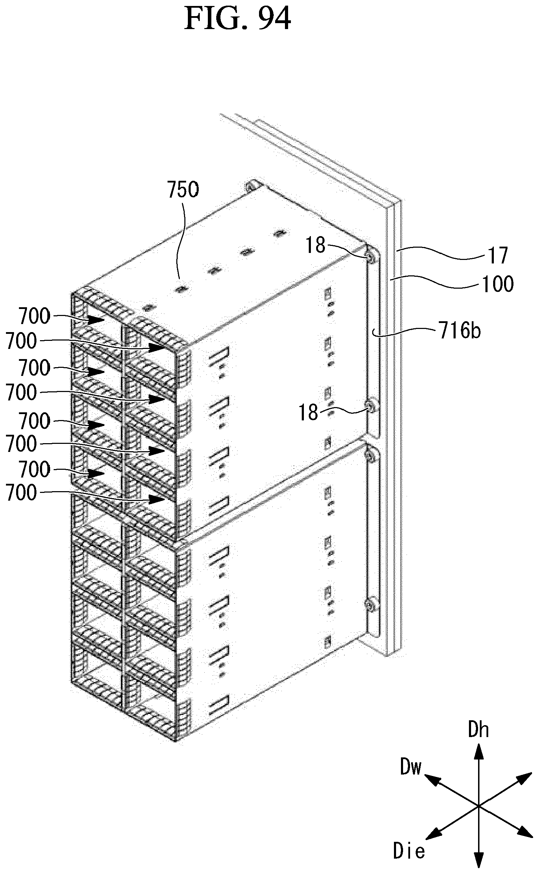

Thus, as illustrated in Fig. 94, when the octuple outer cage 750 is employed, and if the first and fourth cages 700 are fixed to the substrate 100, the second and third cages 700 will be automatically positioned and fixed to the substrate 100.

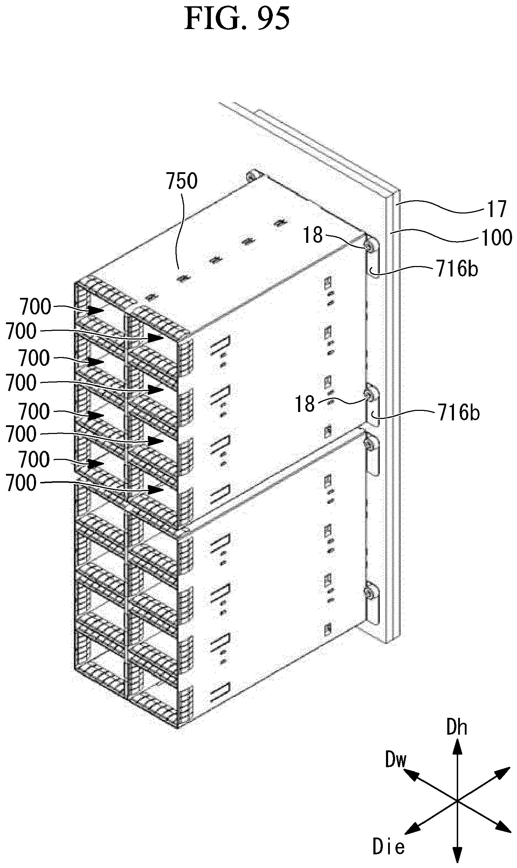

Note that the flange 716b may be formed by being divided in the height direction Dh (that is, a flange divided type) as illustrated in Fig. 95.

In the octuple outer cage 750 illustrated in Fig. 95, only the positions corresponding to the first and fourth cages 700 from the top (four positions in total) may be provided with the flanges 716b in which the holes 716c are formed. Even in such a case, the cages 700 corresponding to the second and third from the top are integrated with the cages 700 corresponding to the first and fourth from the top and are thus not required to be separately positioned or fixed.

Further, compared to the flanges 716b formed continuously in the height direction Dh (Fig. 93 and Fig. 94), the dimension in the height direction Dh per one flange 716b is smaller, and this makes the bending work easier.

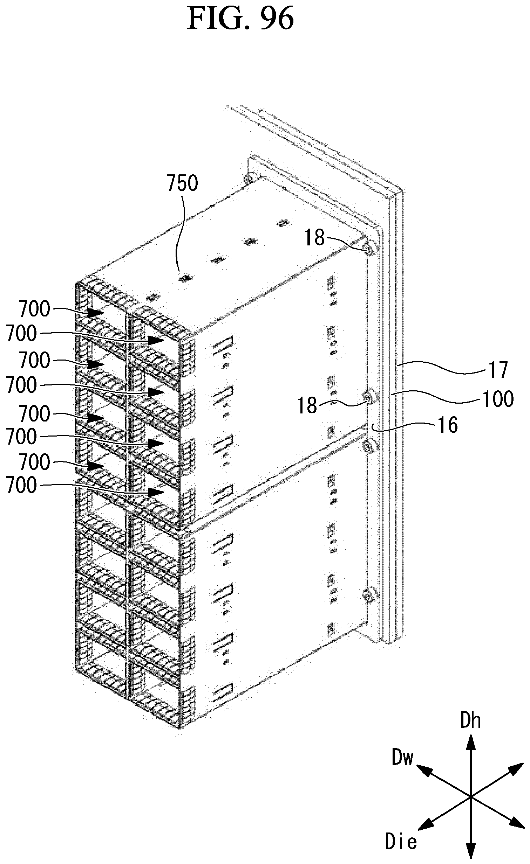

Note that, although fixed to the substrate 100 without using the base plate 16 in Fig. 94 and Fig. 95, the octuple outer cage 750 may be fixed to the substrate 100 by using the base plate 16, as illustrated in Fig. 96.

### [Modified Example 4]

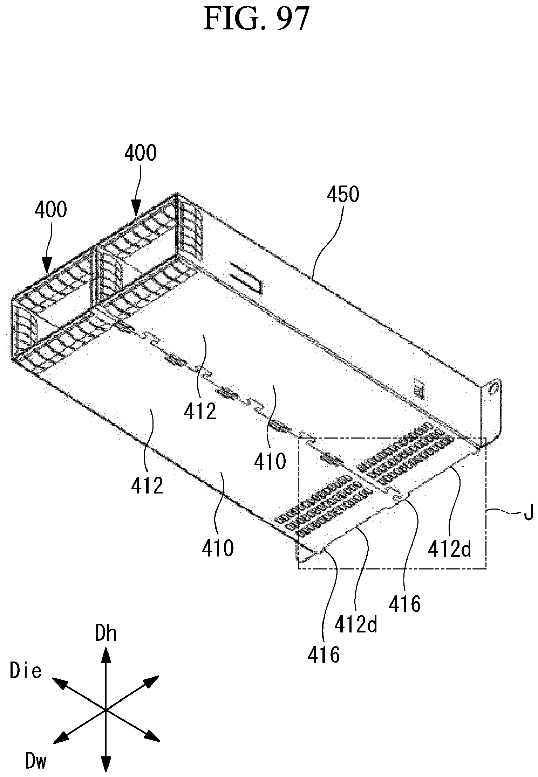

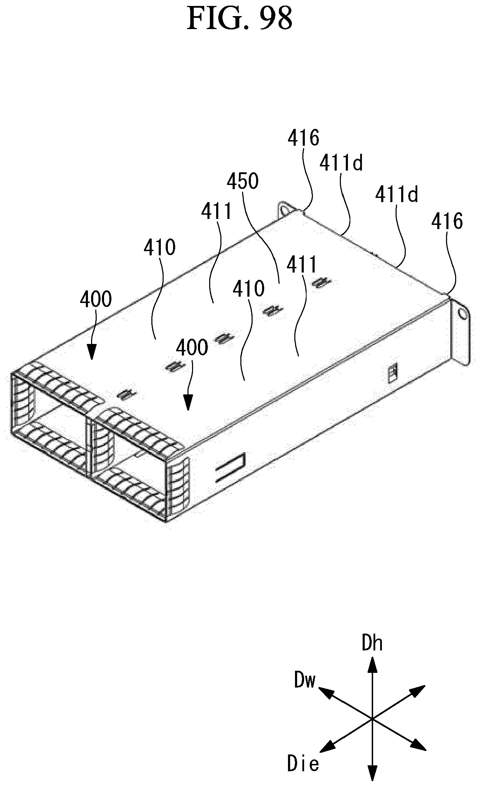

As illustrated in Fig. 97 and Fig. 98, an undercut part 412d may be provided in the rear end edge 416 corresponding to the bottom wall 412 of the cage body 410, and an undercut part 411d may be provided in the rear end edge 416 corresponding to the top wall 411.

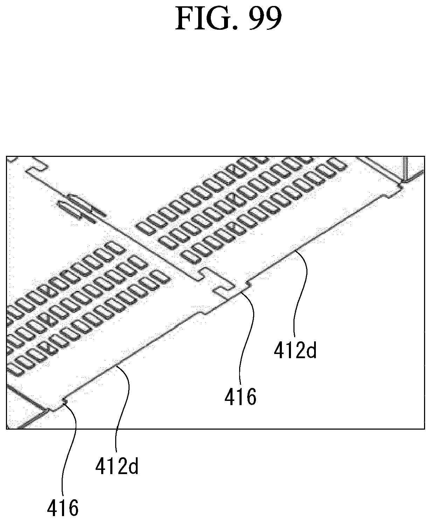

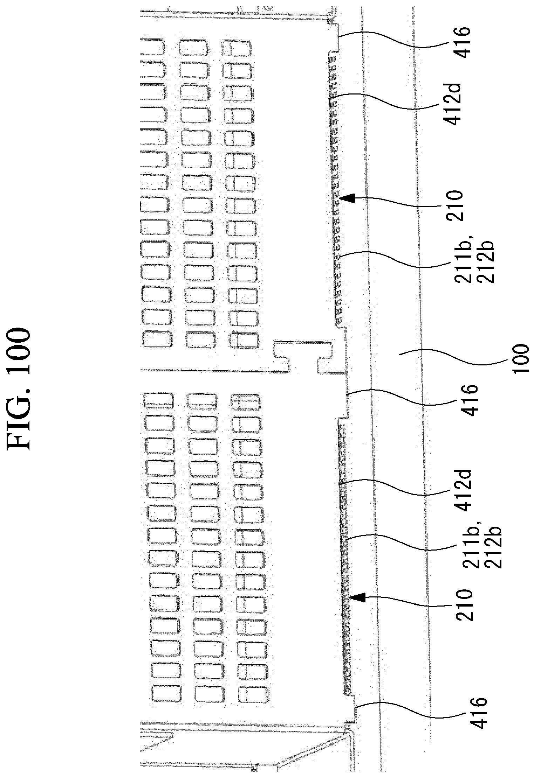

When description is provided with the undercut part 412d as an example, the undercut part 412d is a portion recessed (a portion cut out) so that the rear end edge 416 is spaced apart from the substrate 100, as illustrated in Fig. 99 and Fig. 100.

As illustrated in Fig. 100, because the undercut part 412d is provided, the rear end edge 416 is spaced apart from the front side 101 of the substrate 100. This can reduce crosstalk occurring between channels. Further, wirings can be protected.

Note that, in view of the effect of reducing crosstalk, the recess amount of the undercut part 412d (that is, the dimension of the clearance between the substrate 100 and the rear end edge 416) is 0.3 mm or larger, preferably, 0.5 mm or larger.

Further, to reduce crosstalk for all the channels, it is preferable that the width dimension of the undercut part 412d be larger than at least the width dimension of the first contact pin group 210.

Note that the configuration of the undercut parts 411d, 412d can be applied not only to the cage body 410 but also to the cage body 510.

### [Fourth Embodiment]

In the first embodiment to the third embodiment, the fixing flanges are provided on the cage bodies 410 (double outer cage 450), the cage bodies 510 (double outer cage 550), the quadruple outer cage 650, and the octuple outer cage 750 except for some examples or modified examples. In the present embodiment, however, no flange is provided on these outer cages.

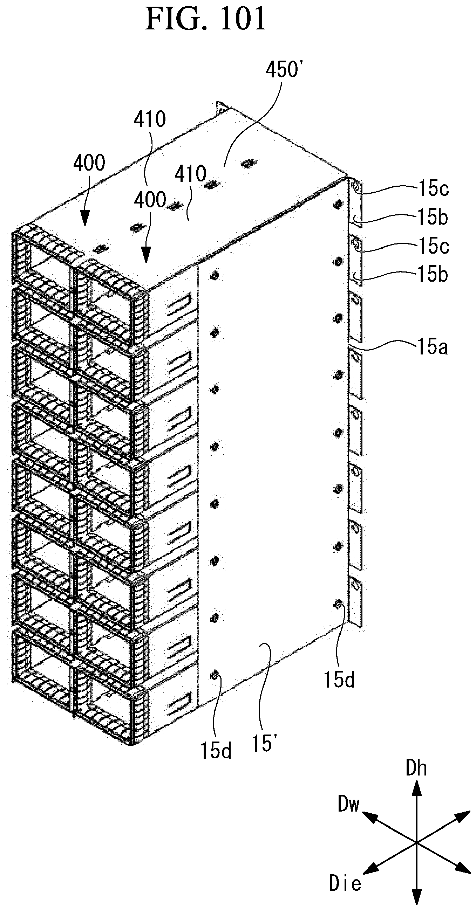

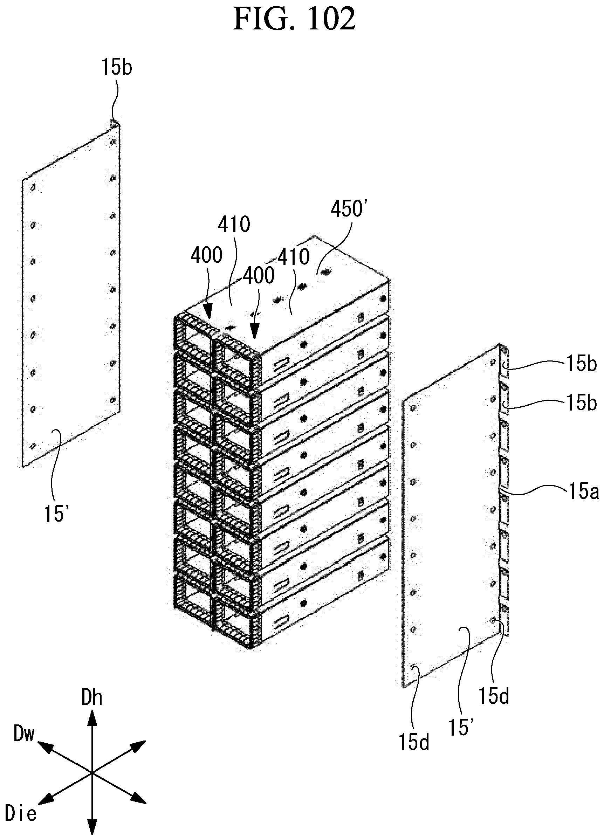

In the present embodiment, as illustrated in Fig. 101 and Fig. 102, flanges 15b in which holes 15c are formed are provided on each connecting panel 15' as the fixing member. Specifically, the flanges 15b expanding in the width direction Dw are provided at rear end edges 15a of the connecting panel 15' facing the substrate 100 when mounted. Note that the configuration of the connecting panel 15' may be the same as the connecting panel 15 except that the flanges 15b are integrally formed.

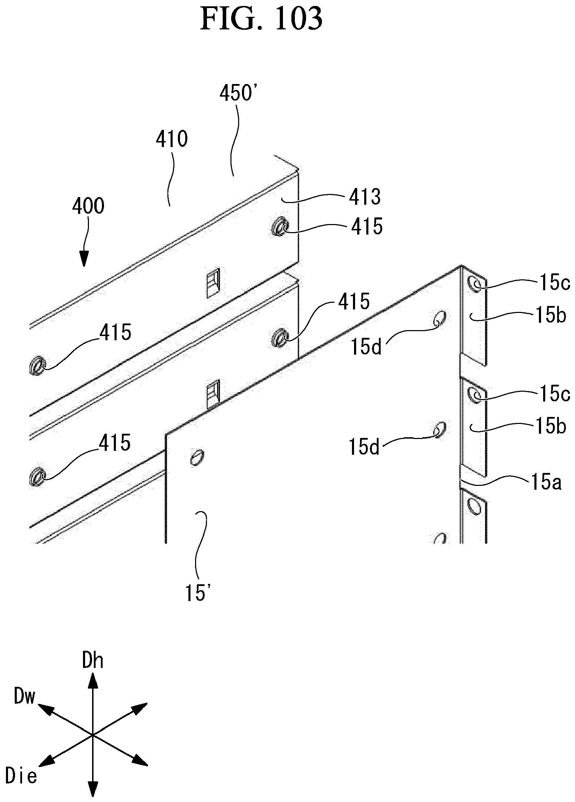

A double outer cage resulted by omitting the flanges 416b from the double outer cage 450 of the first embodiment is referred to as "double outer cage 450‴. As illustrated in Fig. 103, when description is provided with the double outer cage 450' as an example, a plurality of protrusions 415 protruding in the width direction Dw are provided on the right wall 413 of the cage body 410 on the right side in Fig. 103. Further, although not illustrated, the same protrusions 415 are provided on the left wall 414 of the cage body 410 on the left side in Fig. 103. Thus, in view of each double outer cage 450', the protrusions 415 are formed on both sides in the width direction Dw.

A plurality of receiving holes 15d for receiving respective protrusions 415 are formed in the connecting panel 15' to which the flanges 15b are formed.

In the plurality of double outer cages 450' and the two connecting panels 15' configured as described above, each protrusion 415 of the double outer cage 450' is inserted in each receiving hole 15d of the connecting panel 15' and crimped, and thereby each connecting panel 15' is connected and fixed to the plurality of double outer cages 450'. Thus, the plurality of double outer cages 450' aligned in the height direction Dh are integrated by two connecting panels 15'.

The assembly of the plurality of double outer cages 450' and the two connecting panels 15' can be handled in the same manner as the assembly of the double outer cage 450 and the connecting panel 15 illustrated in Fig. 36 and Fig. 46, for example. In this handling, the flange 15b formed on the connecting panel 15' functions in the same manner as the flange 416b of the double outer cage 450, for example.

Note that the flanges 15b formed on the connecting panel 15' may be formed continuously in the height direction Dh or may be formed dividedly.

Further, since respective double outer cages 450' are connected to each other by the connecting panel 15', it is not required to provide the flange 15b to all the positions corresponding to the first double outer cage 450' to the eighth double outer cage 450' from the top. For example, the flanges 15b may be provided at only the first, third, fifth, and eighth positions.

The connection method using the protrusions 415 and the receiving holes 15d as described above can be employed even in the connecting panels 15 of the first embodiment to the third embodiment where no flange 15b is formed.

Further, means for connecting, to the double outer cages 450', the connecting panel 15' with the flange 15b formed are not limited to the protrusion 415 and the receiving hole 15d.

Further, the connecting panel 15' with the flange 15b formed can be applied not only to the double outer cage 450' but also to the quadruple outer cage 650 or the octuple outer cage 750, for example.

### [Fifth Embodiment]

In the first embodiment to the third embodiment, the fixing flanges are provided on the cage bodies 410 (double outer cage 450), the cage bodies 510 (double outer cage 550), the quadruple outer cage 650, and the octuple outer cage 750 except for some examples or modified examples. Further, in the fourth embodiment, the flanges are provided on the connecting panel 15'. In the present embodiment, however, no flange is provided on the outer cages or the connecting panel.

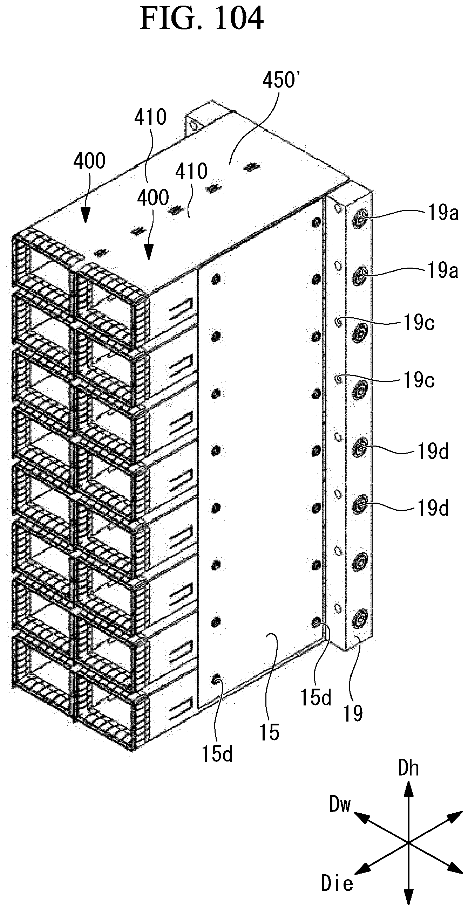

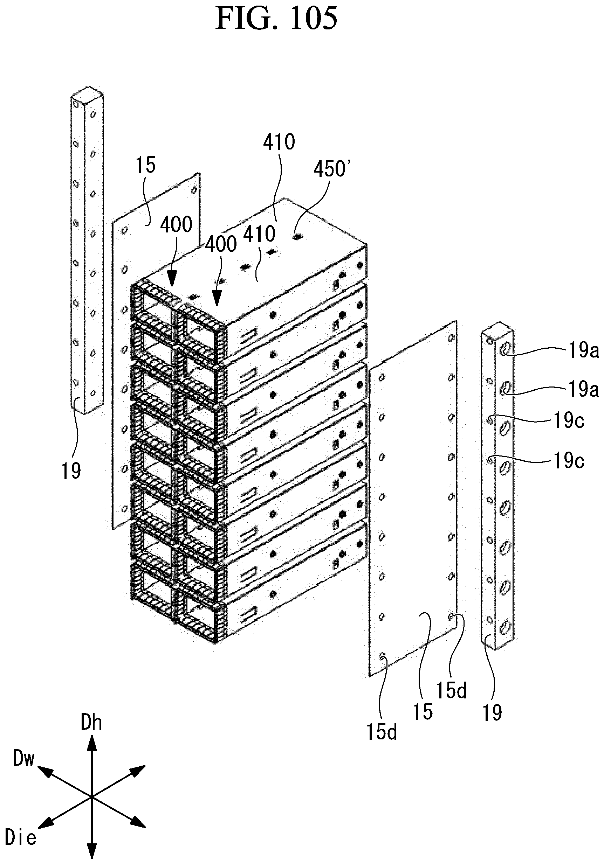

In the present embodiment, as illustrated in Fig. 104 and Fig. 105, two flange members 19 as the fixing member are further provided.

Each flange member 19 is a member extending in the height direction Dh.

In the flange member 19, a plurality of holes 19c penetrating in the insertion-extraction direction Die are formed aligned in the height direction Dh. These holes 19c function in the same manner as the holes 416c formed in the flanges 416b of the double outer cage 450, for example.

Further, in the flange member 19, a plurality of counterbored holes 19a penetrating in the width direction Dw are formed aligned in the height direction Dh. The shaft part of a cap bolt 19d is inserted through the counterbored hole 19a, and the head part of the cap bolt 19d is abutted against the counterbored hole 19a.

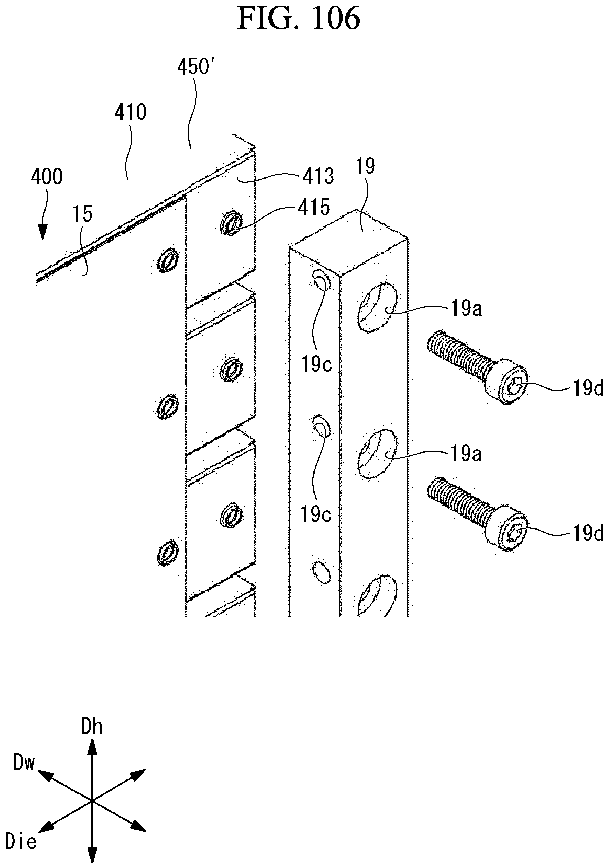

As illustrated in Fig. 106, when description is provided with the double outer cage 450' as an example, a plurality of protrusions 415 protruding in the width direction Dw are provided on the right walls 413 of the cage bodies 410 on the right side in Fig. 106. Further, although not illustrated, the same protrusions 415 are provided on the left walls 414 of the cage bodies 410 on the left side in Fig. 106. Thus, in view of each double outer cage 450', the protrusions 415 are formed on both sides in the width direction Dw. An internal thread is formed inside each protrusion 415.

In the plurality of double outer cages 450' and the two flange members 19 configured as described above, an external thread formed on the shaft part of the cap bolt 19d inserted through along the width direction Dw from outside of each flange member 19 is screwed into the internal thread formed inside each protrusion 415, and thereby each flange member 19 is connected and fixed to the plurality of double outer cages 450'.

The assembly of the plurality of double outer cages 450' and the two flange members 19 can be handled in the same manner as the assembly of the double outer cage 450 and the connecting panel 15 illustrated in Fig. 36 and Fig. 46, for example. In this handling, the flange member 19 functions in the same manner as the flange 416b of the double outer cage 450, for example.

Further, when respective double outer cages 450' are connected to each other by the connecting panel 15, it is not required to provide the hole 19c to all the positions corresponding to the first double outer cage 450' to the eighth double outer cage 450' from the top. For example, the holes 19c may be provided at only the first, third, fifth, and eighth positions.

Note that means for connecting the flange member 19 to the double outer cages 450' are not limited to the protrusion 415, the counterbored hole 19a, and the cap bolt 19d.

Further, the flange member 19 can be applied not only to the double outer cage 450' but also to the quadruple outer cage 650 or the octuple outer cage 750, for example.

Further, for example, the flange member 19 is manufactured by die casting, and the connecting panel 15 is manufactured by a sheet metal press working or die casting.

### [Sixth Embodiment]

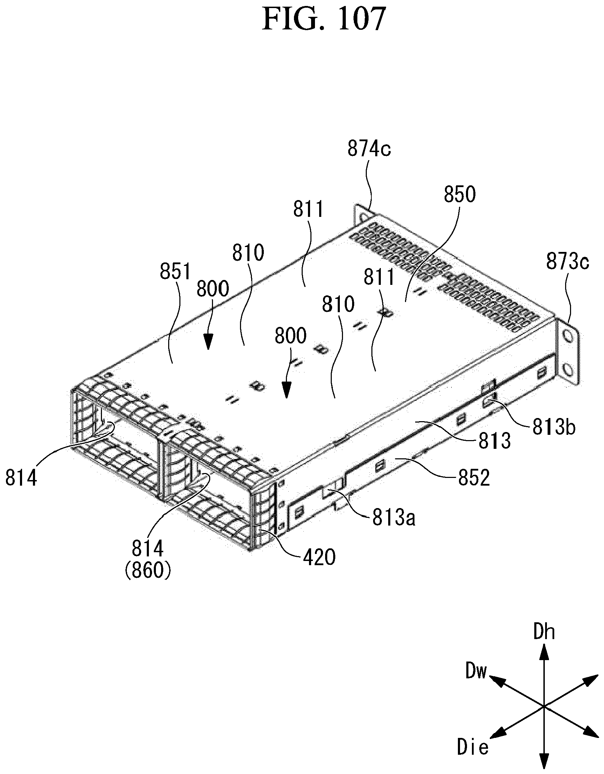

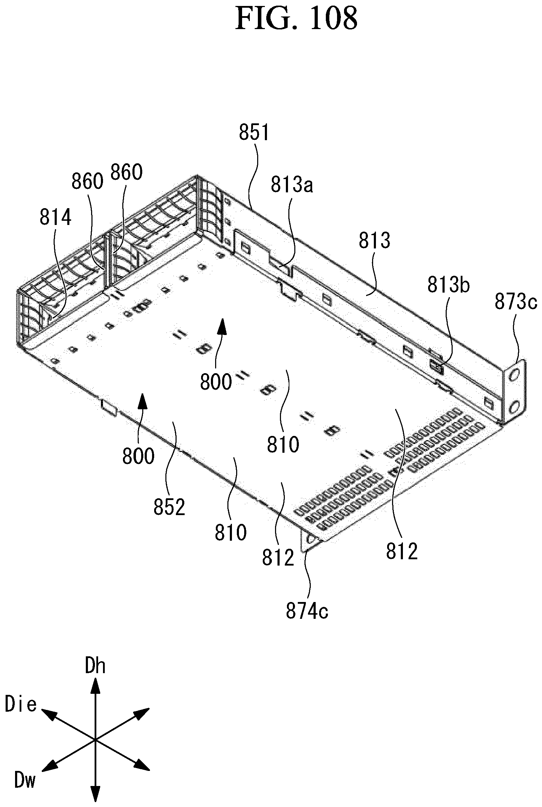

The cage body 410 of the double configuration of the first embodiment and the third embodiment or the cage body 510 of the double configuration of the second embodiment are formed of the double outer cage 450, 550 formed of a single plate material and at least one partition wall 460, 560. However, in a cage 800 according to the present embodiment, each double outer cage 450, 550 as presented in the first embodiment to the third embodiment is formed of two components. In details, as illustrated in Fig. 107 and Fig. 108, a double outer cage 850 according to the present embodiment is formed of a main outer cage 851 and a bottom face outer cage 852.

Thus, the cage body 810 has the main outer cage 851, the bottom face outer cage 852, and at least one partition wall 860.

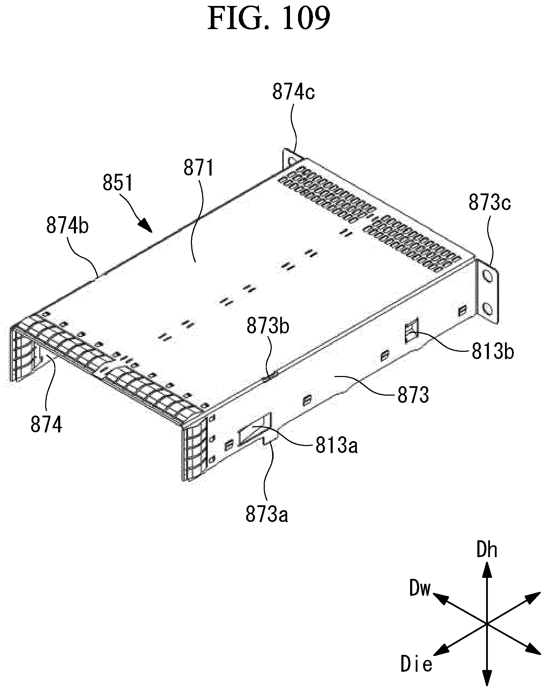

As illustrated Fig. 109, the main outer cage 851 is a component forming a top wall 811, a right wall 813, and a left wall 814 of the cage bodies 810 (see Fig. 107 and Fig. 108).

The main outer cage 851 is formed of a top face part 871, a right side-face part 873, and a left side-face part 874. The main outer cage 851 is formed by bending a single plate material, for example.

The top face part 871 is a face corresponding to the top wall 811 of the cage body 810, and the normal line direction of the face substantially matches the height direction Dh.

The right side-face part 873 is a face corresponding to the right wall 813 of the cage body 810, and the face is connected substantially perpendicularly to one side edge of the top face part 871 and extends downward.

A fixing claw 813a and a stopper claw 813b that are inclined inward in the width direction Dw are provided in the right side-face part 873 in the same manner as the first embodiment. Further, a flange 873c that is the same as that of the first embodiment is provided at the rear end edge of the right side-face part 873.

A positioning protrusion 873a is provided at the side edge of the right side-face part 873. The positioning protrusion 873a is a small piece protruding downward in the height direction Dh.

An installing notch 837b is provided at the boundary (a bending part) between the right side-face part 873 and the top face part 871 at a position corresponding to the positioning protrusion 873a in the insertion-extraction direction Die. The installing notch 873b is a position with which the bottom end of a positioning protrusion 873a of another cage body 810 is contacted.

The left side-face part 874 is a face corresponding to the left wall 814 of the cage body 810, and the face is connected substantially perpendicularly to the other side edge of the top face part 871 and extends downward.

In the same manner as the right side-face part 873, a fixing claw 814a, a stopper claw 814b, a positioning protrusion 874a, an installing notch 874b, and a flange 874c are also provided in the left side-face part 874.

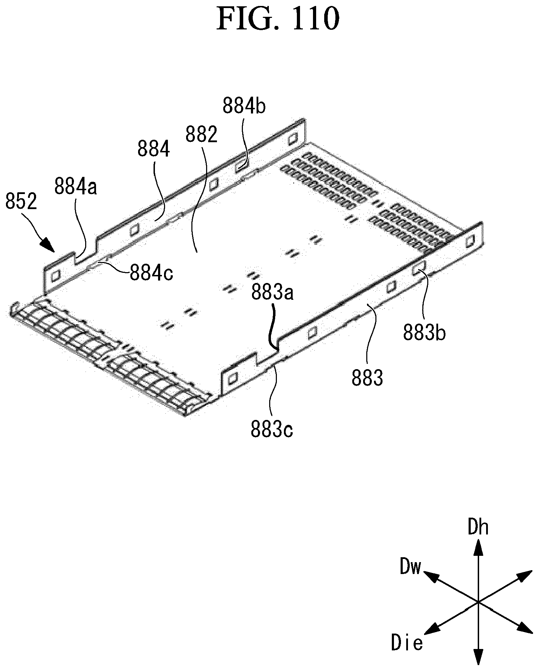

As illustrated in Fig. 110, the bottom face outer cage 852 is a component forming a bottom wall 812 of the cage body 810 (see Fig. 107 and Fig. 108).

The bottom face outer cage 852 is formed of a bottom face part 882, a right side-face part 883, and a left side-face part 884. The bottom face outer cage 852 is formed by bending a single plate material, for example.

The bottom face part 882 is a face corresponding to the bottom wall 812 of the cage body 810, and the normal line direction of the face substantially matches the height direction Dh.

The right side-face part 883 is a face overlapping the outer face of the right side-face part 873 of the main outer cage 851, and the face is connected substantially perpendicularly to one side edge of the bottom face part 882 and extends upward.

In the right side-face part 883, a checking notch 883a is provided in a portion corresponding to the position of the fixing claw 813a, and a checking hole 883b is provided in a portion corresponding to the position of the stopper claw 813b.

A protrusion insertion hole 883c is provided at the boundary (bending part) between the right side-face part 883 and the bottom face part 882 at a position corresponding to the positioning protrusion 873a of the main outer cage 851 in the insertion-extraction direction Die. The protrusion insertion hole 883c is a through hole through which the positioning protrusion 873a of the main outer cage 851 is inserted.

The left side-face part 884 is a face overlapping the outer face of the left side-face part 874 of the main outer cage 851, and the face is connected substantially perpendicularly to the other side edge of the bottom face part 882 and extends upward.

In the same manner as the right side-face part 883, a checking notch 884a, a checking hole 884b, and a protrusion insertion hole 884c are also provided in the left side-face part 884.

As illustrated in Fig. 108, the cage bodies 810 (double outer cage 850) are configured such that the bottom face outer cage 852 is attached to the main outer cage 851 so as to cover the underside thereof.

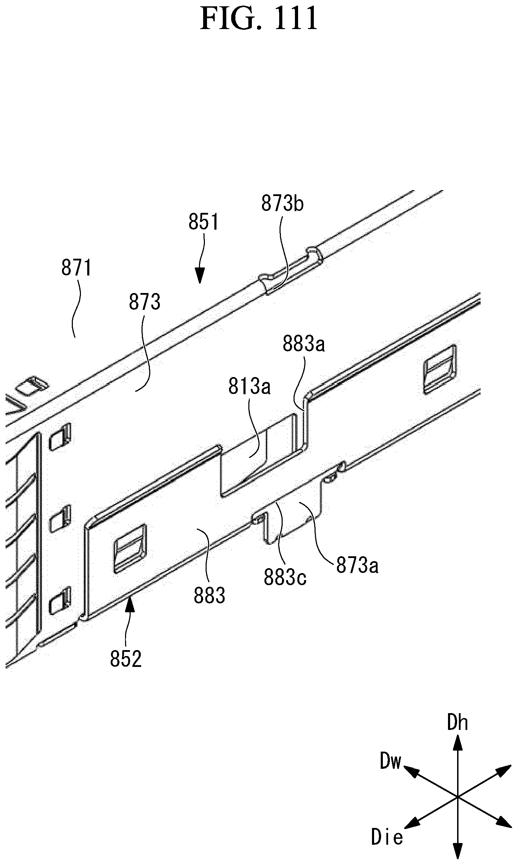

In this state, as illustrated in Fig. 111, the right side-face part 883 of the bottom face outer cage 852 is overlapped with the outer face of the right side-face part 873 of the main outer cage 851. Further, although not illustrated, the left side-face part 884 of the bottom face outer cage 852 is overlapped with the outer face of the left side-face part 874 of the main outer cage 851.

Further, the positioning protrusion 873a of the main outer cage 851 is inserted through the protrusion insertion hole 883c of the bottom face outer cage 852.

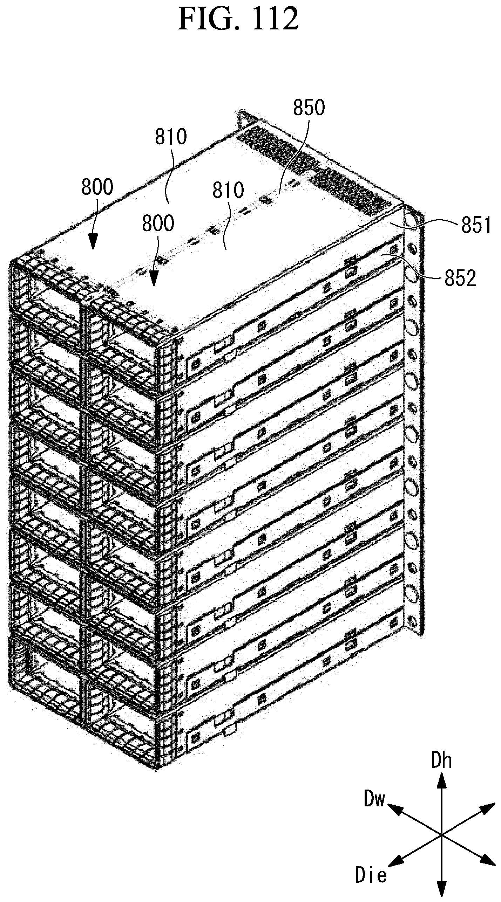

The cage bodies 810 of the double outer cage 850 configured as described above are arranged over multiple levels in the height direction Dh, as illustrated in Fig. 112.

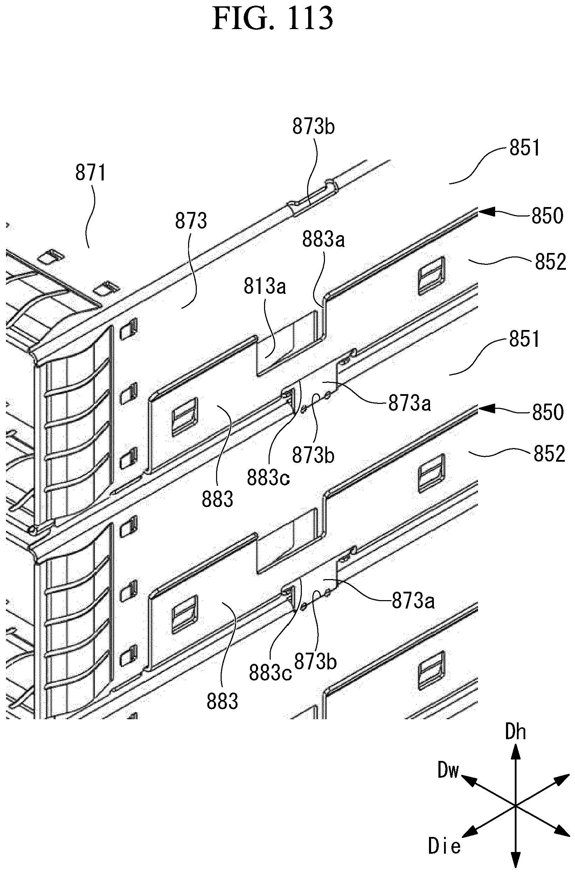

As illustrated in Fig. 113, in two double outer cages 850 adjacent in the height direction Dh, the bottom end of the positioning protrusion 873a of the double outer cage 850 located above comes into contact with the installing notch 873b of the double outer cage 850 located below (the same applies to a pair of the positioning protrusion 874a and the installing notch 874b). Accordingly, the double outer cage 850 located above is positioned with respect to the double outer cage 850 located below.

In this state, by suitably designing the dimension along the height direction Dh of the positioning protrusion 873a, it is possible to control the clearance in the height direction Dh between the double outer cage 850 located above and the double outer cage 850 located below.

Note that the right side-face part 873 near the positioning protrusion 873a and the installing notch 873b may be joined by welding or soldering, for example.

Further, it is possible to view the fixing claw 813a when the checking notch 883a is provided in the right side-face part 883, and it is thus possible to check the state of the fixing claw 813a and the pluggable module 20. The same applies to the checking hole 883b and the stopper claw 813b.

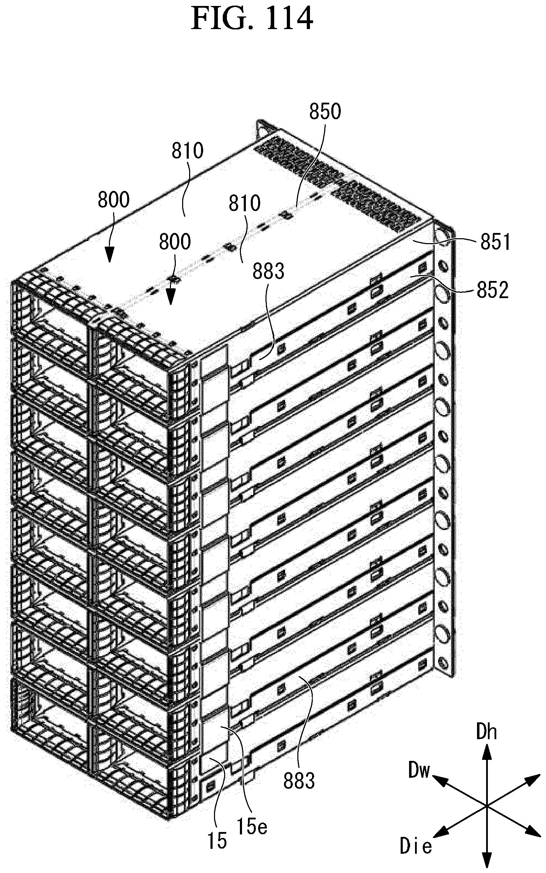

As illustrated in Fig. 114, a common connecting panel 15 may be attached to a set of the cage bodies 810 arranged over multiple levels in the height direction Dh.

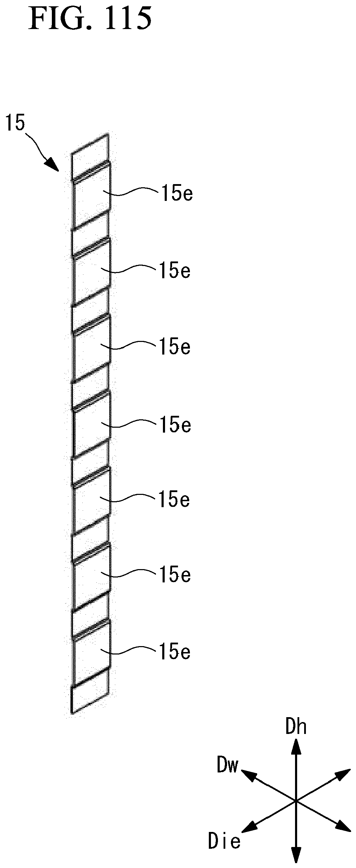

As illustrated in Fig. 115, the connecting panel 15 has a belt shape elongated in the height direction Dh. Protruding parts 15e protruding outward in the width direction Dw are provided on the connecting panel 15 of the present embodiment in order to prevent interference with the right side-face part 883 of the bottom face outer cage 852.

Note that, naturally, the connecting panels 15 are provided on both sides of the set of the cage bodies 810.

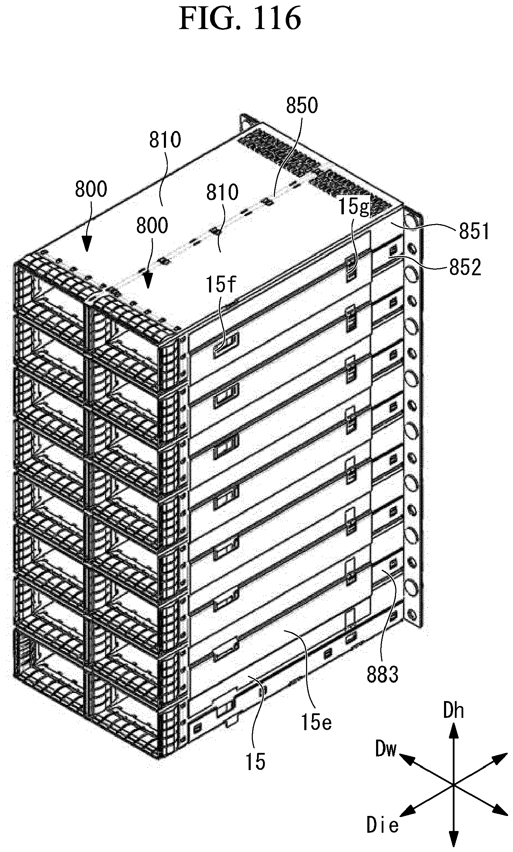

As illustrated in Fig. 116, the dimension along the insertion-extraction direction Die of the connecting panel 15 may be about a dimension covering at least the fixing claw 813a and the stopper claw 813b.

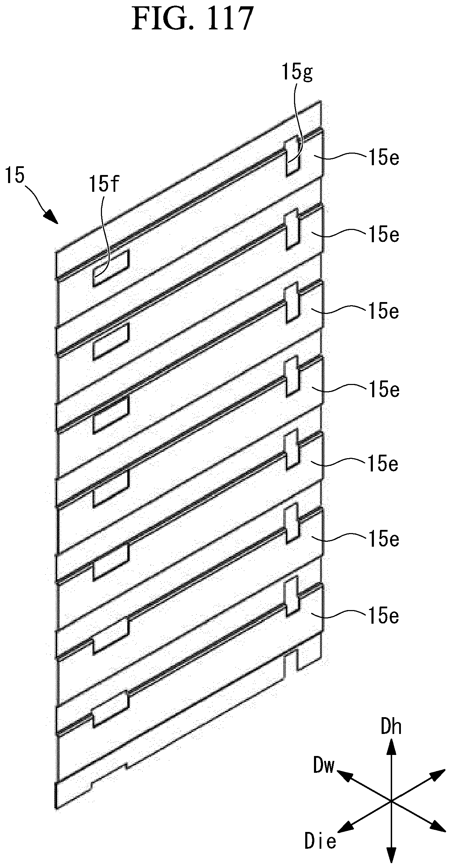

In such a case, as illustrated in Fig. 117, to visually check the fixing claw 813a and the stopper claw 813b, a checking hole 15f corresponding to the position of the fixing claw 813a and the checking hole 15g corresponding to the position of the stopper claw 813b may be provided on the connecting panel 15.

### [Seventh Embodiment]

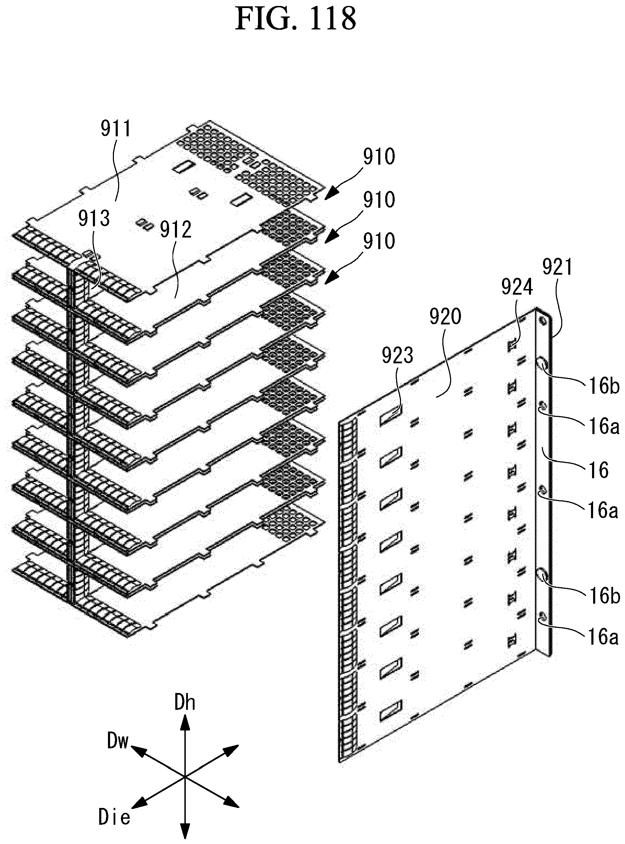

In the present embodiment, as illustrated in Fig. 118, side walls 920 are attached on both sides of sub-assemblies 910 arranged over multiple levels in the height direction Dh.

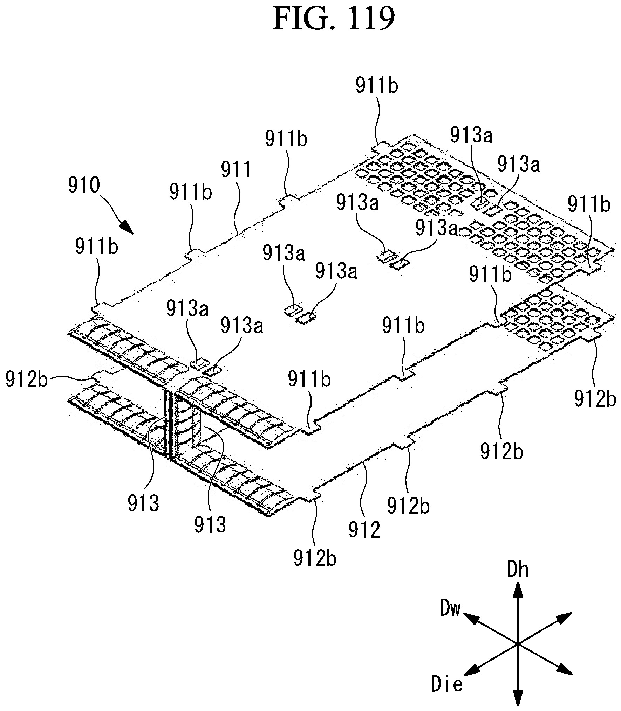

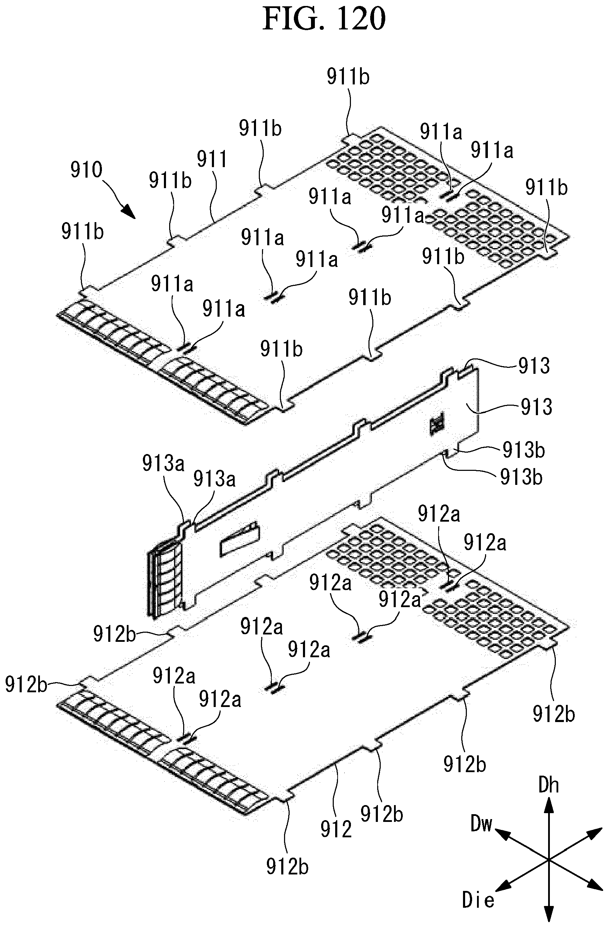

As illustrated in Fig. 119 and Fig. 120, one sub-assembly 910 has a top face member 911, a bottom face member 912, and at least one partition wall 913.

The top face member 911 is a plate-like member whose normal line direction matches the height direction Dh.

A plurality of protrusion insertion holes 911a are provided along the insertion-extraction direction Die in substantially the center region in the width direction Dw of the top face member 911. The number of lines of the protrusion insertion holes 911a along the insertion-extraction direction Die corresponds to the number of partition walls 913.

A plurality of crimping protrusions 911b protruding in the width direction Dw are provided at both side edges in the width direction Dw of the top face member 911.

The bottom face member 912 is a plate-like member whose normal line direction matches the height direction Dh and is arranged so as to face the top face member 911 in the height direction Dh.

A plurality of protrusion insertion holes 912a are provided along the insertion-extraction direction Die in substantially the center region in the width direction Dw of the bottom face member 912. The number of lines of the protrusion insertion holes 912a along the insertion-extraction direction Die corresponds to the number of partition walls 913.

A plurality of crimping protrusions 912b protruding in the width direction Dw are provided at both side edges in the width direction Dw of the bottom face member 912.

The partition wall 913 is a plate-like member extending in the insertion-extraction direction Die and erected in the height direction Dh.

A plurality of crimping protrusions 913a protruding upward in the height direction Dh are provided at the top edge of the partition wall 913. Further, a plurality of crimping protrusions 913b protruding downward in the height direction Dh are provided at the bottom edge of the partition wall 913.

As illustrated in Fig. 119, respective crimping protrusion 913a of the partition wall 913 are inserted through and crimped in corresponding protrusion insertion holes 911a of the top face member 911, further, respective crimping protrusion 913b of the partition wall 913 are inserted through and crimped in corresponding protrusion insertion holes 912a of the bottom face member 912, and thereby the top face member 911, the bottom face member 912, and the partition wall 913 are connected to each other to form the sub-assembly 910.

Note that, instead of or in addition to crimping of the protrusion 913a and the protrusion 913b, the partition wall 913 may be joined to the top face member 911 and the bottom face member 912 by welding or soldering.

The sub-assemblies 910 formed as described above are arranged over multiple levels in the height direction Dh, as illustrated in Fig. 118.

The side walls 920 are then attached to both sides of the set of sub-assemblies 910 arranged over multiple levels.

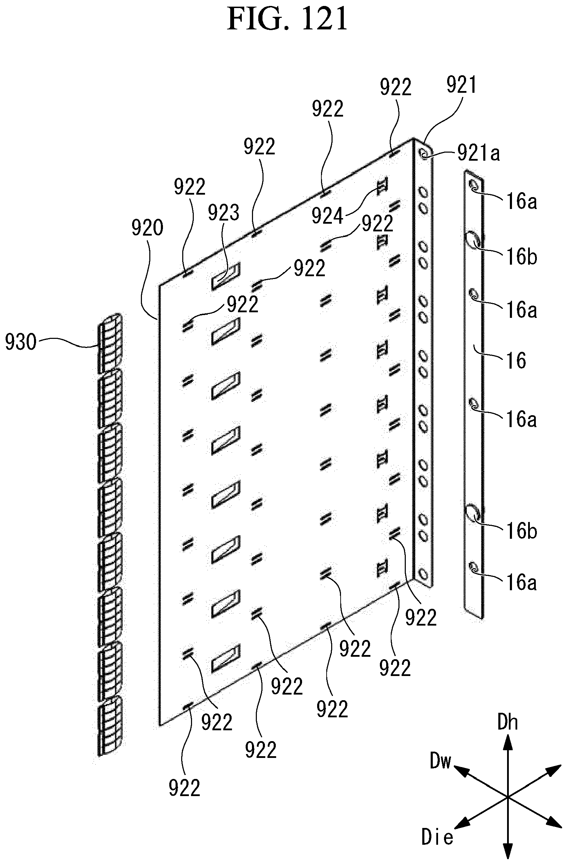

As illustrated in Fig. 121, the side wall 920 is a plate-like member whose normal line direction matches the width direction Dw.

The side wall 920 has a dimension in the height direction Dh sufficient to collectively cover the lateral side of all the sub-assemblies 910 arranged over multiple levels and a dimension in the insertion-extraction direction Die sufficient to cover the lateral side of the sub-assemblies 910.

The rear end edge of the side wall 920 is provided with a flange 921 expanding in the width direction Dw along the height direction Dh. The flange 921 is provided with a plurality of holes 921a along the height direction Dh. The holes 921a correspond to the holes 416c as presented in the first embodiment, for example, and are used in fixing using the base plate 16.

The front end edge of the side wall 920 is provided with EMI fingers 930.

The side wall 920 is provided with protrusion insertion holes 922, fixing claws 923, and stopper claws 924.

Each protrusion insertion hole 922 is a through hole through which the crimping protrusion 911b of the top face member 911 and the crimping protrusion 912b of the bottom face member 912 are inserted.

The fixing claws 923 and the stopper claws 924 correspond to the fixing claws 413a and the stopper claws 413b, respectively, as presented in the first embodiment, for example.

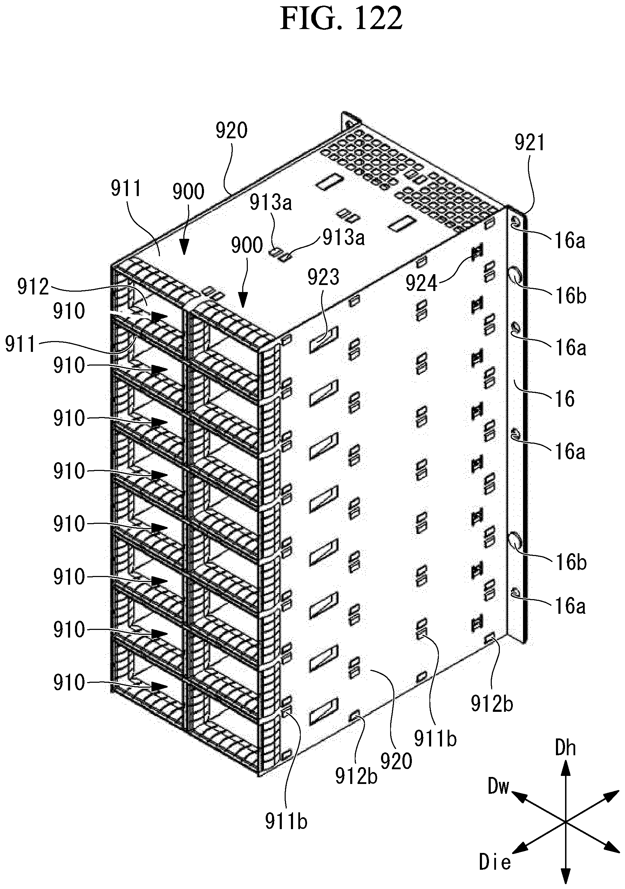

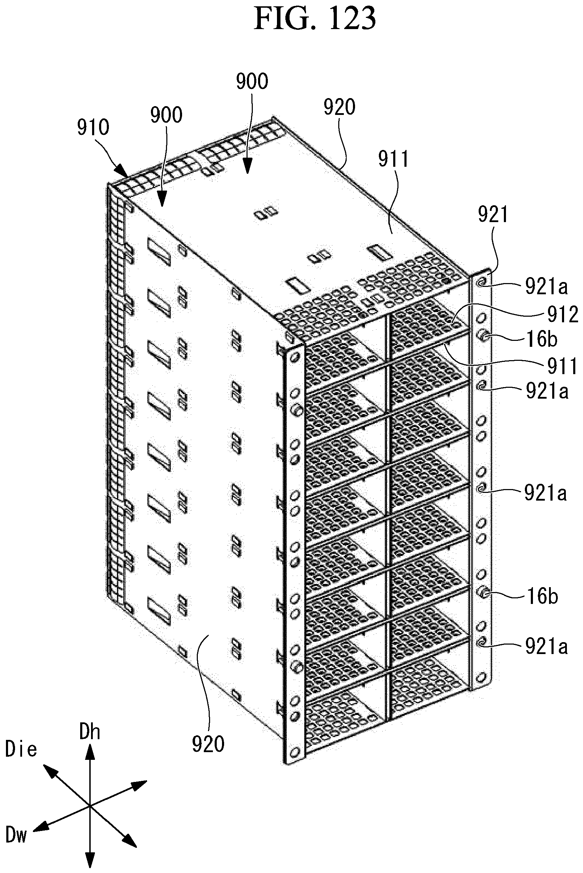

As illustrated in Fig. 122 and Fig. 123, the crimping protrusions 911b of the top face member 911 and the crimping protrusions 912b of the bottom face member 912 of each sub-assembly 910 are inserted through and crimped in corresponding protrusion insertion holes 922 of the side walls 920 on both sides, and thereby the sub-assemblies 910 and the two side walls 920 are connected to each other. This results in a configuration in which sets of cages 900 of the double configuration are arranged over multiple levels in the height direction Dh.

Note that, instead of or in addition to crimping of the crimping protrusion 911b and the crimping protrusion 912b, the side wall 920 may be joined to the top face member 911 and the bottom face member 912 by welding or soldering.

### < Modified Example >

Although the cages 900 are arranged in 2 x 8 (that is, the sub-assemblies 910 are arranged in eight levels) in the above description (for example, Fig. 122), the cages 900 can be arranged in any number of columns and/or any number of levels. Further, the dimension of the side wall 920 or the number of partition walls 913 can be changed as appropriate in accordance with the number of columns and/or the number of levels of the cages 900.

Specific examples are as follows.

Thus, the cages 900 may be arranged in 2 x (1 to 7). In such a case, the dimension in the height direction Dh of the side wall 920 is shorter.

Further, the cages 900 may be arranged in 2 x (9 or greater). In such a case, the dimension in the height direction Dh of the side wall 920 is longer.

Further, the cages 900 may be arranged in 1 x a plural number. In such a case, the partition wall 913 is omitted, the dimensions in the width direction Dw of the top face member 911 and the bottom face member 912 of each sub-assembly 910 is shorter, and the dimension in the height direction Dh of the side wall 920 is changed in accordance with the number of levels.

Further, the cages 900 may be arranged in (3 or greater) x a plural number. In such a case, the partition wall 913 is added, the dimensions in the width direction Dw of the top face member 911 and the bottom face member 912 of each sub-assembly 910 is longer, and the dimension in the height direction Dh of the side wall 920 is changed in accordance with the number of levels.

Note that it is not required to change the configuration of the side wall 920 even when the number of columns is different as long as the number of levels is the same. For example, it is not required to change the configuration of the side wall 920 between a case where the cages 900 are arranged in 2 x 8 and a case where the cages 900 are arranged in 1 x 8, because the dimension in the height direction Dh is the same in both cases.

## Claims

1. A receptacle assembly which is mounted on a first face of a substrate and in which at least one pluggable module is inserted along a first direction, the receptacle assembly comprising:
at least one connector configured to allow a module substrate of the pluggable module to be inserted to the connector along the first direction and configured to be electrically connected to the module substrate; and
at least one cage having a cage body configured to accommodate the connector and define a space in which the pluggable module is guided and inserted along the first direction,
wherein the connector and the cage body are mounted on the substrate such that the first direction is substantially orthogonal to the first face of the substrate, and
wherein a fixing part for fixing the cage body to the substrate is provided at a rear end edge of the cage body located on a substrate side when mounted on the substrate.

2. The receptacle assembly according to claim 1, wherein the fixing part is a flange expanding in a direction orthogonal to the first direction.

3. The receptacle assembly according to claim 2, wherein a hole corresponding to a through hole formed in the substrate is formed in the flange.

4. The receptacle assembly according to claim 2 or 3 further comprising:
a first plate; and
a second plate,
wherein the first plate and the second plate are fastened to each other with the flange and the substrate being interposed between the first plate and the second plate.

5. The receptacle assembly according to any of claims 2 to 4 further comprising a first plate,
wherein the first plate and the flange are fastened to each other with the substrate being interposed between the first plate and the flange.

6. The receptacle assembly according to any of claim 1 to 5, wherein the fixing part is a pin extending in the first direction.

7. The receptacle assembly according to claim 6, wherein the pin is inserted and secured in a through hole formed in the substrate.

8. The receptacle assembly according to any of claims 1 to 7,
wherein the at least one connector and the at least one cage body include a plurality of connectors and a plurality of cage bodies, respectively,
wherein the connectors are adjacent to each other in a width direction orthogonal to the first direction and/or a height direction orthogonal to both the first direction and the width direction,
wherein the cage bodies are adjacent to each other in the width direction and/or the height direction and connected to each other, and
wherein the receptacle assembly further comprises a connecting panel configured to connect the plurality of cage bodies in the height direction.

9. The receptacle assembly according to any of claims 1 to 8,
wherein the at least one connector and the at least one cage body include a plurality of connectors and a plurality of cage bodies, respectively,
wherein the connectors are adjacent to each other in a width direction orthogonal to the first direction and/or a height direction orthogonal to both the first direction and the width direction,
wherein the cage bodies are adjacent to each other in the width direction and/or the height direction and connected to each other,
wherein
(i) the plurality of cage bodies adjacent to each other in the width direction have a rectangular cylindrical outer cage and at least one partition plate, the outer cage defining a space accommodating a plurality of pluggable modules, and the partition plate partitioning the space of the outer cage in the width direction, and/or
(ii) the plurality of cage bodies adjacent to each other in the height direction have a rectangular cylindrical outer cage and at least one partition plate, the outer cage defining a space accommodating the plurality of pluggable modules, and the partition plate partitioning the space of the outer cage in the height direction,
and, furthermore,
wherein the outer cage is formed by bending a plate material having a latch claw and a notch into a rectangular cylindrical shape and then fitting the latch claw into the notch, the latch claw being formed at one edge, and the notch being formed in another edge opposed to the one edge and having a shape adapted to a shape of the latch claw, and
wherein a space defined by the outer cage and the partition plate functions as the cage body.

10. The receptacle assembly according to claim 9,
wherein protrusions are formed at respective edges of the partition plate, the edges being opposed to each other in the height direction,
wherein engagement holes are formed in respective walls of the outer cage, the walls facing each other in the height direction, and
wherein the partition plate is fixed to the outer cage when the protrusions of the partition plate are inserted in the engagement holes of the outer cage.

11. The receptacle assembly according to claim 9 or 10, wherein
a plurality of partition plates partitioning, in the width direction, the space defined by the outer cage are arranged at substantially the same positions while being close to each other in the width direction, and/or
a plurality of partition plates partitioning, in the height direction, the space defined by the outer cage are arranged at substantially the same positions while being close to each other in the height direction.

12. The receptacle assembly according to any of claims 1 to 11,
wherein the cage body is configured such that the pluggable module with a heat sink is inserted in the cage body, and
wherein at least one vent hole is formed in walls of the cage body, the walls facing in a height direction orthogonal to the first direction.

13. The receptacle assembly according to any of claims 1 to 12, wherein an undercut part recessed so as to be spaced apart from the substrate is provided in the rear end edge in walls of the cage body, the walls facing each other in a height direction orthogonal to the first direction.

14. The receptacle assembly according to any of claims 1 to 13,
wherein the connector includes
a contact pin group in which a plurality of contact pins are aligned, and
a housing holding the contact pin group,
wherein the contact pin group at least has signal pins used for signal transmission and ground pins used for reference potential connection,
wherein the contact pin group has a predetermined portion in which two adjacent signal pins are arranged between two ground pins, and
wherein in the predetermined portion, a pitch between one of the ground pins and one of the adjacent signal pins is larger than a pitch between the adjacent signal pins.

15. The receptacle assembly according to any of claims 1 to 14,
wherein the connector includes
a contact pin group in which a plurality of contact pins are aligned,
a housing holding the contact pin group, and
a shell covering the housing,
wherein a fixing tab for fixing the shell to the substrate is provided at an end edge of the shell located on the substrate side, and
wherein a width dimension of the fixing tab is a larger than a width dimension of each of the contact pin of the contact pin group.

16. The receptacle assembly according to any of claims 1 to 15,
wherein the connector includes
a contact pin group in which a plurality of contact pins are aligned,
a housing holding the contact pin group, and
a fixing tab protruding from a face of the housing facing the substrate, and wherein a width dimension of the fixing tab is larger than a width dimension of each of the contact pin of the contact pin group.

17. A cage mounted on a first face of a substrate and comprising a cage body defining a space in which at least one pluggable module is guided and inserted along a first direction,
wherein the cage body is mounted on the substrate such that the first direction is substantially orthogonal to a face of the substrate, and
wherein a fixing part for fixing the cage body to the substrate is provided at a rear end edge of the cage body located on a substrate side when mounted on the substrate.

18. The cage according to claim 17, wherein the fixing part is a flange expanding in a direction orthogonal to the first direction.

19. The cage according to claim 18, wherein a hole corresponding to a through hole formed in the substrate is formed in the flange.

20. The cage according to any of claims 17 to 19, wherein the fixing part is a pin extending in the first direction.

21. The cage according to any of claims 17 to 20 further comprising:
an outer cage defining a space configured to accommodate a plurality of pluggable modules; and
at least one partition plate partitioning a space inside the outer cage,
wherein a space defined by the outer cage and the partition plate functions as the cage body.

22. The cage according to claim 21, wherein the outer cage and the partition plate have a fixing claw configured to latch the pluggable module.

23. A mounting method of mounting the receptacle assembly according to any of claims 8 to 16 on the substrate, the mounting method comprising:
collectively mounting, on the substrate, the plurality of cage bodies integrated by the connecting panel.

24. A receptacle assembly which is mounted on a first face of a substrate and in which at least one pluggable module is inserted along the first direction, the receptacle assembly comprising:
a connector configured to allow a module substrate of the pluggable module to be inserted to the connector along the first direction and configured to be electrically connected to the module substrate;
a cage having a cage body configured to accommodate the connector and define a space in which the pluggable module is guided and inserted along the first direction; and
a fixing member fixed to the cage body,
wherein the connector and the cage body are mounted on the substrate by the fixing member such that the first direction is substantially orthogonal to the first face of the substrate.
